(19)

Europäisches
Patentamt
European
Patent Office
Office européen
des brevets

(11) **EP 4 593 567 A1**

(12) **EUROPEAN PATENT APPLICATION**
published in accordance with Art. 153(4) EPC

(43) Date of publication:
    **30.07.2025 Bulletin 2025/31**

(21) Application number: 23953424.1

(22) Date of filing: 26.09.2023

(51) International Patent Classification (IPC):
    **H10K 59/121** (2023.01)    **H10K 59/122** (2023.01)
    **H10K 59/123** (2023.01)

(52) Cooperative Patent Classification (CPC):
    **H10K 59/121; H10K 59/122; H10K 59/123**

(86) International application number:
    **PCT/CN2023/121696**

(87) International publication number:
    **WO 2025/065265 (03.04.2025 Gazette 2025/14)**

(84) Designated Contracting States:
    **AL AT BE BG CH CY CZ DE DK EE ES FI FR GB
    GR HR HU IE IS IT LI LT LU LV MC ME MK MT NL
    NO PL PT RO RS SE SI SK SM TR**
    Designated Extension States:
    **BA**
    Designated Validation States:
    **KH MA MD TN**

(71) Applicant: **BOE Technology Group Co., Ltd.
    Beijing 100015 (CN)**

(72) Inventors:
    • **LIANG, Ke
      Beijing 100176 (CN)**
    • **ZHANG, Yuxin
      Beijing 100176 (CN)**

    • **LIU, Changchang
      Beijing 100176 (CN)**
    • **HAO, Xueguang
      Beijing 100176 (CN)**
    • **FANG, Fei
      Beijing 100176 (CN)**
    • **WANG, Jingquan
      Beijing 100176 (CN)**
    • **QIAO, Yong
      Beijing 100176 (CN)**
    • **WU, Xinyin
      Beijing 100176 (CN)**

(74) Representative: **Durán-Corretjer, S.L.P.
    Còrsega, 329
    (Paseo de Gracia/Diagonal)
    08037 Barcelona (ES)**

(54) **DISPLAY SUBSTRATE AND DISPLAY APPARATUS**

(57)    A display substrate, comprising: a first display area (A1) and a second display area (A2). The first display area (A1) comprises a first sub-area (A11), and a second sub-area (A12a, A12b) located on at least one side of the first sub-area (A11) close to the second display area (A2). The first sub-area (A11) comprises a plurality of display island areas (A111), and first light-transmitting areas (A112) located between adjacent display island areas (A111). The display island areas (A111) comprise a plurality of first pixel circuits (11) and a plurality of first light-emitting elements (15), the orthographic projections of the first light-emitting elements (15) at least partially overlapping the orthographic projections of the connected first pixel circuits (11) on a substrate (60). The second sub-area (A12a, A12b) comprises a plurality of second light-emitting elements (16). The second display area (A2) comprises a plurality of second pixel circuits (12) provided on the substrate (60). At least one second pixel circuit (12) is connected to at least one second light-emitting element (16) by means of a conductive connection line (53).

FIG. 3

EP 4 593 567 A1

**Description**

Technical Field

The present disclosure relates to, but is not limited to, the field of display technologies, in particular to a display substrate and a display apparatus.

Background

An Organic Light Emitting Diode (OLED) and a Quantum dot Light Emitting Diode (QLED) are active light emitting display devices and have advantages of self-luminescence, a wide viewing angle, a high contrast ratio, low power consumption, an extremely high response speed, lightness and thinness, bendability, and a low cost, etc.

Summary

The following is a summary of subject matters described herein in detail. This summary is not intended to limit the protection scope of claims.

Embodiments of the present disclosure provide a display substrate and a display apparatus.

In one aspect, an embodiment provides a display substrate, including a first display area and a second display area located on at least one side of the first display area. The first display area includes a first sub-area and a second sub-area located on at least one side of the first sub-area close to the second display area. The first sub-area includes a plurality of display island areas and a first light transmitting area located between adjacent display island areas. A display island area includes a plurality of first pixel circuits and a plurality of first light emitting elements provided on a base substrate. The plurality of first pixel circuits and the plurality of first light emitting elements are electrically connected; and an orthographic projection of the first light emitting elements on the base substrate is at least partially overlapped with an orthographic projection of the first pixel circuits connected therewith on the base substrate. The second sub-area includes a plurality of second light emitting elements provided on the base substrate. The second display area at least includes a plurality of second pixel circuits provided on the base substrate. At least one second pixel circuit among the plurality of second pixel circuits is electrically connected with at least one second light emitting element among the plurality of second light emitting elements through a conductive connection line. A distance between an orthographic projection of the second light emitting elements on the base substrate and an orthographic projection of the second pixel circuits with which the second light emitting elements are connected on the base substrate is greater than 0.

In some exemplary embodiments, the plurality of first pixel circuits of the display island area are connected with a plurality of first signal lines extending along a first direction and a plurality of second signal lines extending along a second direction. In the first sub-area, the plurality of first signal lines of adjacent display island areas in the first direction are connected through a plurality of first island area connection lines, and the plurality of second signal lines of adjacent display island areas in the second direction are connected through a plurality of second island area connection lines. The first direction intersects the second direction.

In some exemplary embodiments, the conductive connection line includes at least one wire layer. The plurality of first island area connection lines, the plurality of second island area connection lines and the at least one wire layer of the conductive connection line are of a same layer structure, and are made of a transparent conductive material.

In some exemplary embodiments, the plurality of first island area connection lines, the plurality of second island area connection lines, and the conductive connection line are all made of a metal material.

In some exemplary embodiments, the plurality of first island area connection lines and the plurality of second island area connection lines are made of a metal material, and the conductive connection line is made of a transparent conductive material.

In some exemplary embodiments, the plurality of first pixel circuits in the display island area are connected with a same first power supply line.

In some exemplary embodiments, the plurality of first pixel circuits of the display island area are connected with a same first initial signal line and a same second initial signal line. In the display island area, the first initial signal line, the second initial signal line and the first power supply line extend along a same direction, and the first power supply line is located between the first initial signal line and the second initial signal line.

In some exemplary embodiments, the plurality of first pixel circuits of the display island area are connected with a same light emitting control line, and an extending direction of the light emitting control line intersects an extending direction of the first power supply line.

In some exemplary embodiments, the display island area includes four first pixel circuits which are arranged in a 2×2 array, and active layers of the four first pixel circuits are symmetrically provided about a first center line of the four first pixel circuits in the first direction.

In some exemplary embodiments, the display island area may include three first pixel circuits arranged sequentially along the first direction.

In some exemplary embodiments, the display substrate further includes a light shielding layer located on a side of the first pixel circuits and the second pixel circuits close to the base substrate, and the light shielding layer is not overlapped with an orthographic projection of the first light transmitting area on the base substrate. The light shielding layer at least includes a first light shielding block located in the display island area. An orthographic projection of the first light shielding block on the base substrate covers an orthographic projection of the plurality of first pixel circuits of the display island area and signal lines with which the plurality of first pixel circuits are connected on the base substrate.

In some exemplary embodiments, first light shielding blocks of adjacent display island areas are of an interconnected integral structure.

In some exemplary embodiments, first light shielding blocks of adjacent display island areas are independently provided.

In some exemplary embodiments, an edge of the first light shielding block close to the first light transmitting area is an arc-shaped edge.

In some exemplary embodiments, the display substrate further includes a light emitting structure layer located on a side of the plurality of first pixel circuits and the plurality of second pixel circuits away from the base substrate. The light emitting structure layer includes a cathode layer. An orthographic projection of the cathode layer on the base substrate is not overlapped with an orthographic projection of the first light transmitting area on the base substrate. The cathode layer at least includes cathodes of the plurality of first light emitting elements. The cathodes of the plurality of first light emitting elements of the display island area are of an interconnected integral structure, and an orthographic projection of the integral structure of the cathodes of the plurality of first light emitting elements of the display island area on the base substrate covers an orthographic projection of the plurality of first pixel circuits of the display island area and signal lines with which the plurality of first pixel circuits are connected on the base substrate.

In some exemplary embodiments, the cathode layer further includes cathodes of the plurality of second light emitting elements. The cathodes of the plurality of first light emitting elements of the first sub-area and the cathodes of the plurality of second light emitting elements of the second sub-area are connected to form a mesh shape.

In some exemplary embodiments, the display substrate further includes a light shielding pixel defining layer located on a side of the cathode layer close to the base substrate. The light shielding pixel defining layer is at least located in the first sub-area, and an orthographic projection of the cathode layer on the base substrate covers an orthographic projection of the light shielding pixel defining layer on the base substrate.

In some exemplary embodiments, the display substrate further includes a light shielding layer located on a side of the first pixel circuits and the second pixel circuits close to the base substrate; and the light shielding layer is not overlapped with an orthographic projection of the first light transmitting area on the base substrate. The light shielding layer at least includes a plurality of light shielding strips located in the display island area; and an orthographic projection of each light shielding strip on the base substrate covers an orthographic projection of a channel region of an active layer of at least one transistor of a first pixel circuit on the base substrate. The orthographic projection of the integral structure of the cathodes of the plurality of first light emitting elements of the display island area on the base substrate covers an orthographic projection of the plurality of light shielding strips of the display island area on the base substrate.

In some exemplary embodiments, a light transmittance of the first display area is greater than a light transmittance of the second display area, and a density of light emitting elements in the second display area is the same as a density of light emitting elements in the first display area.

In some exemplary embodiments, the first display area has a strip shape extending along the first direction, and the second sub-area is located between the first sub-area and the second display area in the first direction.

In some exemplary embodiments, the display island area includes at least one first light emitting unit, and the first light emitting unit includes a plurality of adjacent first light emitting elements. The second sub-area includes a plurality of second light emitting units, and a second light emitting unit includes a plurality of adjacent second light emitting elements. A quantity of the first light emitting elements in the first light emitting unit is the same as a quantity of the second light emitting elements in the second light emitting unit; and at least three first light emitting elements in the first light emitting unit are configured to emit light of different colors, and at least three second light emitting elements in the second light emitting unit are configured to emit light of different colors. In an adjacent region of the first sub-area and the second sub-area, along the first direction, a minimum distance between the first light emitting unit and the second light emitting unit is less than a distance between adjacent first light emitting units and greater than a distance between adjacent second light emitting units.

In another aspect, an embodiment provides a display apparatus, including the display substrate described above, and a sensor located on a non-display side of the display substrate. An orthographic projection of the sensor on the display substrate is at least partially overlapped with a first display area of the display substrate.

In another aspect, an embodiment provides a display substrate including a first display area and a second display area located on at least one side of the first display area. The first display area includes a first sub-area and a second sub-area located on at least one side of the first sub-area close to the second display area. The first sub-area includes a plurality of first pixel circuits and a plurality of first light emitting elements provided on a base substrate. The plurality of first pixel circuits and the plurality of first light emitting elements are electrically connected; and an orthographic projection of the first light emitting elements on the base substrate is at least partially overlapped with an orthographic projection of the first pixel circuits connected therewith on the base substrate. The second sub-area includes a plurality of second light emitting elements provided on the base substrate. The second display area at least includes a plurality of second pixel circuits provided on the base substrate. At least one second pixel circuit among the plurality of second pixel circuits is electrically connected with at least one second light emitting element among the plurality of second light emitting elements through a conductive connection line, and a distance between an orthographic projection of the second light emitting elements on the base substrate and an orthographic projection of the second pixel circuits with which the second light emitting elements are connected on the base substrate is greater than 0. For the first light emitting elements and the second light emitting elements emitting light of a same color in the first display area, along the first direction, a distance between adjacent first light emitting elements emitting light of the same color in the first sub-area is greater than a distance between adjacent second light emitting elements emitting light of the same color in the second sub-area.

In some exemplary embodiments, along the first direction, the distance between adjacent first light emitting elements emitting light of the same color in the first sub-area is 1.5 times to 2 times the distance between adjacent first light emitting elements emitting light of the same color in the second sub-area.

In some exemplary embodiments, the first sub-area includes a plurality of display island areas and a light transmitting area located between adjacent display island areas. A display island area at least includes a first light emitting unit, and the first light emitting unit includes a plurality of adjacent first light emitting elements. The second sub-area at least includes a plurality of second light emitting units, and a second light emitting unit includes a plurality of adjacent second light emitting elements. A quantity of the first light emitting elements in the first light emitting unit is the same as a quantity of the second light emitting elements in the second light emitting unit; and at least three first light emitting elements in the first light emitting unit are configured to emit light of different colors, and at least three second light emitting elements in the second light emitting unit are configured to emit light of different colors. In an adjacent region of the first sub-area and the second sub-area, along the first direction, a minimum distance between the first light emitting unit and the second light emitting unit is less than a distance between adjacent first light emitting units and greater than a distance between adjacent second light emitting units.

Other aspects of the present disclosure may be comprehended after the drawings and the detailed descriptions are read and understood.

Brief Description of Drawings

Accompanying drawings are used for providing an understanding of technical solutions of the present application and form a part of the specification, are used for explaining the technical solutions of the present application together with embodiments of the present application, and do not constitute a limitation on the technical solutions of the present application.

FIGS. 1A, 1B and 1C are schematic diagrams of a display substrate according to at least one embodiment of the present disclosure.

FIG. 2 is an equivalent circuit diagram of a pixel circuit according to at least one embodiment of the present disclosure.

FIG. 3 is a partial schematic diagram of a display region according to at least one embodiment of the present disclosure.

FIG. 4 is a partial schematic diagram of a first display area according to at least one embodiment of the present disclosure.

FIG. 5 is a partial schematic diagram of a display island area according to at least one embodiment of the present disclosure.

FIG. 6A is a partial sectional schematic diagram of a display substrate according to at least one embodiment of the present disclosure.

FIG. 6B is another partial sectional schematic diagram of a display substrate according to at least one embodiment of the present disclosure.

FIG. 6C is still another partial sectional schematic diagram of a display substrate according to at least one embodiment of the present disclosure.

FIG. 6D is yet another partial sectional schematic diagram of a display substrate according to at least one embodiment of the present disclosure.

FIG. 7 is a schematic diagram of a first semiconductor layer of a display island area according to at least one embodiment of the present disclosure.

FIG. 8A is a schematic diagram of a display island area after a first conductive layer is formed according to at least one embodiment of the present disclosure.

FIG. 8B is a schematic diagram of the first conductive layer in FIG. 8A.

FIG. 9A is a schematic diagram of a display island area after a second conductive layer is formed according to at least one embodiment of the present disclosure.

FIG. 9B is a schematic diagram of the second conductive layer in FIG. 9A.

FIG. 10A is a schematic diagram of a display island area after a second semiconductor layer is formed according to at least one embodiment of the present disclosure.

FIG. 10B is a schematic diagram of the first semiconductor layer and the second semiconductor layer in FIG. 10A.

FIG. 11A is a schematic diagram of a display island area after a third conductive layer is formed according to at least one embodiment of the present disclosure.

FIG. 11B is a schematic diagram of the third conductive layer in FIG. 11A.

FIG. 12 is a schematic diagram of a display island area after a fifth insulating layer is formed according to at least one embodiment of the present disclosure.

FIG. 13A is a schematic diagram of a display island area after a fourth conductive layer is formed according to at least one embodiment of the present disclosure.

FIG. 13B is a schematic diagram of the fourth conductive layer in FIG. 13A.

FIG. 14 is a schematic diagram of a display island area after a sixth insulating layer is formed according to at least one embodiment of the present disclosure.

FIG. 15A is a schematic diagram of a display island area after a fifth conductive layer is formed according to at least one embodiment of the present disclosure.

FIG. 15B is a schematic diagram of the fifth conductive layer in FIG. 15A.

FIG. 16 is a partial schematic diagram of a light shielding layer of a first sub-area according to at least one embodiment of the present disclosure.

FIG. 17 is another partial schematic diagram of a light shielding layer of a first sub-area according to at least one embodiment of the present disclosure.

FIG. 18 is a partial top view of a first sub-area according to at least one embodiment of the present disclosure.

FIG. 19 is another partial schematic diagram of a display region according to at least one embodiment of the present disclosure.

FIG. 20 is a schematic top view of a display island area according to at least one embodiment of the present disclosure.

FIG. 21 is a schematic diagram of a first semiconductor layer in FIG. 20.

FIG. 22 is a schematic diagram of the first semiconductor layer and the first conductive layer in FIG. 20.

FIG. 23 is a schematic diagram of the first semiconductor layer, the first conductive layer, and the second conductive layer in FIG. 20.

FIG. 24 is a schematic diagram of the first semiconductor layer, the first conductive layer, the second conductive layer, and the second semiconductor layer in FIG. 20.

FIG. 25 is a schematic diagram of the first semiconductor layer, the first conductive layer, the second conductive layer, the second semiconductor layer, and the third conductive layer in FIG. 20.

FIG. 26 is a schematic diagram of via holes provided in the first semiconductor layer, the first conductive layer, the second conductive layer, the second semiconductor layer, the third conductive layer, and the fifth insulating layer in FIG. 20.

FIG. 27A is a schematic diagram of a display island area after a fourth conductive layer is formed in FIG. 20.

FIG. 27B is a schematic diagram of the fourth conductive layer in FIG. 27A.

FIG. 28 is still another partial schematic diagram of a light shielding layer of a first sub-area according to at least one embodiment of the present disclosure.

FIG. 29 is a partial schematic diagram of a display island area according to at least one embodiment of the present disclosure.

FIG. 30 is a schematic diagram of a cathode layer of a first display area according to at least one embodiment of the present disclosure.

FIG. 31 is still another partial schematic diagram of a display region according to at least one embodiment of the present disclosure.

FIG. 32 is another partial schematic diagram of a first display area according to at least one embodiment of the present disclosure.

FIG. 33 is yet another partial schematic diagram of a display region according to at least one embodiment of the present disclosure.

FIG. 34 is a schematic diagram of a display apparatus according to at least one embodiment of the present disclosure.

Detailed Description

The embodiments of the present disclosure will be described below with reference to the drawings in detail. Implementation modes may be implemented in a plurality of different forms. Those of ordinary skills in the art may easily understand such a fact that implementations and contents may be transformed into other forms without departing from the purpose and scope of the present disclosure. Therefore, the present disclosure should not be explained as being limited to the contents recorded in the following implementations only. The embodiments and features in the embodiments of the present disclosure may be randomly combined with each other if there is no conflict.

In the drawings, a size of one or more constituent elements, a thickness of a layer, or a region is sometimes exaggerated for clarity. Therefore, one implementation of the present disclosure is not necessarily limited to the size, and a shape and a size of one or more components in the drawings do not reflect an actual scale. In addition, the accompanying drawings schematically illustrate ideal examples, and an implementation of the present disclosure is not limited to shapes, numerical values, or the like shown in the drawings.

Ordinal numerals "first", "second", "third", etc., in the specification are set not to form limits in numbers but only to avoid confusion between composition elements. In the present disclosure, "plurality" represents two or more than two.

In the specification, for convenience, expressions "central", "above", "below", "front", "back", "vertical", "horizontal", "top", "bottom", "inside", "outside", etc., indicating directional or positional relationships are used to illustrate positional relationships between the composition elements, not to indicate or imply that involved devices or elements are required to have specific orientations and be structured and operated with the specific orientations but only to easily and simply describe the present specification, and thus should not be understood as limitations on the present disclosure. The positional relationships between the constituent elements are changed as appropriate according to a direction where the constituent elements are described. Therefore, appropriate replacements based on situations are allowed, which is not limited to the expressions in the specification.

In the specification, unless otherwise specified and defined explicitly, terms "mount", "mutually connect", "connect", and "couple" should be understood in a broad sense. For example, it may be a fixed connection, a detachable connection, or an integral connection; it may be a mechanical connection or a connection; it may be a direct connection, an indirect connection through a middleware, or an internal communication inside two elements. Those of ordinary skills in the art may understand meanings of the aforementioned terms in the present disclosure according to situations.

In the specification, "electrical connection" includes connection of composition elements through an element with a certain electrical action. The "element with a certain electrical action" is not particularly limited as long as electrical signals between the connected constituent elements may be transmitted. Examples of the "element with a certain electrical action" not only include an electrode and a wiring, but also include a switching element such as a transistor, a resistor, an inductor, a capacitor, another element with a plurality of functions, etc.

In the specification, a transistor refers to an element which at least includes three terminals, i.e., a gate, a drain electrode, and a source electrode. The transistor has a channel region between the drain electrode (drain electrode terminal, drain electrode region, or drain electrode) and the source electrode (source electrode terminal, source electrode region, or source electrode), and a current can flow through the drain electrode, the channel region, and the source electrode. In the specification, the channel region refers to a region through which a current mainly flows.

In the specification, a first electrode may be a drain electrode and a second electrode may be a source electrode, or, a first electrode may be a source electrode and a second electrode may be a drain electrode. In a case that transistors with opposite polarities are used, or in a case that a direction of a current is changed during operation of a circuit, or the like, functions of the "source electrode" and the "drain electrode" are sometimes interchangeable. Therefore, the "source electrode" and the "drain electrode" are interchangeable in the specification. In addition, the gate may also be referred to as a control electrode.

In the specification, "parallel" refers to a state in which an angle formed by two straight lines is -10° or more and 10° or less, and thus also includes a state in which the angle is -5° or more and 5° or less. In addition, "perpendicular" refers to a state in which an angle formed by two straight lines is 80° or more and 100° or less, and thus also includes a state in which the angle is 85° or more and 95° or less.

In this specification, a circle, oval, triangle, rectangle, trapezoid, pentagon or hexagon, etc. is not strictly speaking, but may be an approximate circle, oval, triangle, rectangle, trapezoid, pentagon or hexagon, etc. Some small deformations due to tolerances may exist, for example, guide angles, curved edges and deformations thereof may exist.

A "light transmittance" in the present disclosure refers to an ability of light to pass through a medium, and is a percentage of luminous flux passing through a transparent or translucent body to its incident luminous flux.

In the present disclosure, "about" and "substantially" refer to that a boundary is not defined strictly and a case within a range of process and measurement errors is allowed. In the present disclosure, the same may include the cases of exactly the same and substantially the same. "Substantially the same" refers to a case where numerical values differ within 10%.

In the present disclosure, "A extends along a B direction" means that A may include a main body portion and a secondary portion connected with the main body portion, the main body portion is a line, a line segment, or a strip-shaped body, the main body portion extends along the B direction, and a length of the main body portion extending along the B direction is greater than a length of the secondary portion extending along another direction. "A extends in a B direction" in the present disclosure means "the main portion of A extends along the B direction".

With continuous development of display technologies, a camera is usually installed on a display apparatus to meet the needs of shooting or face recognition. In order to maximize a screen-to-body ratio, technologies such as fringe screen, water drop screen and in-screen hole have successively came into being. These technologies reduce the area occupied by a camera by digging a hole locally in a display area and placing the camera under a hole-digging region, thus increasing the screen-to-body ratio. However, the above technologies need to dig out part of the display area, which will cause some regions in a display picture to be unable to be displayed, and make it impossible to further improve the screen-to-body ratio. In order to avoid punching holes in the display area and under a premise of ensuring practicability of the display substrate, it is possible to achieve a true full-screen by adopting a pixel circuit built-out method or a pixel circuit built-in method in the full display with camera (FDC) region.

The pixel circuit built-out method means that the pixel circuits connected with the light emitting elements in the FDC region is provided in the normal display region, and the light transmittance of the FDC region is improved by arranging the light emitting elements and the pixel circuits separately. Because the pixel circuit is not provided in the FDC region, there is no light shielding layer other than the anodes of the light emitting elements in this region, and a higher light transmittance can be achieved. However, in this mode, the pixel circuits and the light emitting elements need to be electrically connected through conductive connection lines, the size (e.g., aperture) of the FDC region of the display substrate using the pixel circuit built-out method is limited due to the limitation of the space for the arrangement of the conductive connection lines. For example, the pixel circuit built-out method is not suitable for the FDC region with a long-hole track. Moreover, increasing the aperture of the FDC region usually requires an increased mask process of conductive connection lines, resulting in increased cost. In addition, the material of the conductive connection line is usually a transparent conductive material, such as indium tin oxide (ITO). Due to the large square resistance of ITO, the load of the longer conductive connection line is large, which may easily affect the brightness of the light emitting elements in the FDC region and reduce the brightness of the FDC region, thereby leading to a display defect in the FDC region, such as a vertical display defect (Mura).

The pixel circuit built-in method refers to the provision of light emitting elements and the pixel circuits connected with the light emitting elements in the FDC region. Compared with the pixel circuit built-out method, the built-in method eliminates the need for long conductive connection lines for the electric connection between the pixel circuits and the light emitting elements in the FDC region, which may avoid the display defect of the FDC region caused by the conductive connection lines. Moreover, the built-in method does not limit the size of the FDC region and may support the FDC region with large aperture. However, in a display substrate adopting the pixel circuit built-in mode, since the anode of the light emitting element in the FDC region cannot completely block the pixel circuit, the light transmittance of the FDC region will be affected.

The present embodiment provides a display substrate and a display apparatus, which may support increasing the size of the FDC region while ensuring the light transmittance of the FDC region.

The present embodiment provides a display substrate, including a first display area and a second display area located on least one side of the first display area. The first display area includes a first sub-area and a second sub-area located on at least one side of the first sub-area close to the second display area. The first sub-area includes a plurality of display island areas and a first light transmitting area located between adjacent display island areas. A display island area includes a plurality of first pixel circuits and a plurality of first light emitting elements provided on a base substrate. The plurality of first pixel circuits and the plurality of first light emitting elements are electrically connected. An orthographic projection of a first light emitting element on the base substrate is at least partially overlapped with an orthographic projection of a first pixel circuit connected therewith on the base substrate. The second sub-area includes a plurality of second light emitting elements provided on the base substrate. The second display area at least includes a plurality of second pixel circuits provided on the base substrate. At least one second pixel circuit among the plurality of second pixel circuits is electrically connected with at least one second light emitting element among the plurality of second light emitting elements through a conductive connection line. A distance between an orthographic projection of a second light emitting element on the base substrate and an orthographic projection of a second pixel circuit with which the second light emitting element is connected on the base substrate is greater than 0. In other words, the orthographic projection of the second light emitting element on the base substrate is not overlapped with the orthographic projection of the second pixel circuit connected therewith on the base substrate.

The display substrate provided by the present embodiment adopts a combination of the pixel circuit built-out mode and the pixel circuit built-in mode, which may ensure the light transmittance of the first display area, and supports increasing a size of the first display area. For example, the present example may meet the design requirements of the FDC region with a long-hole track.

In some exemplary embodiments, the plurality of first pixel circuits of the display island area are connected with a plurality of first signal lines extending along a first direction and a plurality of second signal lines extending along a second direction. In the first sub-area, the plurality of first signal lines of adjacent display island areas in the first direction are connected through a plurality of first island area connection lines, and the plurality of second signal lines of adjacent display island areas in the second direction are connected through a plurality of second island area connection lines. The first direction intersects the second direction, for example, the first direction may be perpendicular to the second direction. In the present example, signal transmission along the first direction between the first pixel circuits of the adjacent display island areas is achieved by the first island area connection lines, and signal transmission along the second direction between the first pixel circuits of the adjacent display island areas is achieved by the second island area connection lines, so as to ensure the signal transmission in the first direction and the second direction between the adjacent display island areas.

In some exemplary embodiments, the conductive connection line includes at least one wire layer, and the plurality of first island area connection lines, the plurality of second island area connection lines and the at least one wire layer of the conductive connection line may be of a same layer structure, and made of a transparent conductive material. In some examples, the conductive connection lines may include a wire layer, and the plurality of first island area connection lines, the plurality of second island area connection lines and the wire layer may be of a same layer structure, and made of a transparent conductive material. In the present example, by providing the plurality of first island area connection lines, the plurality of second island area connection lines and the conductive connection line on a same transparent conductive layer, a quantity of the transparent conductive layers may be reduced, which is conducive to reducing costs. However, the present embodiment is not limited thereto. In some other examples, the conductive connection line may include a plurality of wire layers made of a transparent conductive material, and the plurality of first island area connection lines and the plurality of second island area connection lines may be in a same layer structure as one of the plurality of wire layers. Alternatively, a portion of the first island area connection lines and a portion of the second island area connection lines may be in a same layer structure as one of the plurality of wire layers, and another portion of the first island area connection lines and another portion of the second island area connection lines may be in a same layer structure as another wire layer. In the present example, preparing the plurality of first island area connection lines and the plurality of second island area connection lines with a transparent conductive material may be conducive to improving the light transmittance of the first display area.

In some exemplary embodiments, the plurality of first island area connection lines, the plurality of second island area connection lines, and the conductive connection line may all be made of a metal material. In some examples, the plurality of first island area connection lines, the plurality of second island area connection lines, and the conductive connection line may be located in different metal layers, or may be located in a same metal layer. In the present example, by providing the plurality of first island area connection lines, the plurality of second island area connection lines and the conductive connection line on a metal conductive layer, a quantity of transparent conductive layers may be reduced, which is conducive to reducing costs.

In some exemplary embodiments, the plurality of first island area connection lines and the plurality of second island area connection lines may be made of a metal material, and the conductive connection line may be made of a transparent conductive material. In some examples, the first island area connection lines and the first signal lines transmitting a same signal may be of an interconnected integral structure, and the second island area connection lines and the second signal lines transmitting a same signal may be of an interconnected integral structure. In some other examples, the first island area connection lines and the first signal lines transmitting a same signal may be located in different metal conductive layers. In some other examples, the second island area connection lines and the second signal lines transmitting a same signal may be located in different metal conductive layers. In the present example, the plurality of first island area connection lines and the plurality of second island area connection lines are provided on a metal conductive layer, and the conductive connection line is provided on a transparent conductive layer, which may reduce an opening process of the first sub-area.

In some exemplary embodiments, the plurality of first pixel circuits in the display island area may be connected with a same first power supply line. The wiring in the display island area may be reduced in the present example.

In some exemplary embodiments, the plurality of first pixel circuits of the display island area may be connected with a same first initial signal line and a same second initial signal line. In the display island area, the first initial signal line, the second initial signal line and the first power supply line extend along a same direction, and the first power supply line is located between the first initial signal line and the second initial signal line. The present example may reduce the wiring in the display island area and reduce the intersection of signal lines.

In some exemplary embodiments, the plurality of first pixel circuits of the display island area may be connected with a same light emitting control line, and an extending direction of the light emitting control line intersects an extending direction of the first power supply line. For example, the light emitting control line may include a plurality of light emitting control segments located at different conductive layers, and transmission of a light emitting control signal is achieved by connection of the plurality of light emitting control segments. The present example may reduce the wiring in the display island area and reduce the intersection of signal lines.

In some exemplary embodiments, the display island area may include four first pixel circuits which may be arranged in a 2×2 array, and active layers of the four first pixel circuits may be symmetrically provided about a first center line of the four first pixel circuits in the first direction. The arrangement mode of the present example is conducive to optimizing the layout of the first pixel circuits and improving the area of the first light transmitting area. In some other examples, the display island area may include three first pixel circuits arranged sequentially along the first direction. In the present example, by reducing a quantity of the first pixel circuits of the display island area, a quantity of signal lines may be reduced, which facilitates the improvement of the area of the first light transmitting area.

In some exemplary embodiments, the display substrate may further include a light shielding layer located on a side of the first pixel circuits and the second pixel circuits close to the base substrate. An orthographic projection of the light shielding layer on the base substrate is not overlapped with an orthographic projection of a first light transmitting area on the base substrate. The light shielding layer at least includes a first light shielding block located in the display island area. An orthographic projection of the first light shielding block on the base substrate may cover an orthographic projection of the plurality of first pixel circuits of the display island area and signal lines with which the plurality of first pixel circuits are connected on the base substrate. In some examples, first light shielding blocks of adjacent display island areas are of an interconnected integral structure. In some other examples, first light shielding blocks of adjacent display island areas may be independently provided. The present example shields the first pixel circuits of the display island area and the signal line by providing a light shielding layer, which may be beneficial to prevent diffraction. In some examples, an edge of the first light shielding block close to the first light transmitting area may be substantially an arc-shaped edge. In the present example, the edge of the first light shielding block close to the first light transmitting area may have an approximately a same shape as an outer edge of the signal line in the display island, thereby helping to increase the area of the first light transmitting area.

In some exemplary embodiments, the display substrate may further include a light emitting structure layer located on a side of the plurality of first pixel circuits and the plurality of second pixel circuits away from the base substrate. The light emitting structure layer may include a cathode layer. An orthographic projection of the cathode layer on the base substrate is not overlapped with an orthographic projection of the first light transmitting area on the base substrate. The cathode layer may at least include cathodes of the plurality of first light emitting elements. The cathodes of the plurality of first light emitting elements of the display island area are of an interconnected integral structure, and an orthographic projection of the integral structure of the cathodes of the plurality of first light emitting elements of the display island area on the base substrate covers an orthographic projection of the plurality of first pixel circuits of the display island area and signal lines with which the plurality of first pixel circuits are connected on the base substrate. In the present example, a patterned cathode design is performed to shield the first pixel circuits in the display island area and the signal line, which is beneficial to prevent diffraction.

Schemes of the embodiments will be described below through some examples.

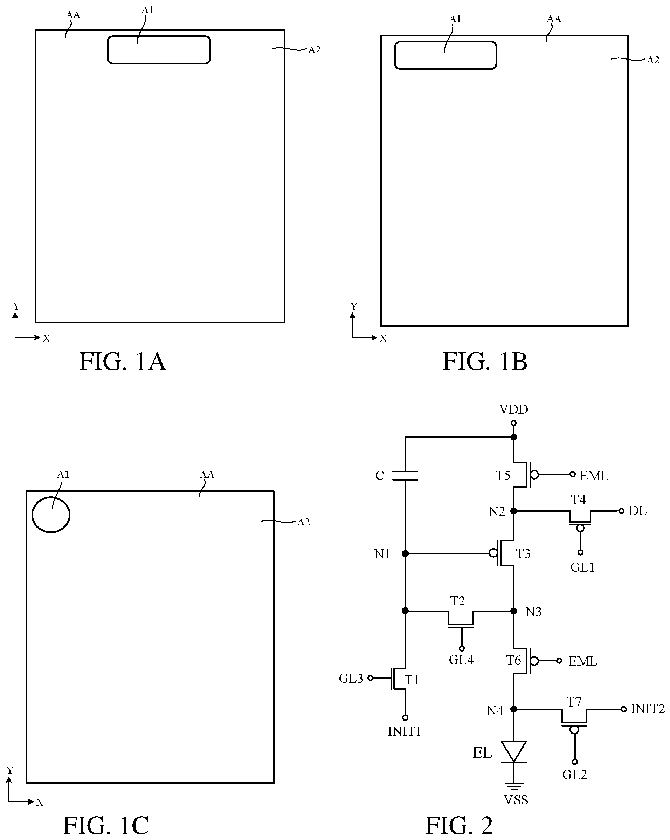

FIGS. 1A, 1B and 1C are schematic diagrams of a display substrate according to at least one embodiment of the present disclosure. In some examples, the display substrate may include a display region AA and a peripheral region (not shown) located at a periphery of the display region AA. The display region AA of the display substrate may at least include a first display area A1 and a second display area A2. The second display area A2 may at least partially surround the first display area A1. For example, as shown in FIG. 1A, the second display area A2 may surround a periphery of the first display area A1. The peripheral region may surround the second display area A2. However, the present embodiment is not limited thereto.

In some examples, the first display area A1 may be a light transmitting display area, which may serve as a Full Display with Camera (FDC) region, or a full display face identification (Face ID) region. The second display area A2 may be referred to as a normal display area. A light transmittance rate of the first display area A1 may be greater than a light transmittance rate of the second display area A2. For example, an orthographic projection of a sensor (such as a camera and other hardware) on the display substrate may be located within the first display area A1 of the display substrate. In some other examples, as shown in FIGS. 1A and 1B, the first display area A1 may be in a shape of a rectangle, and a size of an orthographic projection of a single sensor on the display substrate may be less than or equal to a size of an inscribed circle of the first display area A1. The first display area A1 may cover an orthographic projections of a plurality of sensors on the display substrate. However, the present embodiment is not limited thereto. In some other examples, as shown in FIG. 1C, the first display area A1 may be in a shape of a circle, and a size of an orthographic projection of a single sensor on the display substrate may be less than or equal to a size of the first display area A1.

In some examples, as shown in FIG. 1A, the first display area A1 may be located at a middle position of a top of the display region AA. The second display area A2 may surround a periphery of the first display area A1. However, the present embodiment is not limited thereto. For example, the second display area A2 may surround at least one side of the first display area A1. For example, as shown in FIGS. 1B and 1C, the first display area A1 may be located at an upper left corner of the display region AA. In some other examples, the first display area A1 may be located in other positions such as a lower left corner, a lower right corner or an upper right corner of the display region AA.

In some examples, as shown in FIGS. 1A and 1B, the display region AA may be in a shape of a rectangle, e.g., a rounded rectangle. The first display area A1 may have a rectangular shape. For example, it may have a strip shape extending substantially along the first direction X. A length of the first display area A1 along the first direction X may be greater than a length along the second direction Y. The first direction X intersects the second direction Y. For example, the first direction X may be perpendicular to the second direction Y. However, the present embodiment is not limited thereto. For example, as shown in FIG. 1C, the first display area A1 may be in a shape of a circle. In some other examples, the first display area A1 may be in other shapes such as a semicircle or a pentagon.

In some examples, the display region AA may be provided with a plurality of sub-pixels. At least one sub-pixel may include a pixel circuit and a light emitting element. The pixel circuit may be configured to drive a light emitting element connected therewith. For example, the pixel circuit may be configured to provide a drive current for driving the light emitting element to emit light. The pixel circuit may include a plurality of transistors and at least one capacitor. For example, the pixel circuit may be a circuit of a 3T1C, 4T1C, 5T1C, 5T2C, 6T1C, 7T1C, or 8T1C structure. Herein, in the above circuit structure, T refers to a thin film transistor, C refers to a capacitor, a number before T represents a quantity of thin film transistors in the circuit, and a number before C represents a quantity of capacitors in the circuit.

In some examples, the light emitting element may be any of a Light Emitting Diode (LED), an Organic Light Emitting Diode (OLED), a Quantum dot Light Emitting Diode (QLED), a micro LED (including: mini-LED or micro-LED), and the like. For example, the light emitting element may be an OLED, and the light emitting element may emit red light, green light, blue light, or white light, etc. under drive of a pixel circuit corresponding to the light emitting element. A color of light emitted by the light emitting element may be determined as required. In some examples, the light emitting element may include an anode, a cathode, and an organic emitting layer located between the anode and the cathode. The anode of the light emitting element may be electrically connected with a corresponding pixel circuit. However, the present embodiment is not limited thereto.

FIG. 2 is an equivalent circuit diagram of a pixel circuit according to at least one embodiment of the present disclosure. The pixel circuit of the present example may be a 7T1C structure, and may include seven transistors (e.g., first transistors T1 to seventh transistors T7) and one capacitor (e.g., storage capacitor C). The pixel circuit may be electrically connected with a first scan line GL1, a second scan line GL2, a third scan line GL3, a fourth scan line GL4, a light emitting control line EML, a first initial signal line INIT1, a second initial signal line INIT2, a data line DL, and a first power supply line VDD.

In some examples, the first transistor T1 is also referred to as a first reset transistor, the second transistor T2 is also referred to as a threshold compensation transistor, the third transistor T3 is also referred to as a drive transistor, the fourth transistor T4 is also referred to as a data writing transistor, the fifth transistor T5 is also referred to as a first light emitting control transistor, the sixth transistor T6 is also referred to as a second light emitting control transistor, and the seventh transistor T7 is also referred to as a second reset transistor. The light emitting device EL may be an Organic Light Emitting Diode (OLED) including a first electrode (e.g., anode), an organic emitting layer, and a second electrode (e.g., cathode) that are stacked.

In some examples, the third transistor T3 to the seventh transistor T7 may be transistors of the first type, such as P-type transistors; and the first transistor T1 and the second transistor T2 may be transistors of the second type, for example, N-type transistors. However, the present embodiment is not limited thereto. In some other examples, the first transistor T1 to the seventh transistor T7 may all be P-type transistors, or may all be N-type transistors.

In some examples, for the first type transistor (including, for example, the third transistor T3 to the seventh transistor T7) of the pixel circuit, a low temperature poly silicon thin film transistor may be adopted, and for the second type transistor (including, for example, the first transistor T1 and the second transistor T2) of the pixel circuit, an oxide thin film transistor may be adopted. Low Temperature Poly Silicon (LTPS) is used for an active layer of a low temperature poly silicon thin film transistor and an oxide semiconductor (Oxide) is used for an active layer of an oxide thin film transistor. The low temperature poly silicon thin film transistor has advantages, such as a high mobility, and fast charging, etc., while the oxide thin film transistor has advantages, such as a low leakage current, etc. The low temperature poly-silicon thin film transistor and the oxide thin film transistor are integrated on one display substrate to form a low temperature poly-crystalline oxide (LTPS+ Oxide) display substrate, and advantages of both the low temperature poly silicon thin film transistor and the oxide thin film transistor can be utilized, which can achieve low frequency drive, reduce power consumption, and improve display quality.

In some examples, a first end of the storage capacitor C is connected with a first node N1, that is, the first end of the storage capacitor C is connected with a control electrode of the third transistor T3, and a second end of the storage capacitor C is connected with the first power supply line VDD.

In some examples, a gate of the first transistor T1 is connected with the third scan line GL3, a first electrode of the first transistor T1 is connected with the first initial signal line INIT1, and a second electrode of the first transistor T1 is connected with the first node N1. When a scan signal with an on-level is applied to the third scan line GL3, the first transistor T1 transmits a first initialization voltage to the control electrode of the third transistor T3 so as to initialize a charge amount of the control electrode of the third transistor T3.

In some examples, a gate of the second transistor T2 is connected with the fourth scan line GL4, a first electrode of the second transistor T2 is connected with a third node N3, and a second electrode of the second transistor T2 is connected with the first node N1. When a scan signal with an on-level is applied to the fourth scan line GL4, the second transistor T2 enables the gate of the third transistor T3 to be connected with the second electrode of the third transistor T3.

In some examples, the gate of the third transistor T3 is connected with the first node N1, i.e., the gate of the third transistor T3 is connected with the first end of the storage capacitor C, the first electrode of the third transistor T3 is connected with the second node N2, and the second electrode of the third transistor T3 is connected with the third node N3. The third transistor T3 may be referred to as a drive transistor (DTFT), and the third transistor T3 determines an amount of a drive current flowing between the first power supply line VDD and the second power supply line VSS according to a potential difference between the gate and the first electrode of the third transistor T3. The first power supply line VDD may be configured to transmit a first voltage signal, the second power supply line VSS may be configured to transmit a second voltage signal, and the first voltage signal may be greater than the second voltage signal.

In some examples, a gate of the fourth transistor T4 is connected with the first scan line GL1, a first electrode of the fourth transistor T4 is connected with the data line DL, and a second electrode of the fourth transistor T4 is connected with the second node N2. The fourth transistor T4 may be referred to as a data writing transistor. When a scan signal with an on-level is applied to the first scan line GL1, the fourth transistor T4 enables a data voltage of the data signal line DL to be input to the pixel circuit.

In some examples, a gate of the fifth transistor T5 is connected with the light emitting control line EML, a first electrode of the fifth transistor T5 is connected with the first power supply line VDD, and a second electrode of the fifth transistor T5 is connected with the second node N2. A gate of the sixth transistor T6 is connected with the light emitting control line EML, a first electrode of the sixth transistor T6 is connected with the third node N3, and a second electrode of the sixth transistor T6 is connected with a fourth node N4. The fifth transistor T5 and the sixth transistor T6 may be referred to as light emitting transistors. When a light emitting signal with an on-level is applied to the light emitting control line EML, the fifth transistor T5 and the sixth transistor T6 enable the light emitting device to emit light by forming a driving current path between the first power supply line VDD and the second power supply line VSS.

In some examples, a gate of the seventh transistor T7 is connected with the second scan line GL2, a first electrode of the seventh transistor T7 is connected with the second initial signal line INIT2, and a second electrode of the seventh transistor T7 is connected with the fourth node N4. When a scan signal with an on-level is applied to the second scan line GL2, the seventh transistor T7 transmits a second initialization voltage to the first electrode of the light emitting device so as to initialize a charge amount accumulated in the first electrode of the light emitting device or release a charge amount accumulated in the first electrode of the light emitting device.

In some examples, a second electrode of the light emitting device EL is connected with the second power supply line VSS, a signal of the second power supply line VSS is a low-level signal, and a signal of the first power supply line VDD is a high-level signal. The first scan line GL1 is a scan line in a pixel circuit in the present display row, and the second scan line GL2 is a scan line in a pixel circuit in a previous display row, that is, for an nth display row, the first scan line GL1 is GL(n), the second scan line GL2 is GL(n-1), the second scan line GL2 in the present display row and the first scan line GL1 in the pixel circuit in the previous display row may be a same signal line, so as to reduce signal lines of the display panel and achieve a narrow border of the display panel.

In some examples, as shown in FIG. 2, the first node N1 may be connected with the second electrode of the first transistor T1, the second electrode of the second transistor T2, the gate of the third transistor T3, and the first end of the storage capacitor C, respectively. The second node N2 may be connected with the second electrode of the fifth transistor T5, the second electrode of the fourth transistor T4, and the first electrode of the third transistor T3, respectively. The third node N3 may be connected with the second electrode of the third transistor T3, the first electrode of the second transistor T2, and the first electrode of the sixth transistor T6, respectively. The fourth node N4 may be connected with the second electrode of the sixth transistor T6, the second electrode of the seventh transistor T7, and the first electrode of the light emitting device EL, respectively.

In some other examples, the pixel circuit of the present embodiment may be an 8T1C structure, and may include eight transistors (e.g., a first transistor to an eighth transistor) and a capacitor. The eighth transistor may also be referred to as a third reset transistor. A gate of the eighth transistor may be connected with the second scan line, a first electrode of the eighth transistor is connected with the third initial signal line, and a second electrode of the eighth transistor is connected with the second node. When a scan signal with an on-level is applied to the second scan line, the eighth transistor may transmit a third initialization voltage provided by the third initial signal line to the second node to initialize the second node. The eighth transistor may be a transistor of first type, for example, a P-type transistor. The description of the first to seventh transistors and the capacitance of the pixel circuit may be referred to the description corresponding to FIG. 2, which will not be described here in detail.

In some examples, a working process of the pixel circuit of the present example may include the following stages. The description is made by taking the first transistor T1 and the second transistor T2 as N-type transistors and the third transistor T3 to the seventh transistor T7 as P-type transistors as an example.

The first stage is referred to as a reset stage. Signals of the first scan line GL1, the third scan line GL3, and the light emitting control line EML are high-level signals, and signals of the second scan line GL2 and the fourth scan line GL4 are low-level signals. The signal of the third scan line GL3 is a high-level signal, so that the first transistor T1 is turned on, and a signal of the first initial signal line INIT1 is provided to the first node N1 to initialize the storage capacitor C, and clear an original data voltage in the storage capacitor C. The signal of the second scan line GL2 is a low-level signal, so that the seventh transistor T7 is turned on. The seventh transistor T7 is turned on so that an initial voltage of the second initial signal line INIT2 is provided to the first electrode of the light emitting device EL to initialize (reset) the first electrode of the light emitting device EL, and clear a pre-stored voltage therein, thereby completing the initialization. The signals of the first scan line GL1 and the light emitting control line EML are high-level signals, so that the second transistor T2, the fourth transistor T4, the fifth transistor T5, and the sixth transistor T6 are turned off. The signal of the fourth scan line GL4 is at a low level, and the second transistor T2 is turned off. At this stage, the light emitting device EL does not emit light.

The second stage is referred to as a data writing stage or a threshold compensation stage. Signals of the first scan line GL1 and the third scan line GL3 are low-level signals, signals of the second scan line GL2, the fourth scan line GL4 and the light emitting control line EML are high-level signals, and the data line DL outputs a data voltage.

In this stage, the first end of the storage capacitor C is at a low level, so the third transistor T3 is turned on. The signal of the first scan line GL1 is a low-level signal, so that the fourth transistor T4 is turned on, and the signal of the fourth scan line GL4 is a high-level signal, so that the second transistor T2 is turned on. The second transistor T2 and the fourth transistor T4 are turned on so that the data voltage output by the data line DL is provided to the first node N1 through the second node N2, the turned-on third transistor T3, the third node N3, and the turned-on second transistor T2, and a voltage difference between the data voltage output by the data line DL and a threshold voltage of the third transistor T3 is charged to the storage capacitor C, where a voltage at the first end (the first node N1) of the storage capacitor C is Vd-|Vth|, Vd is the data voltage output by the data line DL, and Vth is the threshold voltage of the third transistor T3. The signal of the second scan line GL2 is a high-level signal, so that the seventh transistor T7 is turned off. The signal of the third scan line GL3 is a low-level signal, so that the first transistor T1 is turned off. The signal of the light emitting control line EML is the high-level signal, so that the fifth transistor T5 and the sixth transistor T6 are turned off.

The third stage is referred to as a light emitting stage. A signal of the light emitting control line EML is a low-level signal, signals of the first scan line GL1 and the second scan line GL2 are high-level signals, and signals of the third scan line GL3 and the fourth scan line GL4 are low-level signals. The signal of the light emitting control line EML is a low-level signal, so that the fifth transistor T5 and the sixth transistor T6 are turned on, and a power supply voltage output from the first power supply line VDD provides a driving voltage to the first electrode of the light emitting device EL through the fifth transistor T5, the third transistor T3 and the sixth transistor T6 which are turned on, so as to drive the light emitting device EL to emit light.

In a drive process of the pixel circuit, a drive current flowing through the third transistor T3 (the drive transistor) is determined by a voltage difference between the gate and the first electrode of the third transistor T3. Since the voltage of the first node N1 is Vdata-|Vth|, the drive current of the third transistor T3 is as follows.

$$I = K \times (Vgs\text{-}Vth)^2 = K \times [(Vdd\text{-}Vd+|Vth|)\text{-}Vth]^2 = K \times [Vdd\text{-}Vd]^2$$

Herein, I is the drive current flowing through the third transistor T3, i.e., a drive current for driving the light emitting device EL, K is a constant, Vgs is the voltage difference between the gate and the first electrode of the third transistor T3, Vth is the threshold voltage of the third transistor T3, Vd is the data voltage output by the data line DL, and Vdd is the power voltage output by the first power supply line VDD.

It may be seen from the above formula that a current flowing through the light emitting element is independent of the threshold voltage of the third transistor T3. Therefore, the pixel circuit according to this embodiment may better compensate the threshold voltage of the third transistor T3.

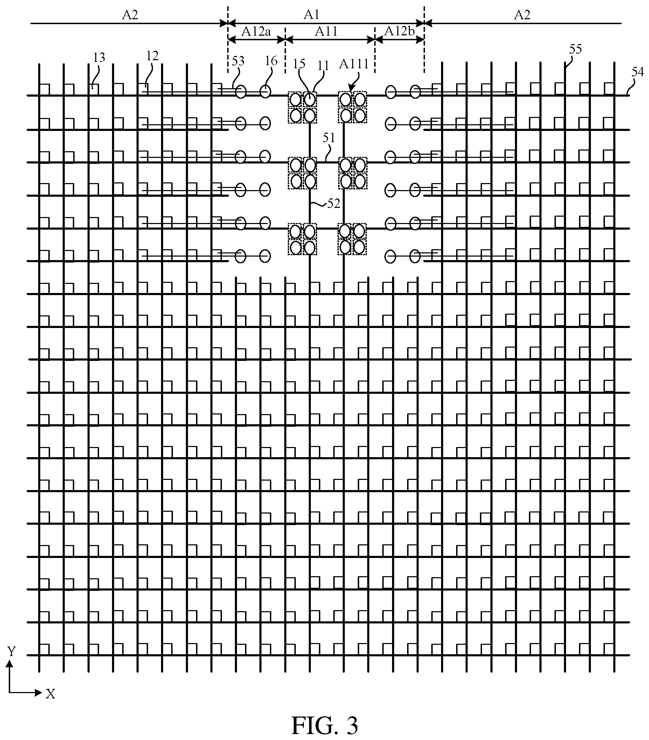

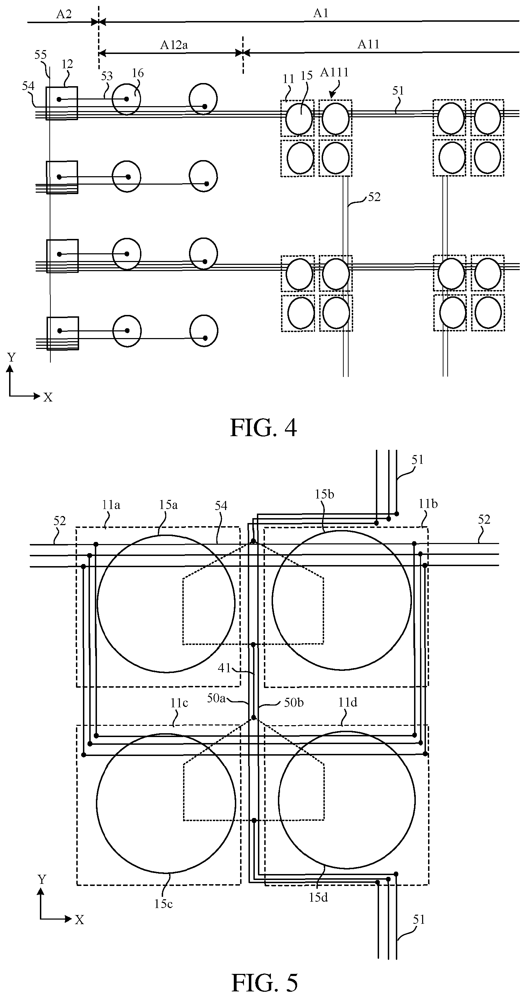

FIG. 3 is a partial schematic diagram of a display region according to at least one embodiment of the present disclosure. FIG. 4 is a partial schematic diagram of a first display area according to at least one embodiment of the present disclosure.

In some examples, as shown in FIG. 3, the first display area A1 may include a first sub-area A11 and two second sub-areas A12a and A12b. The second sub-areas A12a and A12b may be located on opposite sides of the first sub-area A11 close to the second display area A2. The first sub-area A11 may be located between the two second sub-areas A12a and A12b in the first direction X. The second sub-area A12a may be located between the first sub-area A11 and the second display area A2 on the left, and the second sub-area A12b may be located between the first sub-area A11 and the second display area A2 on the right. In the second direction Y, the first sub-area A11, and the second sub-areas A12a and A12b may be directly adjacent to the second display area A2. However, the present embodiment is not limited thereto. In some other examples, the second sub-area may be located on one side or opposite sides of the first sub-area in the second direction Y; alternatively, the second sub-area may be located between the first sub-area and the second display area in both the first direction X and the second direction Y.

In some examples, an area of the first sub-area A11 may account for one-third to two-thirds of a total area of the first display area A1. For example, areas of the first sub-area A11, the second sub-area A12a, and the second sub-area A12b may be substantially the same. The area of the first sub-area A11 may account for one-third of the total area of the first display area A1, the area of the second sub-area A12a may account for one-third of the total area of the first display area A1, and the area of the second sub-area A12b may account for one-third of the total area of the first display area A1. However, the present embodiment is not limited thereto. In some other examples, the area of the first sub-area A11 may be greater than the area of a single second sub-area, or the area of the first sub-area may be greater than or equal to the total area of a plurality of second sub-areas.

In some examples, the first sub-area A11 may include a plurality of display island areas A111 arranged in an array. Each display island area A111 may be configured to perform image display. The plurality of display island areas A111 may be arranged in an array along the first direction X and the second direction Y. The plurality of display island areas A111 arranged along the first direction X may be referred to as a row of display island areas, and the plurality of display island areas A111 arranged along the second direction Y may be referred to as a column of display island areas. FIG. 3 is illustrated with an example of two columns and three rows of display island areas in the first sub-area A11. The present embodiment is not limited to the quantity of display island areas A111 in the first sub-area A11.

In some examples, shapes of the plurality of display island areas A111 may be substantially the same in a plane parallel to the display substrate. For example, the display island area A111 may substantially have an oval shape, or may have other shapes that do not have right-angled edges, so as to provide sufficient light emitting areas to ensure a display effect. The display island area A111 may have smooth edges, thereby reducing the light diffraction effect to help improve the photographing effect. A first light transmitting area may be provided between adjacent display island areas A111, and the first light transmitting area may be configured to provide a light transmission space. For example, a plurality of first light transmitting areas of the first sub-area A11 may communicate with each other. However, the present embodiment is not limited thereto. In some other examples, the plurality of first light transmitting areas of the first sub-area A11 may be independent of each other and not communicated.

In some examples, as shown in FIGS. 3 and 4, the display island A111 may include a plurality of first pixel circuits 11 and a plurality of first light emitting elements 15 (e.g., four first pixel circuits 11 and four first light emitting elements 15). At least one first pixel circuit 11 is electrically connected with at least one first light emitting element 15, and the at least one first pixel circuit 11 may be configured to drive the at least one first light emitting element 15 connected therewith to emit light. Orthographic projections of the first light emitting element 15 and the connected first pixel circuit 11 on the base substrate may at least partially overlap. For example, the plurality of first pixel circuits 11 and the plurality of first light emitting elements 15 may be electrically connected in one-to-one correspondence. However, the present embodiment is not limited thereto. In some other examples, one first pixel circuit 11 may be connected with a plurality of first light emitting elements 15 and configured to drive the plurality of first light emitting elements 15 connected therewith to emit light.

In some examples, one display island area A111 may be provided with one first pixel unit, and the one first pixel unit may include four first sub-pixels, each of which may include a first pixel circuit 11 and a first light emitting element 15. In some other examples, one first pixel unit may include three first sub-pixels. The present embodiment is not limited thereto.

In some examples, the second sub-areas A12a and A12b may include a plurality of second light emitting elements 16. In FIG. 3, two columns of second light emitting elements 16 in the second sub-areas A12a and A12b are illustrated as an example. The present embodiment is not limited thereto. For example, each second sub-area may include at least one column of second light emitting elements.

In some examples, the second display area A2 may include a plurality of second pixel circuits 12, a plurality of third pixel circuits 13, and a plurality of third light emitting elements (not shown). At least one second pixel circuit 12 may be electrically connected with at least one second light emitting element 16 in the second sub-area A12a or A12b through a conductive connection line 53, and is configured to drive at least one second light emitting element 16 connected therewith to emit light. An orthographic projection of the second light emitting element 16 on the base substrate may be not overlapped with an orthographic projection of the second pixel circuit 12 connected therewith on the base substrate. For example, the plurality of second pixel circuits 12 of the second display area A2 and the plurality of second light emitting elements 16 of the second sub-areas A12a and A12b may be electrically connected in one-to-one correspondence. However, the present embodiment is not limited thereto. In some other examples, the second pixel circuit 12 and the second light emitting element 16 may be in a one-to-many relationship.

In some examples, the conductive connection line 53 may at least extend along the first direction X. The conductive connection line 53 may be made of a transparent conductive material, such as indium tin oxide (ITO). Alternatively, a metal material may be used. The present embodiment is not limited thereto.

In some examples, at least one third pixel circuit 13 in the second display area A2 is electrically connected with at least one third light emitting element 12, and configured to drive the at least one third light emitting element 12 to emit light. An orthographic projection of the third light emitting element on the base substrate may be at least partially overlapped with an orthographic projection of the third pixel circuit 13 on the base substrate. For example, a plurality of third pixel circuits 13 in the second display area are electrically connected with a plurality of third light emitting elements in one-to-one correspondence. However, the present embodiment is not limited thereto. In some other examples, the third pixel circuit 13 and the third light emitting element may be in a one-to-many relationship.

In some examples, in the second display area A2, the plurality of second pixel circuits 12 may be arranged among the plurality of third pixel circuits 13. For example, in the first direction X, one second pixel circuit 12 may be provided after every two third pixel circuits 13. However, the present embodiment is not limited thereto. In some other examples, one second pixel circuit 12 may be provided after every four third pixel circuits 13.

In some examples, since only the second light emitting elements 16 are provided in the second sub-areas A12a and A12b, and no pixel circuits are provided in the second sub-areas A12a and A12b, a gap between adjacent second light emitting elements 16 may form a second light transmitting area, which is conducive to improving the light transmittance of the first display area A1. For example, the second light transmitting area in the second sub-areas A12a and A12b may communicate with the first light transmitting area in the first sub-area A11. However, the present embodiment is not limited thereto.

In some examples, arrangement of the second light emitting elements 16 in the second sub-areas A12a and A12b may be the same as arrangement of the third light emitting elements in the second display area A2, so that the display effect at a junction position of the second sub-areas A12a and A12b and the second display area A2 may tend to be consistent. The arrangement of the second light emitting elements 16 in the second sub-areas A12a and A12b may be different from the arrangement of the first light emitting elements 15 in the first sub-area A11. For example, the first light emitting elements 15 in the first sub-area A11 may be arranged in an island shape to increase an area of the first light transmitting area.

In some examples, the second light emitting element 16 and the third light emitting element that emit light of the same color may have substantially the same light emitting area. A light emitting area of the second light emitting element 16 emitting light of the same color may be larger than a light emitting area of the first light emitting element 15. In the present example, the light emitting area of the light emitting element may refer to an overlapping area of an anode of the light emitting element exposed by a pixel defining layer with an organic light emitting layer and a cathode. The arrangement of the present example may be conducive to ensuring the consistency of the display effect at the junction position of the first display area A1 and the second display area A2, and is conducive to improving the light transmittance of the first display area A1.

In some examples, the first pixel circuit 11, the second pixel circuit 12, and the third pixel circuit 13 in the display region AA may all be connected with a plurality of first signal lines 54 extending along the first direction X and a plurality of second signal lines 55 extending along the second direction Y. For example, the plurality of first signal lines 54 may include a first scan line, a second scan line, a third scan line, a fourth scan line, and a light emitting control line; and the plurality of second signal lines 55 may include a first power supply line, a data line, a first initial signal line, and a second initial signal line. The present embodiment is not limited thereto. In some other examples, the first initial signal line and the second initial signal line may be configured to extend along the first direction X.

In some examples, in the first sub-area A11, the plurality of first signal lines 54 of adjacent display island areas A111 in the first direction X may be connected through a plurality of first island area connection lines 51; and the plurality of second signal lines 55 of adjacent display island areas A111 in the second direction Y may be connected through a plurality of second island area connection lines 52. In some examples, the plurality of first island area connection lines 51 may be located in a first wire area between adjacent display island areas A111, and the plurality of second island area connection lines 52 may be located in a second wire area between adjacent display island areas A111. For example, taking the first wire area and the second wire area that are provided with wires made of a metal material as an example, the first light transmitting area of the first display area A1 may be independently provided, and one first light transmitting area may be formed by being surrounded by four display island areas A111 arranged in a 2×2 array, two first wire areas adjacent along the second direction Y, and two second wire areas adjacent along the first direction X. The present embodiment is not limited thereto. In some other examples, the first wire area and the second wire area may be provided with wires made of a transparent conductive material, so that the first wire area and the second wire area may communicate with adjacent first light transmitting areas, and the light transmittance of the first display area may be improved.

In some examples, the plurality of first signal lines 54 with which the third pixel circuit 13 of the second display area A2 is connected may pass directly through the second sub-areas A12a and A12b so as to extend to be connected with the first pixel circuit 11 in the first sub-area A11. The plurality of second signal lines 55 with which the third pixel circuit 13 of the second display area A2 is connected may extend directly to the first sub-area A11 and be connected with the first pixel circuit 11 of the first sub-area A11. However, the present embodiment is not limited thereto. In some other examples, the plurality of first signal lines 54 with which the third pixel circuit 13 of the second display area A2 is connected may be connected with the first pixel circuit 11 of the first sub-area A11 through the plurality of first island area connection lines 51 provided in the second sub-areas A12a and A12b. In some other examples, the plurality of second signal lines 55 with which the third pixel circuit 13 of the second display area A2 is connected may be connected with the first pixel circuit 11 of the first sub-area A11 through the plurality of second island area connection lines 52.

In some examples, the plurality of first island area connection lines 51 and the plurality of second island area connection lines 52 may be made of a transparent conductive material. For example, the plurality of first island area connection lines 51, the plurality of second island area connection lines 52, and the conductive connection lines 53 may be of a same layer structure. In the present example, a transparent conductive layer is provided to arrange the plurality of first island area connection lines 51, the plurality of second island area connection lines 52 and the conductive connection line 53, so that a quantity of transparent conductive layers may be reduced, which is conducive to reducing costs. However, the present embodiment is not limited thereto. In some other examples, the plurality of first island area connection lines 51 and the plurality of second island area connection lines 52 may be made of a metallic material.

In some examples, a density of light emitting elements in the second display area A2 may be substantially the same as a density of light emitting elements in the second sub-area A12a (or A12b). A density of light emitting elements in the first sub-area A11 may be substantially the same as the density of light emitting elements in the second sub-area A12a (or A12b). The arrangement of the present example is conducive to the display uniformity of the display region. The density of light emitting elements in the present example may refer to a quantity of light emitting elements arranged per unit area.

In the present example, the first sub-area A11 of the first display area A1 adopts a pixel circuit built-in mode, and the second sub-areas A12a and A12b adopt a pixel circuit built-out mode, which may improve the situation of low transmittance when only the pixel circuit built-in mode is adopted and the situation of limited size of the first display area when only the pixel circuit built-out mode is adopted, thereby ensuring the light transmittance of the first display area A1 and supporting the increase of the size of the first display area A1.

FIG. 5 is a partial schematic diagram of a display island area according to at least one embodiment of the present disclosure. In some examples, the display island area may include four first pixel circuits (including, for example, first pixel circuits 11a, 11b, 11c, and 11d), and four first light emitting elements (including, for example, first light emitting elements 15a, 15b, 15c, and 15d). The four first pixel circuits 11a, 11b, 11c, and 11d may be arranged in a 2×2 array. The first pixel circuit 11a may be connected with the first light emitting element 15a, the first pixel circuit 11b may be connected with the first light emitting element 15b, the first pixel circuit 11c may be connected with the first light emitting element 15c, and the first pixel circuit 11d may be connected with the first light emitting element 15d. For example, the first light emitting element 15a may be configured to emit red light, the first light emitting element 15c may be configured to emit blue light, and the first light emitting elements 15b and 15d may be configured to emit green light. The first light emitting element 15a emitting red light and the first light emitting element 15c emitting blue light may be arranged in a same column along the second direction Y, the first light emitting elements 15b and 15d emitting green light may be arranged in a same column along the second direction Y, the first light emitting element 15a emitting red light and the first light emitting element 15b emitting green light may be arranged in a same row, and the first light emitting element 15c emitting blue light and the first light emitting element 15d emitting green light may be arranged in a same row.

In some examples, the four first pixel circuits may be connected with a plurality of first signal lines 54 extending along the first direction X, and the plurality of first signal lines 54 may be connected with a plurality of first island area connection lines 51, thereby achieving signal transmission in the first sub-area A1 along the first direction X. The four first pixel circuits may be connected with a plurality of second signal lines (including, for example, a first power supply line 41, and data lines 50a and 50b) extending along the second direction Y, and the plurality of second signal lines may be connected with a plurality of second island area connection lines 52, thereby achieving signal transmission in the first sub-area A1 along the second direction Y. For example, the four first pixel circuits of the display island area may be connected with a same first power supply line 41, so as to reduce the intersection of signal lines and facilitate the wiring design of the display island area.

In some examples, the plurality of first signal lines and the plurality of first island area connection lines 51 may be located in different film layers, and the plurality of second signal lines and the plurality of second island area connection lines may be located in different film layers. For example, the plurality of first signal lines and the plurality of second signal lines may be made of a metal material, and the plurality of first island area connection lines 51 and the plurality of second island area connection lines may be made of a transparent conductive material. The present embodiment is not limited thereto.

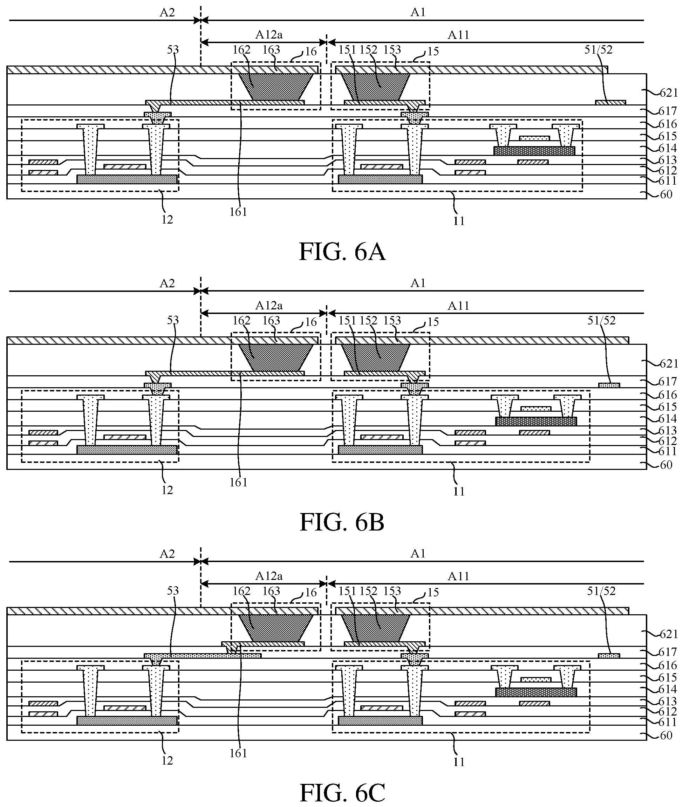

FIG. 6A is a partial sectional schematic diagram of a display substrate according to at least one embodiment of the present disclosure. In some examples, as shown in FIG. 6A, in a direction perpendicular to the display substrate, the display substrate may include a base substrate 60, and a circuit structure layer, a conductive connection layer and a light emitting structure layer which are provided on the base substrate 60. The light emitting structure layer may be located on a side of the circuit structure layer away from the base substrate 60, and the conductive connection layer may be located between the circuit structure layer and the light emitting structure layer. The circuit structure layer of the first display area A1 may include a plurality of first pixel circuits 11. The light emitting structure layer of the first display area A1 may include a plurality of first light emitting elements 15 and a plurality of second light emitting elements 16. The circuit structure layer of the second display area A2 may at least include a plurality of second pixel circuits 12. In FIG. 6A, a first pixel circuit 11 and a first light emitting element 15 in the first sub-area A11, and a second light emitting element 16 in the second sub-area A12a of the first display area A1 are illustrated as an example, in which a first type transistor, a second type transistor and a storage capacitor of the first pixel circuit 11 are illustrated, and a first type transistor and a storage capacitor of the second pixel circuit 12 are also illustrated.

In some examples, the circuit structure layer may include a first semiconductor layer, a first conductive layer, a second conductive layer, a second semiconductor layer, a third conductive layer, a fourth conductive layer, and a fifth conductive layer which are provided on the base substrate 60. A first insulating layer 611 may be provided between the first semiconductor layer and the first conductive layer, a second insulating layer 612 may be provided between the first conductive layer and the second conductive layer, a third insulating layer 613 may be provided between the second conductive layer and the second semiconductor layer, a fourth insulating layer 614 may be provided between the second conductive layer and the third conductive layer, a fifth insulating layer 615 may be provided between the third conductive layer and the fourth conductive layer, a sixth insulating layer 616 may be provided between the fourth conductive layer and the fifth conductive layer, and a seventh insulating layer 617 may be provided on a side of the fifth conductive layer away from the base substrate 60. In some examples, the first insulating layer 611 to the fourth insulating layer 614 may be inorganic insulating layers; the fifth insulating layer 615 may be an inorganic insulating layer, an organic insulating layer, or a laminated structure of an inorganic insulating layer and an organic insulating layer; and the sixth insulating layer 616 to the seventh insulating layer 617 may be organic insulating layers. However, the present embodiment is not limited thereto.

In some examples, the conductive connection layer may be provided on the seventh insulating layer 617. For example, the conductive connection layer may be made of a transparent conductive material (e.g., ITO), and the conductive connection layer may also be referred to as a transparent conductive layer. As shown in FIG. 6A, the conductive connection layer may include a plurality of conductive connection lines 53, a plurality of first island area connection lines 51, and a plurality of second island area connection lines 52, and the conductive connection lines 53 may extend from the second display area A2 to the second sub-area A12a of the first display area A1 to achieve electrical connection of the second light emitting element 16 in the second sub-area A12a with the second pixel circuit 12 in the second display area A2. The plurality of first island area connection lines 51, the plurality of second island area connection lines 52, and the plurality of conductive connection lines 53 are provided on a same conductive layer, which may save transparent conductive film layers and is beneficial to reducing costs. However, the present embodiment is not limited thereto. In some other examples, the display substrate may include a plurality of conductive connection layers made of a transparent conductive material, and at least one conductive connection line may be located in one of the conductive connection layers, or at least one conductive connection line may include a plurality of wire layers located in different conductive connection layers.

In some examples, the light emitting structure layer may include an anode layer, a pixel defining layer 621, an organic light emitting layer, and a cathode layer that are sequentially provided on the seventh insulating layer 617. The anode layer may at least include an anode 151 of the first light emitting element 15 and an anode 161 of the second light emitting element 16. In a direction perpendicular to the display substrate, the anode layer may include a first transparent conductive layer (e.g., being made of an ITO material), a metal layer (including, for example, silver), and a second transparent conductive layer (e.g., being made of an ITO material) that are stacked. The first transparent conductive layer of the anode layer may be connected with the conductive connection layer. For example, the first transparent conductive layer of the anode 161 of the second light emitting element 16 may be of an interconnected integral structure with the conductive connection line 53. The anode 161 of the second light emitting element 16 may be connected with the second pixel circuit 12 through the conductive connection line 53, and the anode 151 of the first light emitting element 15 may be connected with the first pixel circuit 11. However, the present embodiment is not limited thereto. In some other examples, an organic insulating layer may be provided between the anode layer and the conductive connection layer, and the anode layer may be connected with the conductive connection layer through a via opened on the organic insulating layer.

In some examples, the pixel defining layer 621 may be provided with a plurality of pixel openings which may expose a portion of a surface of the anode layer. An organic light emitting layer 152 of the first light emitting element 15 may be in direct contact with the anode 151 through the pixel opening, and a cathode 153 of the first light emitting element 15 may be in direct contact with the organic light emitting layer 152. An organic light emitting layer 162 of the second light emitting element 16 may be in direct contact with the anode 161 through the pixel opening, and a cathode 163 of the second light emitting element 16 may be in direct contact with the organic light emitting layer 162. The organic light emitting layer of the light emitting element may be driven by the anode layer and the cathode layer to emit light of a corresponding color.

In some examples, an encapsulation structure layer may further be provided on a side of the light emitting structure layer away from the base substrate 60. For example, the encapsulation structure layer may include a first encapsulation layer, a second encapsulation layer, and a third encapsulation layer that are stacked. The first encapsulation layer and the third encapsulation layer may be made of an inorganic material, the second encapsulation layer may be made of an organic material, and the second encapsulation layer may be provided between the first encapsulation layer and the third encapsulation layer to form a laminated structure of inorganic material/organic material/inorganic material, which may ensure that external moisture cannot enter the light emitting structure layer. In some possible implementations, the display substrate may further include other film layers, such as a touch structure layer, and a color filter layer, which is not limited here in this embodiment.

FIG. 6B is another partial sectional schematic diagram of a display substrate according to at least one embodiment of the present disclosure. In some examples, as shown in FIG. 6B, the conductive connection layer may be made of a transparent conductive material (e.g., ITO), and the conductive connection layer may include a plurality of conductive connection lines 53. The plurality of first island area connection lines 51 and the plurality of second island area connection lines 52 may be made of a metal material, and may be located, for example, on the fifth conductive layer. However, the present embodiment is not limited thereto. In some other examples, the plurality of first island area connection lines and the plurality of second island area connection lines may be located on the fourth conductive layer. In some other examples, the plurality of first island area connection lines and the plurality of second island area connection lines may be located in different film layers. For example, the first island area connection line may be of an interconnected integral structure with the first signal line connected therewith, and the second island area connection line and the second signal line connected therewith may be of an interconnected integral structure. Rest of description of the display substrate of the present example may be referred to description of the aforementioned embodiments, which will not be described here in detail.

FIG. 6C is still another partial sectional schematic diagram of a display substrate according to at least one embodiment of the present disclosure. In some examples, as shown in FIG. 6C, the conductive connection line 53 may be made of a metal material, and may be located, for example, on the fifth conductive layer. The plurality of first island area connection lines 51 and the plurality of second island area connection lines 52 may be made of a metal material, and may be located, for example, on the fifth conductive layer. However, the present embodiment is not limited thereto. For example, the conductive connection lines may be located in a different metal film layer from the first island area connection lines and the second island area connection lines. Rest of description of the display substrate of the example may be referred to description of the aforementioned embodiments, which will not be described here in detail.

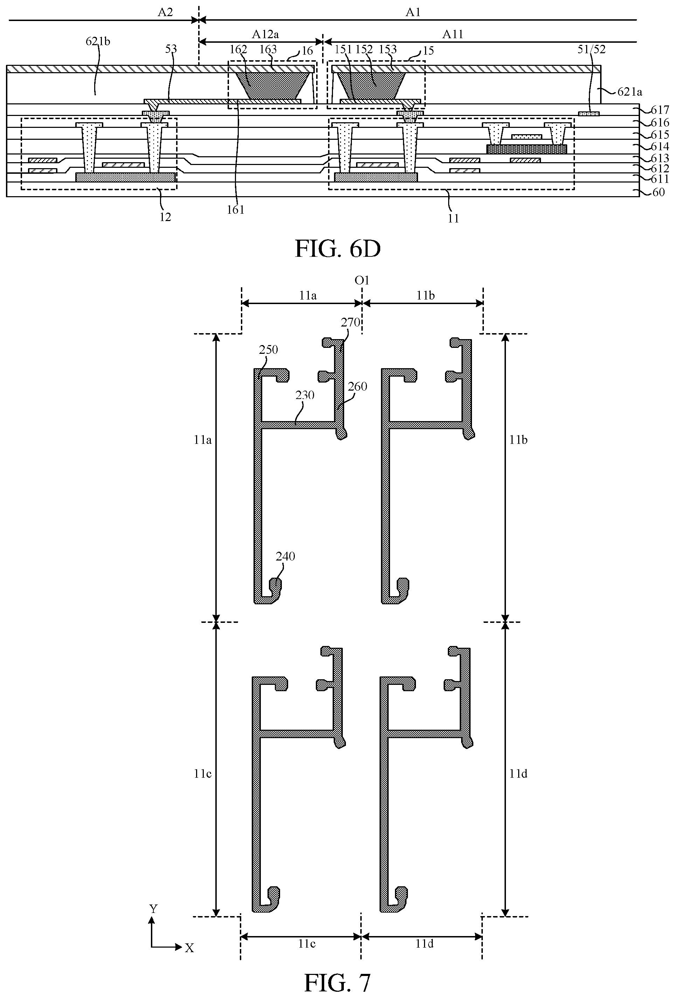

FIG. 6D is still another partial sectional schematic diagram of a display substrate according to at least one embodiment of the present disclosure. In some examples, as shown in FIG. 6D, the pixel defining layer may include a first pixel defining layer 621a located in the first display area A1 and a second pixel defining layer 621b located in the second display area A2. The first pixel defining layer 621a may also be referred to as a light shielding pixel defining layer. For example, it may be a black pixel defining layer. The first pixel defining layer 621a in the first light transmitting area and the second light transmitting area in the first display area A1 may be removed to ensure light transmittance of the light transmitting areas. The first pixel defining layer 621a may at least cover a first pixel circuit of the display island area, a metal wire with which the first pixel circuit is connected, and a peripheral portion of a light emitting region of the second light emitting element 16 of the second sub-area. **In** the present example, by providing a first pixel defining layer in the first display area, the metal film layer may be effectively shielded and diffraction may be reduced.

In some examples, as shown in FIG. 6D, the cathode layer of the first display area A1 may adopt a patterning design. The cathode layers of the first light transmitting area and the second light transmitting area in the first display area A1 may be removed to ensure light transmittance of the light transmitting areas. The cathodes 153 of the plurality of first light emitting elements 15 in the display island area of the first sub-area A11 may be of an interconnected integral structure. The cathode 153 of the first light emitting element 15 may be connected with the cathode 163 of the second light emitting element 16. An orthographic projection of the cathode layer in the first display area A1 on the base substrate 60 may cover an orthographic projection of the first pixel defining layer 621a on the base substrate 60. The present example may adopt a cathode layer with a patterning design to achieve light shielding effect, to effectively shield the metal film layer and reduce diffraction. Rest of description of the display substrate of the example may be referred to description of the aforementioned embodiments, which will not be described here in detail.

A structure of the display substrate will be described below through an example of a manufacturing process for the display substrate. A "patterning process" mentioned in the present disclosure includes photoresist coating, mask exposure, development, etching, photoresist stripping, etc., for a metal material, an inorganic material, or a transparent conductive material, and includes organic material coating, mask exposure, development, etc., for an organic material. Deposition may be any one or more of sputtering, evaporation, and chemical vapor deposition, coating may be any one or more of spray coating, spin coating, and inkjet printing, and etching may be any one or more of dry etching and wet etching, the present disclosure is not limited thereto. A "thin film" refers to a layer of thin film made of a certain material on a base substrate using deposition, coating, or other processes. **If** the "thin film" does not need to be processed through a patterning process in the entire manufacturing process, the "thin film" may also be called a "layer". **If** the "thin film" needs to be processed through the patterning process in the entire manufacturing process, the "thin film" is called a "thin film" before the patterning process is performed and is called a "layer" after the patterning process is performed. At least one "pattern" is contained in the "layer" which has been processed through the patterning process.

"A and B are provided in a same layer" or "A and B are of a same layer structure" in the present disclosure means that A and B are formed simultaneously through a same patterning process, or distances between surfaces of A and B close to a base substrate and the base substrate are substantially the same, or the surfaces of A and B close to the base substrate are in direct contact with a same film layer. A "thickness" of a film is a dimension of the film in a direction perpendicular to the display substrate. In an exemplary implementation of the present disclosure, "an orthographic projection of B being within a range of an orthographic projection of A" or "an orthographic projection of A containing an orthographic projection of B" means that a boundary of the orthographic projection of B falls within a range of a boundary of the orthographic projection of A, or the boundary of the orthographic projection of A is overlapped with the boundary of the orthographic projection of B. The "shape of A" in the present disclosure refers to the shape of an orthographic projection of A on the base substrate.

In some examples, a preparing process of the display substrate may include the following operations. The circuit structure layer of the display island area A111 of the first sub-area A11 of the first display area A1 is illustrated as an example, and the film layer structure is illustrated by taking a structure of a first transistor 21, a second transistor 22, a third transistor 23, a fourth transistor 24, a fifth transistor 25, a sixth transistor 26, a seventh transistor 27 and a storage capacitor of the first pixel circuit 11a in the display island area A111 as an example.

(1) A base substrate is provided. In some examples, the base substrate may be a rigid base or a flexible base. For example, the rigid base may be made of, but not limited to, one or more of glass and quartz. The flexible base substrate may be made of, but not limited to, one or more of polyethylene terephthalate, ethylene terephthalate, polyether ether ketone, polystyrene, polycarbonate, polyarylate, polyarylester, polyimide, polyvinyl chloride, polyethylene, and textile fibers. In some examples, the flexible base may include a first flexible material layer, a first inorganic material layer, a second flexible material layer and a second inorganic material layer which are stacked. The first flexible material layer and the second flexible material layer may be made of a material such as polyimide (PI), polyethylene terephthalate (PET), or a polymer soft film of which surface is treated, and materials of the first inorganic material layer and the second inorganic material layer may be silicon nitride (SiNy,y>0) or silicon oxide (SiOx,x>0), etc., which are used to improve resistance to water and oxygen of the base substrate.

(2) A first semiconductor layer is formed. In some examples, a first semiconductor thin film is deposited on the base substrate, and the first semiconductor thin film is patterned through a patterning process to form the first semiconductor layer provided on the base substrate. In some examples, a material of the first semiconductor layer may be amorphous silicon (a-Si), poly silicon (p-Si), hexathiophene or polythiophene, or other materials.

FIG. 7 is a schematic diagram of a first semiconductor layer of a display island area according to at least one embodiment of the present disclosure. In some examples, as shown in FIG. 7, the first semiconductor layer of the display island area may include active layers of a plurality of first type transistors of four first pixel circuits (including, for example, first pixel circuits 11a, 11b, 11c and 11d) (including, for example, an active layer 230 of a third transistor, an active layer 240 of a fourth transistor, an active layer 250 of a fifth transistor, an active layer 260 of a sixth transistor, and an active layer 270 of a seventh transistor of the first pixel circuit 11a).

In some examples, the active layers of the plurality of first type transistors of each first pixel circuit may be of an interconnected integral structure. Active layers of a plurality of first type transistors of different first pixel circuits may be independent of each other. Patterns of the first semiconductor layers of the four first pixel circuits may be arranged in a 2×2 array. A pattern of the first semiconductor layer of the four first pixel circuits may be substantially symmetrical with respect to a first center line O1. An extension direction of the first center line O1 may be parallel to the second direction Y.

In some examples, an active layer of each transistor may include a first region, a second region, and a channel region located between the first region and the second region. A material of the first semiconductor layer may include, for example, poly silicon. The channel region may not be doped with an impurity, and has characteristics of a semiconductor. The first region and the second region may be doped regions on both sides of the channel region, and are doped with impurities, and thus have conductivity. The impurities may be changed according to a type of a transistor. In some examples, a doped region of the active layer may be interpreted as a source or a drain of a transistor. A portion of the active layer between the transistors may be interpreted as a wiring doped with an impurity, and may be used for electrically connecting the transistors. The present embodiment is not limited thereto.

In some examples, the pattern of the first semiconductor layer of the first pixel circuit 11a is illustrated as an example. The active layer 240 of the fourth transistor of the first pixel circuit 11a may be located on a side of the active layer 230 of the third transistor in an opposite direction of the second direction Y, and the active layer 250 of the fifth transistor, the active layer 260 of the sixth transistor, and the active layer 270 of the seventh transistor may be located on a side of the active layer 230 of the third transistor in the second direction Y. The active layer 250 of the fifth transistor and the active layer 240 of the fourth transistor may be located on a side of the active layer 230 of the third transistor in an opposite direction of the first direction X, and the active layer 260 of the sixth transistor and the active layer 270 of the seventh transistor may be located on a side of the active layer 230 of the third transistor in the first direction X. The first region of the active layer 230 of the third transistor may simultaneously serve as the second region of the active layer 250 of the fifth transistor and the second region of the active layer 240 of the fourth transistor, the second region of the active layer 230 of the third transistor may simultaneously serve as the first region of the active layer 260 of the sixth transistor, and the second region of the active layer 260 of the sixth transistor may simultaneously serve as the second region of the active layer 270 of the seventh transistor.

In some examples, the active layer 230 of the third transistor may be substantially "I" shaped, the active layer 240 of the fourth transistor may be substantially U shaped, and the active layer 250 of the fifth transistor, the active layer 260 of the sixth transistor, and the active layer 270 of the seventh transistor may be substantially L shaped. The present embodiment is not limited thereto.

(3) A first conductive layer is formed. In some examples, a first insulation thin film and a first conductive thin film are deposited sequentially on the base substrate on which the aforementioned structures are formed, and the first conductive thin film is patterned through a patterning process to form a first insulating layer and a first conductive layer arranged on the first insulating layer. In some examples, the first conductive layer may also be referred to as a first gate metal layer and the first insulating layer may also be referred to as a first gate insulating layer.

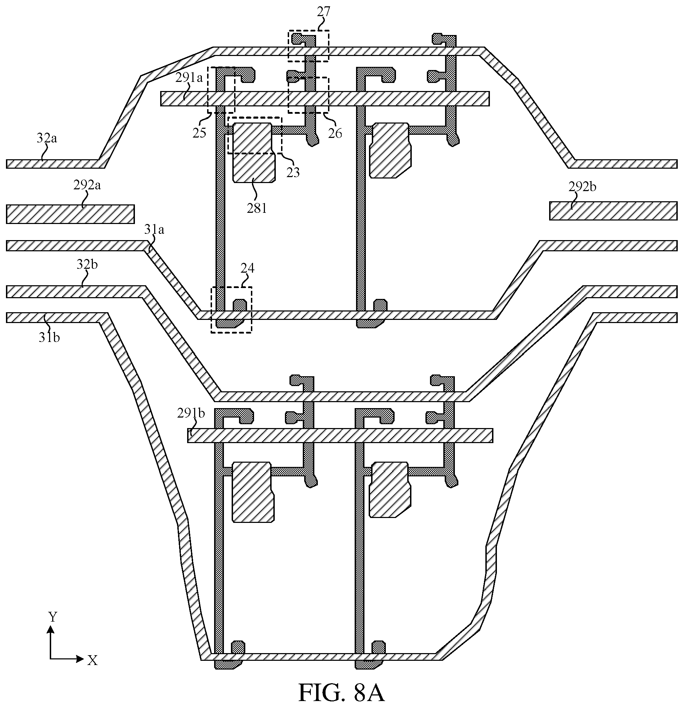

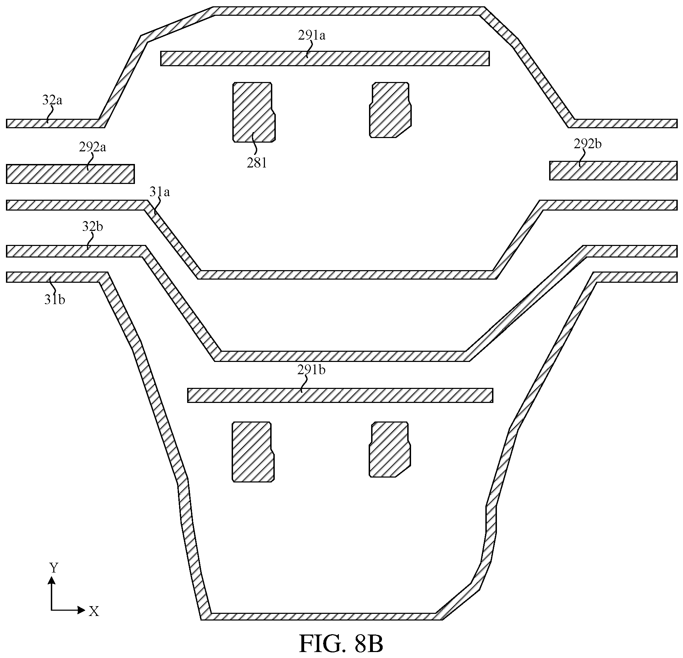

FIG. 8A is a schematic diagram of a display island area after a first conductive layer is formed according to at least one embodiment of the present disclosure. FIG. 8B is a schematic diagram of the first conductive layer in FIG. 8A.

In some examples, as shown in FIGS. 8A and 8B, the first conductive layer of the display island area may at least include first electrodes (e.g., first electrodes 281) of the storage capacitors of the four first pixel circuits, first scan lines 31a and 31b, second scan lines 32a and 32b, first light emitting control segments 291a and 291b, and second light emitting control segments 292a and 292b.

In some examples, in the display island area, the first scan line 31b, the second scan line 32b, the first scan line 31a, and the second scan line 32a may be arranged sequentially along the second direction Y. The first scan lines 31a and 31b and the second scan lines 32a and 32b may have a bend line shape extending substantially along the first direction X. The first scan line 31a may be bypassed from a side of the first electrodes of the storage capacitors of the first pixel circuits 11a and 11b in an opposite direction of the second direction Y, and the second scan line 32a may be bypassed from a side of the first electrodes of the storage capacitors of the first pixel circuits 11a and 11b in the second direction Y. The first scan line 31b may be bypassed from a side of the first electrodes of the storage capacitors of the first pixel circuits 11c and 11d in the opposite direction of the second direction Y, and the second scan line 32b may be bypassed from a side of the first electrodes of the storage capacitors of the first pixel circuits 11c and 11d in the second direction Y.

In some examples, an overlapping region of the first scan line 31a with the active layer of the fourth transistor 24 of the first pixel circuit 11a may serve as a gate of the fourth transistor 24 of the first pixel circuit 11a, and an overlapping region of the first scan line 31a with the active layer of the fourth transistor of the first pixel circuit 11b may serve as a gate of the fourth transistor of the first pixel circuit 11b. An overlapping region of the first scan line 31b with the active layer of the fourth transistor of the first pixel circuit 11c may serve as a gate of the fourth transistor of the first pixel circuit 11c, and an overlapping region of the first scan line 31b with the active layer of the fourth transistor of the first pixel circuit 11d may serve as a gate of the fourth transistor of the first pixel circuit 11d. For example, the fourth transistor of the first pixel circuit may be a dual-gate transistor.

In some examples, an overlapping region of the second scan line 32a with the active layer of the seventh transistor 27 of the first pixel circuit 11a may serve as a gate of the seventh transistor 27 of the first pixel circuit 11a, and an overlapping region of the second scan line 32a with the active layer of the seventh transistor of the first pixel circuit 11b may serve as a gate of the seventh transistor of the first pixel circuit 11b. An overlapping region of the second scan line 32b with the active layer of the seventh transistor of the first pixel circuit 11c may serve as a gate of the seventh transistor of the first pixel circuit 11c, and an overlapping region of the second scan line 32b with the active layer of the seventh transistor of the first pixel circuit 11d may serve as a gate of the seventh transistor of the first pixel circuit 11d.

In some examples, the first light emitting control segments 291a and 291b and the second light emitting control segments 292a and 292b may have a straight line shape extending substantially along the first direction X. The first light emitting control segment 291a may be located on a side of the first electrodes 281 of the storage capacitors of the first pixel circuits 11a and 11b in the second direction Y, and on a side of the second scan line 32a in the opposite direction of the second direction Y. The first light emitting control segment 291b may be located on a side of the first electrodes of the storage capacitors of the first pixel circuits 11c and 11d in the second direction Y, and on a side of the second scan line 32b in the opposite direction of the second direction Y. The second light emitting control segment 292a may be located on a side of the first pixel circuit 11a in the opposite direction of the first direction X, and the second light emitting control segment 292b may be located on a side of the first pixel circuit 11b in the first direction X. The second light emitting control segments 292a and 292b may be aligned in the first direction X.

In some examples, an overlapping region of the first light emitting control segment 291a with the active layer of the fifth transistor 25 of the first pixel circuit 11a may serve as a gate of the fifth transistor 25 of the first pixel circuit 11a, an overlapping region of the first light emitting control segment 291a with the active layer of the sixth transistor 26 of the first pixel circuit 11a may serve as a gate of the sixth transistor 26 of the first pixel circuit 11a, an overlapping region of the first light emitting control segment 291a with the active layer of the fifth transistor of the first pixel circuit 11b may serve as a gate of the fifth transistor of the first pixel circuit 11b, and an overlapping region of the first light emitting control segment 291a with the active layer of the sixth transistor of the first pixel circuit 11b may serve as a gate of the sixth transistor of the first pixel circuit 11b. An overlapping region of the first light emitting control segment 291b with the active layer of the fifth transistor of the first pixel circuit 11c may serve as a gate of the fifth transistor of the first pixel circuit 11c, an overlapping region of the first light emitting control segment 291b with the active layer of the sixth transistor of the first pixel circuit 11c may serve as a gate of the sixth transistor of the first pixel circuit 11c, an overlapping region of the first light emitting control segment 291b with the active layer of the fifth transistor of the first pixel circuit 11d may serve as a gate of the fifth transistor of the first pixel circuit 11d, and an overlapping region of the first light emitting control segment 291b with the active layer of the sixth transistor of the first pixel circuit 11d may serve as a gate of the sixth transistor of the first pixel circuit 11d.

In some examples, the first electrode 281 of the storage capacitor of the first pixel circuit 11a may have a substantially rectangular shape. The first electrode 281 of the storage capacitor of the first pixel circuit 11a may simultaneously serve as a gate of the third transistor 23.

(4) A second conductive layer is formed. In some examples, a second insulation thin film and a second conductive thin film are deposited sequentially on the base substrate on which the aforementioned structures are formed, and the second conductive thin film is patterned through a patterning process to form a second insulating layer and a second conductive layer provided on the second insulating layer. In some examples, the second conductive layer may also be referred to as a second gate metal layer and the second insulating layer may also be referred to as a second gate insulating layer.

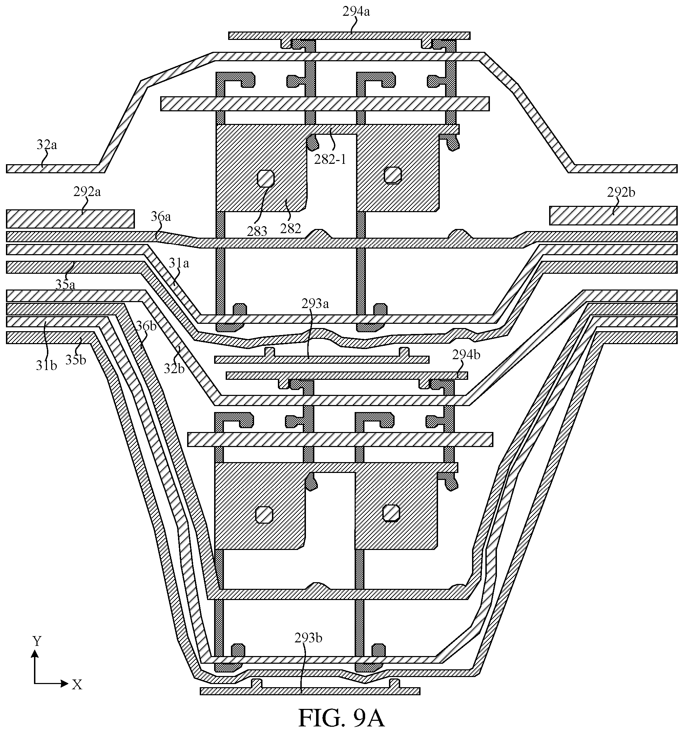

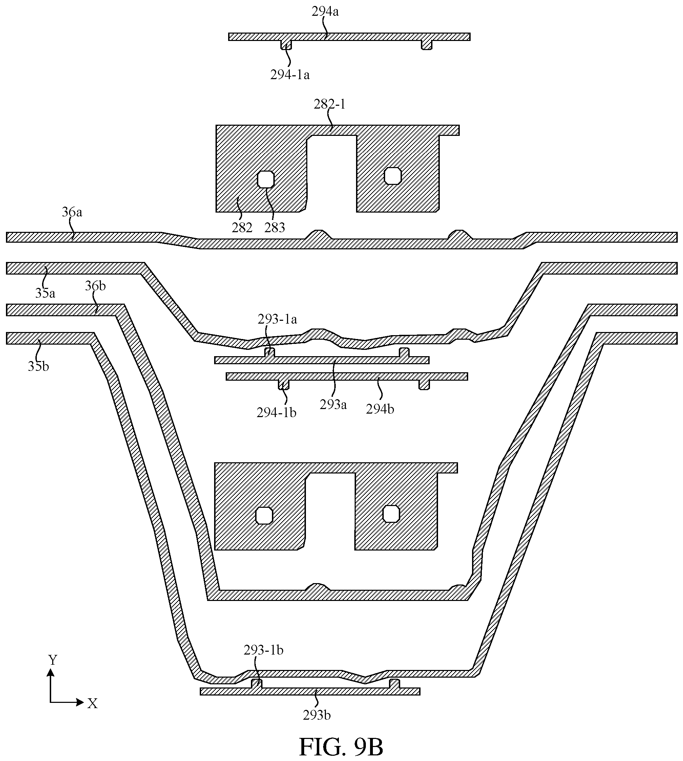

FIG. 9A is a schematic diagram of a display island area after a second conductive layer is formed according to at least one embodiment of the present disclosure. FIG. 9B is a schematic diagram of the second conductive layer in FIG. 9A.

In some examples, as shown in FIGS. 9A and 9B, the second conductive layer of the display island area may at least include first scan auxiliary lines 35a and 35b, second scan auxiliary lines 36a and 36b, second electrodes (e.g., second electrodes 282) of the storage capacitors of four first pixel circuits, first initial connection segments 293a and 293b, and second initial connection segments 294a and 294b.

In some examples, the second electrode 282 of the storage capacitor of the first pixel circuit 11a may have a substantially rectangular shape. For example, the rectangular shape may have rounded corners or chamfered corners. The second electrode 282 may have a hollowed area 283 which may have a substantially rectangular shape. For example, it may be a rounded rectangle. An orthographic projection of the hollowed area 283 on the base substrate may be located within a range of an orthographic projection of the first electrode 281 on the base substrate. The second electrodes of the storage capacitors of the remaining first pixel circuits are similar in shape, which will not be described here in detail.

In some examples, the second electrode 282 of the storage capacitor of the first pixel circuit 11a and the second electrode of the storage capacitor of the first pixel circuit 11b may be connected through an electrode plate connection block 282-1. The electrode plate connection block 282-1 may have a strip shape extending substantially along the first direction X. A length of the electrode plate connection block 282-1 along the second direction Y may be smaller than a length of the second electrode 282 along the second direction Y. The second electrode 282 of the storage capacitor of the first pixel circuit 11a, the second electrode of the storage capacitor of the first pixel circuit 11b, and the electrode plate connection block 282-1 may be of an interconnected integral structure. The second electrode of the storage capacitor of the first pixel circuit 11c and the second electrode of the storage capacitor of the first pixel circuit 11d may be connected through another electrode plate connection block. The second electrode of the storage capacitor of the first pixel circuit 11c, the second electrode of the storage capacitor of the first pixel circuit 11d, and the electrode plate connection block may be of an interconnected integral structure.

In some examples, the first scan auxiliary lines 35a and 35b may have a bend line shape extending substantially along the first direction X. An orthographic projection of the first scan auxiliary line 35a on the base substrate may be located between an orthographic projection of the first scan line 31a on the base substrate and an orthographic projection of the second scan line 32b on the base substrate. An orthographic projection of the first scan auxiliary line 35b on the base substrate may be located on a side of an orthographic projection of the first scan line 31b on the base substrate in the opposite direction of the second direction Y. The orthographic projections of the first scan auxiliary lines 35a and 35b on the base substrate may not be overlapped with an orthographic projection of the first semiconductor layer of the four first pixel circuits on the base substrate. The first scan auxiliary line 35a may be bypassed from a side of the second electrodes of the storage capacitors of the first pixel circuits 11a and 11b in the opposite direction of the second direction Y, and the first scan auxiliary line 35b may be bypassed from a side of the second electrodes of the storage capacitors of the first pixel circuits 11c and 11d in the opposite direction of the second direction Y.

In some examples, the second scan auxiliary lines 36a and 36b may have a bend line shape extending substantially along the first direction X. An orthographic projection of the second scan auxiliary line 36a on the base substrate may be located on a side of an orthographic projection of the first scan line 31a on the base substrate along the second direction Y. An orthographic projection of the second scan auxiliary line 36b on the base substrate may be located within a range of orthographic projections of the second scan line 32b and the first scan line 31b on the base substrate. The second scan auxiliary line 36a may be bypassed from a side of the second electrodes of the storage capacitors of the first pixel circuits 11a and 11b in the opposite direction of the second direction Y, and the second scan auxiliary line 36b may be bypassed from a side of the second electrodes of the storage capacitors of the first pixel circuits 11c and 11d in the opposite direction of the second direction Y.

In some examples, the first initial connection segments 293a and 293b may have a strip shape extending substantially along the first direction X. The first initial connection segment 293a may be located on a side of the first scan auxiliary line 35a in the opposite direction of the second direction Y. The first initial connection segment 293b may be located on a side of the first scan auxiliary line 35b in the opposite direction of the second direction Y.

In some examples, the first initial connection segment 293a may be provided with two first initial connection blocks 293-1a provided at intervals along the first direction X on a side close to the first scan auxiliary line 35a. The first initial connection segment 293a and the two first initial connection blocks 293-1a may be of an interconnected integral structure. The first initial connection segment 293b may be provided with two first initial connection blocks 293-1b provided at intervals along the first direction X on a side close to the first scan auxiliary line 35b. The first initial connection segment 293b and the two first initial connection blocks 293-1b may be of an interconnected integral structure.

In some examples, the second initial connection segments 294a and 294b may have a strip shape extending substantially along the first direction X. The second initial connection segment 294a may be located on a side of the second scan line 32a along the second direction Y. The second initial connection segment 294b may be located on a side of the first initial connection segment 293a in the opposite direction of the second direction Y.

In some examples, the second initial connection segment 294a may be provided with two second initial connection blocks 294-1a provided at intervals along the first direction X on a side close to the second scan line 32a. The second initial connection segment 294a and the two second initial connection blocks 294-1a may be of an interconnected integral structure. The second initial connection segment 294b may be provided with two second initial connection blocks 294-1b provided at intervals along the first direction X on a side close to the second scan line 32b. The second initial connection segment 294b and the two second initial connection blocks 294-1b may be of an interconnected integral structure.

(5) A second semiconductor layer is formed. In some examples, a third insulation thin film and a second semiconductor thin film are sequentially deposited on the base substrate on which the aforementioned patterns are formed, and the second semiconductor thin film is patterned through a patterning process to form a third insulating layer and a second semiconductor layer arranged on the third insulating layer. In some examples, a material of the second semiconductor layer may include Indium Gallium Zinc Oxide (IGZO). In some examples, the third insulating layer may also be referred to as a third gate insulating layer.

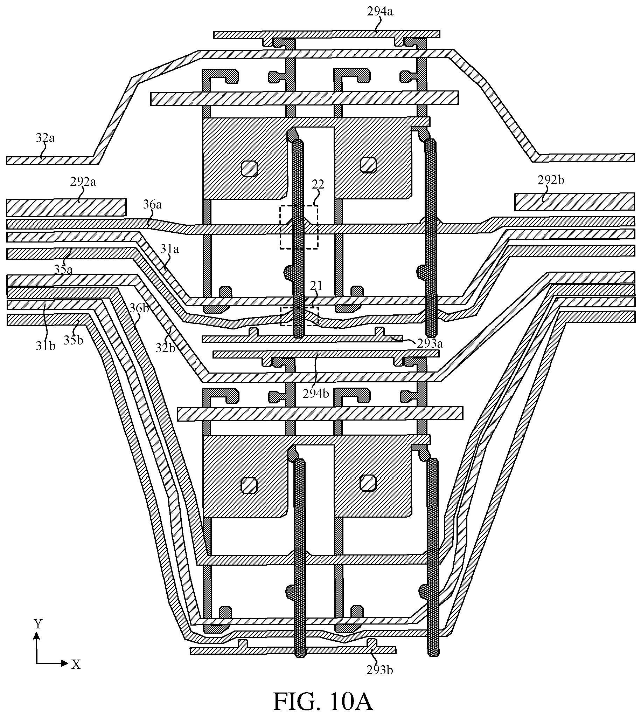

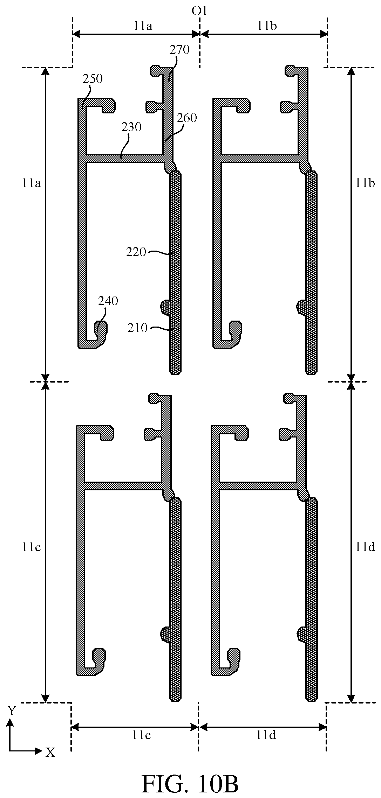

FIG. 10A is a schematic diagram of a display island area after a second semiconductor layer is formed according to at least one embodiment of the present disclosure. FIG. 10B is a schematic diagram of the first semiconductor layer and the second semiconductor layer in FIG. 10A.

In some examples, as shown in FIGS. 10A and 10B, the second semiconductor layer of the display island area may at least include active layers of a plurality of second type transistors of four first pixel circuits (including, for example, an active layer 210 of the first transistor 21, and an active layer 220 of the second transistor 22 of the first pixel circuit 11a).

In some examples, active layers of two second type transistors of each first pixel circuit may be of an interconnected integral structure. Active layers of second type transistors of different first pixel circuits may be independent of each other.

In some examples, taking a pattern of a second semiconductor layer of the first pixel circuit 11a as an example, the active layer 210 of the first transistor 21 and the active layer 220 of the second transistor 22 may be of an interconnected integral structure. A second region of the active layer 210 of the first transistor 21 may simultaneously serve as a second region of the active layer 220 of the second transistor 22. The integral structure of the active layer 210 of the first transistor 21 and the active layer 320 of the second transistor 22 may be located on a side of the active layer 230 of the third transistor in the opposite direction of the second direction Y, and on a side of the active layer 230 of the third transistor along the first direction X.

In some examples, the active layer 210 of the first transistor 21 and the active layer 220 of the second transistor 22 may have a substantially I shape. The present embodiment is not limited thereto.

In some examples, a pattern of the second semiconductor layer of the four first pixel circuits may be substantially symmetrical with respect to a first center line O1. The active layers of the transistors of the four first pixel circuits in the display island area of the present example may be substantially symmetrical with respect to the first center line O1, which may optimize the arrangement of the first pixel circuits and save occupied space.

(6) A third conductive layer is formed. In some examples, a fourth insulation thin film and a third conductive thin film are sequentially deposited on the base substrate on which the aforementioned patterns are formed, and the third conductive thin film is patterned through a patterning process to form a fourth insulating layer and a third conductive layer arranged on the fourth insulating layer. In some examples, the third conductive layer may also be referred to as a third gate metal layer and the fourth insulating layer may also be referred to as a fourth gate insulating layer.

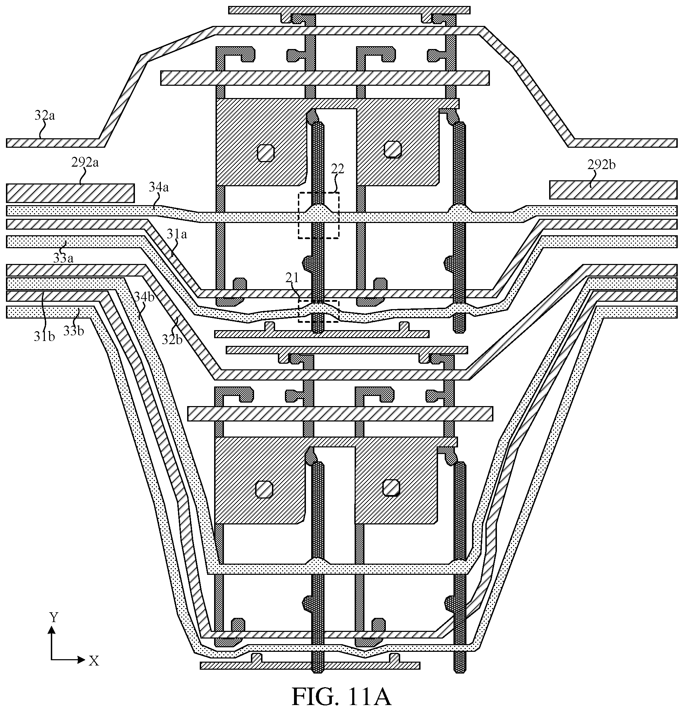

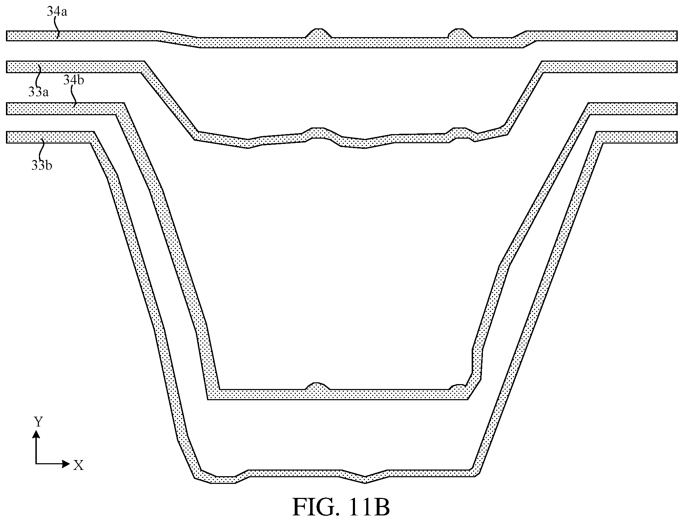

FIG. 11A is a schematic diagram of a display island area after a third conductive layer is formed according to at least one embodiment of the present disclosure. FIG. 11B is a schematic diagram of the third conductive layer in FIG. 11A.

In some examples, as shown in FIGS. 11A and 11B, the third conductive layer of the display island area may at least include third scan lines 33a and 33b, and fourth scan lines 34a and 34b. The third scan line 33b, the fourth scan line 34b, the third scan line 33a, and the fourth scan line 34b may be arranged sequentially along the second direction Y.

In some examples, the third scan lines 33a and 33b may have a bend line shape extending substantially along the first direction X. An orthographic projection of the third scan line 33a on the base substrate may be located between an orthographic projection of the first scan line 31a on the base substrate and an orthographic projection of the second scan line 32b on the base substrate. An orthographic projection of the third scan line 33a on the base substrate may be at least partially overlapped with an orthographic projection of the first scan auxiliary line 35a on the base substrate. For example, the orthographic projection of the third scan line 33a on the base substrate may cover the orthographic projection of the first scan auxiliary line 35a on the base substrate.

In some examples, an overlapping region of the third scan line 33a with the active layer 210 of the first transistor 21 of the first pixel circuit 11a may serve as a gate of the first transistor 21 of the first pixel circuit 11a, and an overlapping region of the third scan line 33a with the active layer of the first transistor of the first pixel circuit 11b may serve as a gate of the first transistor of the first pixel circuit 11b. An overlapping region of the first scan auxiliary line 35a with the active layer 210 of the first transistor 21 of the first pixel circuit 11a may serve as a bottom gate of the first transistor 21 of the first pixel circuit 11a, and an overlapping region of the first scan auxiliary line 35a with the active layer of the first transistor of the first pixel circuit 11b may serve as a bottom gate of the first transistor of the first pixel circuit 11b.

In some examples, an orthographic projection of the third scan line 33b on the base substrate may be located on a side of the first scan line 31b in the opposite direction of the second direction Y. The orthographic projection of the third scan line 33b on the base substrate may be at least partially overlapped with an orthographic projection of the first scan auxiliary line 35b on the base substrate. For example, the orthographic projection of the third scan line 33b on the base substrate may cover the orthographic projection of the first scan auxiliary line 35b on the base substrate

In some examples, an overlapping region of the third scan line 33b with the active layer of the first transistor of the first pixel circuit 11c may serve as a gate of the first transistor of the first pixel circuit 11c, and an overlapping region of the third scan line 33b with the active layer of the first transistor of the first pixel circuit 11d may serve as a gate of the first transistor of the first pixel circuit 11d. An overlapping region of the first scan auxiliary line 35b with the active layer of the first transistor of the first pixel circuit 11c may serve as a bottom gate of the first transistor of the first pixel circuit 11c, and an overlapping region of the first scan auxiliary line 35b with the active layer of the first transistor of the first pixel circuit 11d may serve as a bottom gate of the first transistor of the first pixel circuit 11d.

In some examples, the fourth scan lines 34a and 34b may have a bend line shape extending substantially along the first direction X. An orthographic projection of the fourth scan line 34a on the base substrate may be located on a side of an orthographic projection of the first scan line 31a on the base substrate along the second direction Y. An orthographic projection of the fourth scan line 34b on the base substrate may be located between an orthographic projection of the second scan line 32b on the base substrate and an orthographic projection of the first scan line 31b on the base substrate.

In some examples, the orthographic projection of the fourth scan line 34a on the base substrate may be at least partially overlapped with an orthographic projection of the second scan auxiliary line 36a on the base substrate. For example, the orthographic projection of the fourth scan line 34a on the base substrate may cover the orthographic projection of the second scan auxiliary line 36a on the base substrate. The orthographic projection of the fourth scan line 34b on the base substrate may be at least partially overlapped with the orthographic projection of the second scan auxiliary line 36b on the base substrate. For example, the orthographic projection of the fourth scan line 34b on the base substrate may cover the orthographic projection of the second scan auxiliary line 36b on the base substrate.

In some examples, an overlapping region of the fourth scan line 34a with the active layer 220 of the second transistor 22 of the first pixel circuit 11a may serve as a gate of the second transistor 22 of the first pixel circuit 11a, and an overlapping region of the active layer of the second transistor of the first pixel circuit 11b may serve as a gate of the second transistor of the first pixel circuit 11b. An overlapping region of the second scan auxiliary line 36a with the active layer 220 of the second transistor 22 of the first pixel circuit 11a may serve as a bottom gate of the second transistor 22 of the first pixel circuit 11a, and an overlapping region of the active layer of the second transistor of the first pixel circuit 11b may serve as a bottom gate of the second transistor of the first pixel circuit 11b.

In some examples, an overlapping region of the fourth scan line 34b with the active layer of the second transistor of the first pixel circuit 11c may serve as a gate of the second transistor of the first pixel circuit 11c, and an overlapping region of the fourth scan line 34b with the active layer of the second transistor of the first pixel circuit 11d may serve as a gate of the second transistor of the first pixel circuit 11d. An overlapping region of the second scan auxiliary line 36b with the active layer of the second transistor of the first pixel circuit 11c may serve as a bottom gate of the second transistor 22 of the first pixel circuit 11c, and an overlapping region of the second scan auxiliary line 36b with the active layer of the second transistor of the first pixel circuit 11d may serve as a bottom gate of the second transistor of the first pixel circuit 11d.

(7) A fifth insulating layer is formed. In some examples, a fifth insulation thin film is deposited on the base substrate on which the aforementioned patterns are formed, and the fifth insulation thin film is patterned through a patterning process to form a fifth insulating layer. In some examples, the fifth insulating layer may also be referred to as a passivation layer. In some other examples, the fifth insulating layer may employ an organic insulating layer. The present embodiment is not limited thereto.

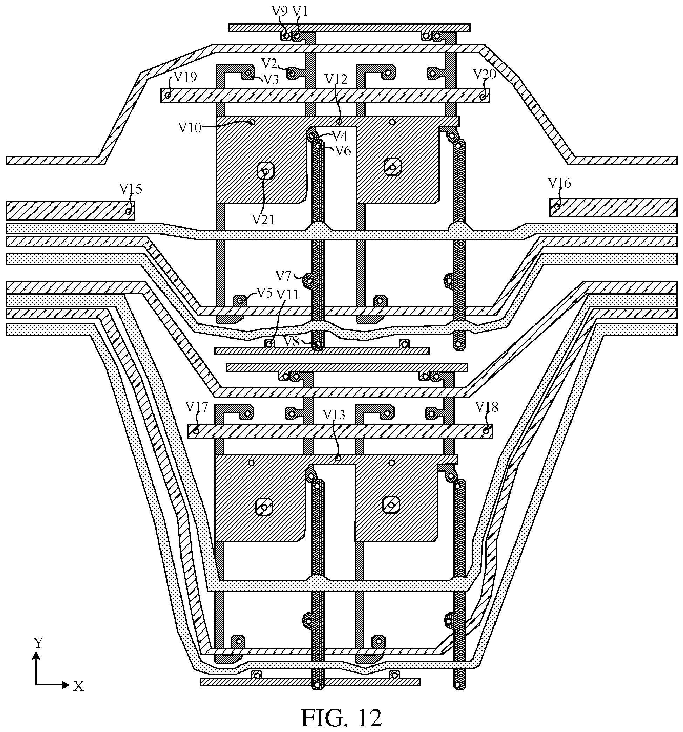

FIG. 12 is a schematic diagram of a display island area after a fifth insulating layer is formed according to at least one embodiment of the present disclosure. In some examples, as shown in FIG. 12, the fifth insulating layer of the display island area may be provided with a plurality of vias, which may include, for example, a first via V1 to a fifth via V5, a sixth via V6 to an eighth via V8, a ninth via V9 to a thirteenth via V13, and a fifteenth via V15 to a twenty-first via V21.

In some examples, the fifth insulating layer, the fourth insulating layer, the third insulating layer, the second insulating layer, and the first insulating layer within the first via V1 to the fifth via V5 may be removed, exposing a portion of a surface of the first semiconductor layer. The fifth insulating layer and the fourth insulating layer within the sixth via V6 to the eighth via V8 may be removed, exposing a portion of a surface of the second semiconductor layer. The fifth insulating layer, the fourth insulating layer and the third insulating layer within the ninth via V9 to the thirteenth via V13 may be removed, exposing a portion of a surface of the second conductive layer. The fifth insulating layer, the fourth insulating layer, the third insulating layer and the second insulating layer within the fifteenth via V15 to the twenty-first via V21 may be removed, exposing a portion of a surface of the first conductive layer.

(8) A fourth conductive layer is formed. In some examples, a fourth conductive thin film is deposited on the base substrate on which the aforementioned patterns are formed, and the fourth insulation thin film is patterned through a patterning process to form a fourth conductive layer on the fifth insulating layer. In some examples, the fourth conductive layer may also be referred to as a first source-drain metal layer.

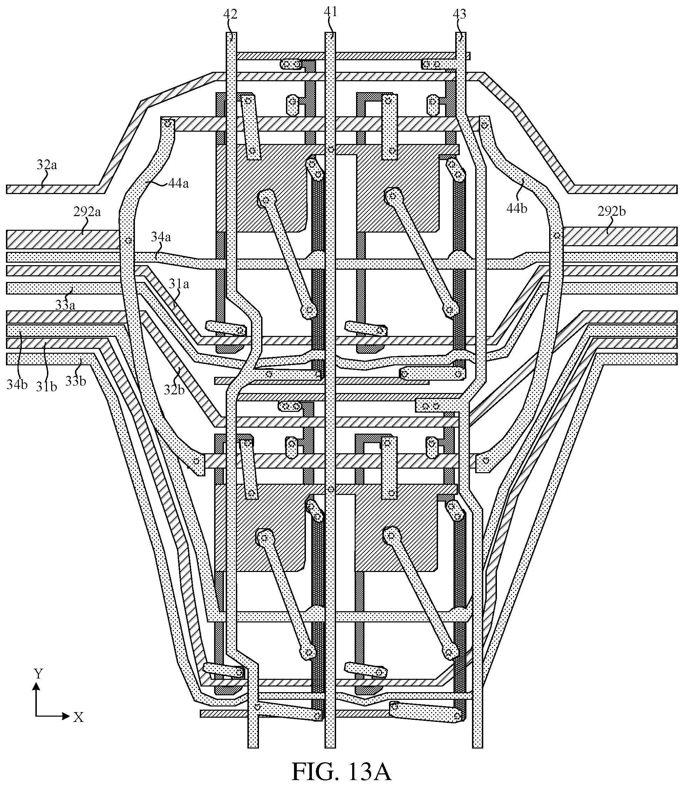

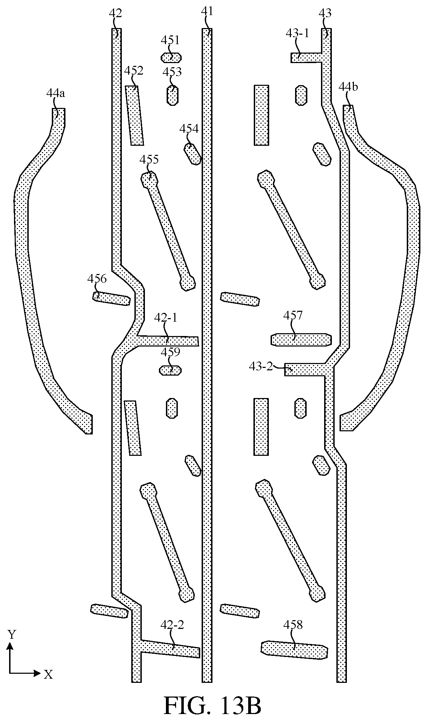

FIG. 13A is a schematic diagram of a display island area after a fourth conductive layer is formed according to at least one embodiment of the present disclosure. FIG. 13B is a schematic diagram of a fourth conductive layer in FIG. 13A.

In some examples, as shown in FIGS. 13A and 13B, the fourth conductive layer of the display island area may at least include a first power supply line 41, a first initial signal line 42, a second initial signal line 43, third light emitting control segments 44a and 44b, and a plurality of connection electrodes (e.g., a first connection electrode 451 to a ninth connection electrode 459).

In some examples, the first power supply line 41 may have a straight line shape extending substantially along the second direction Y. The first power supply line 41 may be located between the first pixel circuits 11a and 11b and between the first pixel circuits 11c and 11d. The first power supply line 41 may be connected with the electrode plate connection block 282-1 through the twelfth via V12 to achieve connection with the second electrodes of the storage capacitors of the first pixel circuits 11a and 11b, and the first power supply line 41 may be connected with the other electrode plate connection block through the thirteenth via V13 to achieve connection with the second electrodes of the storage capacitors of the first pixel circuits 11c and 11d. In the present example, the four first pixel circuits of the display island area may be connected with a same first power supply line 41, which may reduce the wire arrangement. The first power supply line 41 may achieve transmission of a first voltage signal along the second direction Y, and the second electrode of the storage capacitor of the first pixel circuit may achieve transmission of the first voltage signal along the first direction X, thereby forming a mesh structure for transmitting the first voltage signal within the display island area, which is conducive to the uniformity of the transmission of the first voltage signal.

In some examples, the first initial signal line 42 may have a bend line shape extending substantially along the second direction Y. The first initial signal line 42 may be located on a side of the first power supply line 41 in the opposite direction of the first direction X. The first initial signal line 42 may be provided with a first initial bump 42-1 and a second initial bump 42-2 on a side close to the first power supply line 41. The first initial bump 42-1 and the second initial bump 42-2 may have a strip shape extending substantially along the first direction X. The first initial bump 42-1, the second initial bump 42-2, and the first initial signal line 42 may be of an interconnected integral structure.

In some examples, the first initial bump 42-1 may be connected with the first initial connection block 293-1a through the eleventh via V11 to achieve electrical connection with the first initial connection segment 293a, and may be connected with the first region of the active layer of the first transistor of the first pixel circuit 11a through the eighth via V8. The second initial bump 42-2 may be electrically connected with the first initial connection segment 293b and the first region of the active layer of the first transistor of the first pixel circuit 11c. The seventh connection electrode 457 and the eighth connection electrode 458 may have a strip shape extending substantially along the first direction X. The seventh connection electrode 457 may be electrically connected with the first initial connection segment 293a and the first region of the active layer of the first transistor of the first pixel circuit 11b. The eighth connection electrode 458 may be electrically connected with the first initial connection segment 293b and with the first region of the active layer of the first transistor of the first pixel circuit 11d. In the present example, the four first pixel circuits of the display island area may be connected with a same first initial signal line 42, which may reduce wire arrangement. The first initial signal line 42 may achieve transmission of a first initial signal line along the second direction Y, and the first initial connection segments 293a and 293b may achieve transmission of the first initial signal along the first direction X, thereby forming a mesh structure for transmitting the first initial signal within the display island area, which is conducive to the uniformity of the transmission of the first initial signal.

In some examples, the second initial signal line 43 may have a bend line shape extending substantially along the second direction Y. The second initial signal line 43 may be located on a side of the first power supply line 41 along the first direction X. The second initial signal line 43 may be provided with a third initial bump 43-1 and a fourth initial bump 43-2 on a side close to the first power supply line 41. The third initial bumps 43-1 and the fourth initial bumps 43-2 may have a strip shape extending substantially along the first direction X. The third initial bump 43-1, the fourth initial bump 44-2, and the second initial signal line 43 may be of an interconnected integral structure.

In some examples, the third initial bump 43-1 may be connected with the second initial connection block 294-1a to achieve electrical connection with the second initial connection segment 294a, and may be connected with the first region of the active layer of the seventh transistor of the first pixel circuit 11b. The fourth initial bump 43-2 may be electrically connected with the second initial connection segment 294b and the first region of the active layer of the seventh transistor of the first pixel circuit 11d. The first connection electrode 451 and the ninth connection electrode 459 may have a strip shape extending substantially along the first direction X. The first connection electrode 451 may be connected with a second initial connection block 294-1a through the ninth via V9 to achieve electrical connection with the second initial connection segment 294a, and may be connected with the first region of the active layer of the seventh transistor of the first pixel circuit 11a through the first via V1. The ninth connection electrode 459 may be electrically connected with the second initial connection segment 294b and the first region of the active layer of the seventh transistor of the first pixel circuit 11c. In the present example, the four first pixel circuits of the display island area may be connected with a same second initial signal line 43, which may reduce wire arrangement. The second initial signal line 43 may achieve transmission of a second initial signal line along the second direction Y, and the second initial connection segments 294a and 294b may achieve transmission of the second initial signal along the first direction X, thereby forming a mesh structure for transmitting the second initial signal within the display island area, which is conducive to the uniformity of the transmission of the second initial signal.

In some examples, the third light emitting control segments 44a and 44b may have a curve shape extending substantially along the second direction Y. The third light emitting control segment 44a may be located on a side of the first initial signal line 42 in the opposite direction of the first direction X, and the third light emitting control segment 44b may be located on a side of the second initial signal line 43 along the first direction X.

In some examples, the third light emitting control segment 44a may be bent along the opposite direction of the first direction X, and the third light emitting control segment 44b may be bent along the first direction X. The third light emitting control segment 44a may be connected with one end of the first light emitting control segment 291a through the nineteenth via V19, the third light emitting control segment 44a may be connected with the second light emitting control segment 292a through the fifteenth via V15, and the third light emitting control segment 44a may be connected with one end of the first light emitting control segment 291b through the seventeenth via V17. The third light emitting control segment 44b may be connected with the other end of the first light emitting control segment 291a through the twentieth via V20, the third light emitting control segment 44b may be connected with the second light emitting control segment 292b through the sixteenth via V16, and the third light emitting control segment 44b may be connected with the other end of the first light emitting control segment 291b through the eighteenth via V18. The four first pixel circuits of the display island area of the present example may share a light emitting control line. The light emitting control line may be divided into a first light emitting control segment, a second light emitting control segment and a third light emitting control segment. Two first light emitting control segments may be connected with the four first pixel circuits respectively, and two third light emitting control segments may achieve electrical connection of the first light emitting control segment and the second light emitting control segment. The arrangement of the light emitting control line in the present example may avoid the intersection of signals wires and is conducive to the wiring design of the display island area.

In some examples, the second connection electrode 452 may have a strip ship extending substantially along the second direction Y. The second connection electrode 452 may be connected with the first region of the active layer of the fifth transistor of the first pixel circuit 11a through the third via V3, and may be connected with the second electrode 282 of the storage capacitor of the first pixel circuit 11a through the tenth via V10.

In some examples, the third connection electrode 453 may have a substantially rectangular shape. The third connection electrode 453 may be connected with the second region of the active layer of the sixth transistor of the first pixel circuit 11a through the second via V2. The third connection electrode 453 may be configured to be connected with an anode connection electrode to be formed subsequently.

In some examples, the fourth connection electrode 454 may have a substantially rectangular shape. The fourth connection electrode 454 may be connected with the first region of the active layer of the sixth transistor of the first pixel circuit 11a through the fourth via V4, and may be connected with the first region of the active layer of the second transistor of the first pixel circuit 11a through the sixth via V6. The fourth connection electrode 454 may achieve connection with the second region of the active layer of the third transistor, the first region of the active layer of the second transistor, and the first region of the active layer of the sixth transistor of the first pixel circuit 11a, and may serve as a third node of the first pixel circuit 11a.

In some examples, the fifth connection electrode 455 may have a strip shape extending substantially along a third direction, which may intersect both the first direction X and the second direction Y. The fifth connection electrode 455 may be connected with a gate of the third transistor of the first pixel circuit 11a through the twenty-first via V21, and may be connected with the first region of the active layer of the second transistor through the seventh via V7. The gate of the third transistor, a first electrode plate of the storage capacitor, a first electrode of the second transistor, and a first electrode of the first transistor of the first pixel circuit 11a may be connected through the fifth connection electrode 455, and the fifth connection electrode 455 may serve as a first node of the first pixel circuit 11a.

In some examples, the sixth connection electrode 456 may have a strip shape extending substantially along the first direction X. The sixth connection electrode 456 may be connected with the first region of the active layer of the fourth transistor of the first pixel circuit 11a through the fifth via V5. The sixth connection electrode 456 may be configured to be connected with a data line 50a to be formed subsequently.

(9) A sixth insulating layer is formed. In some examples, a sixth insulation thin film is coated on the base substrate on which the aforementioned patterns are formed, and the sixth insulation thin film is patterned through a patterning process to form a sixth insulating layer. In some examples, the sixth insulating layer may also be referred to as a planarization layer.

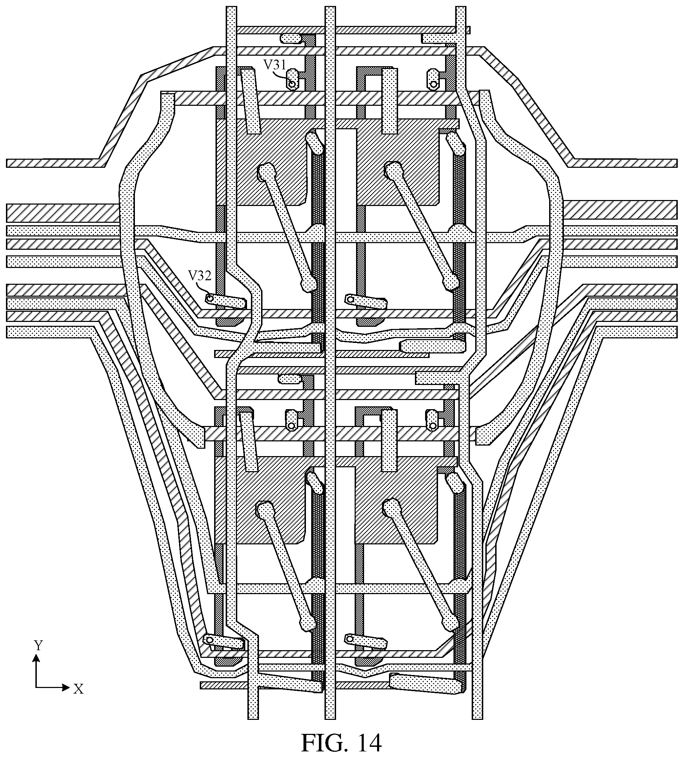

FIG. 14 is a schematic diagram of a display island area after a sixth insulating layer is formed according to at least one embodiment of the present disclosure. In some examples, as shown in FIG. 14, the sixth insulating layer of the display island area may be provided with a plurality of vias, which may include, for example, a thirty-first via V31 and a thirty-second via V32. The sixth insulating layer within the thirty-first via V31 and the thirty-second via V32 may be removed, exposing a surface of the fourth conductive layer.

(10) A fifth conductive layer is formed. In some examples, a fifth conductive thin film is deposited on the base on which the aforementioned patterns are formed, and the fifth conductive thin film is patterned through a patterning process to form a fifth conductive layer on the sixth insulating layer. In some examples, the fifth conductive layer may also be referred to as a second source-drain metal layer.

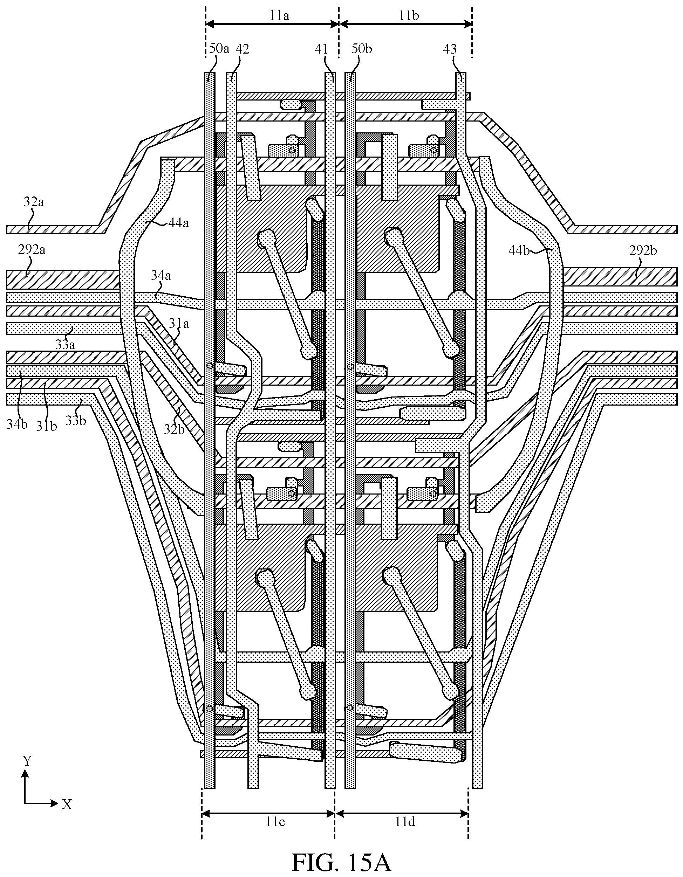

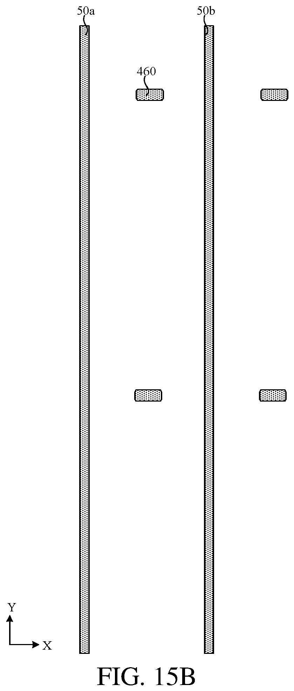

FIG. 15A is a schematic diagram of a display island area after a fifth conductive layer is formed according to at least one embodiment of the present disclosure. FIG. 15B is a schematic diagram of the fifth conductive layer in FIG. 15A.

In some examples, as shown in FIGS. 15A and 15B, the fifth conductive layer of the display island area may at least include two data lines 50a and 50b, and four anode connection electrodes (e.g., an anode connection electrode 460).

In some examples, the data lines 50a and 50b may have a straight line shape extending substantially along the second direction Y. An orthographic projection of the data line 50a on the base substrate may be located on a side of the first initial signal line 42 away from the first power supply line 41. The data line 50a may be connected with the sixth connection electrode 456 through the thirty-second via V32 to achieve connection with the fourth transistor of the first pixel circuit 11a. The data line 50a may be connected with the fourth transistor of the first pixel circuit 11c. An orthographic projection of the data line 50b on the base substrate may be located on a side of the first power supply line 41 close to the second initial signal line 43. The data line 50b may be connected with the fourth transistors of the first pixel circuits 11b and 11d. In some examples, the first pixel circuits, with which first light emitting elements that emit red light and blue light respectively are connected, may share a data line, which may save a quantity of wires in the display island area.

In some examples, the anode connection electrode 460 may be connected with the third connection electrode 453 through the thirty-first via V31 to achieve connection with the sixth transistor of the first pixel circuit 11a. The anode connection electrode 460 may be configured to be connected with an anode of the first light emitting element.

(11) A seventh insulating layer is formed. In some examples, a seventh insulation thin film is coated on the base on which the aforementioned patterns are formed, and the seventh insulation thin film is patterned through a patterning process to form a seventh insulating layer. In some examples, the seventh insulating layer may also be referred to as a planarization layer.

In some examples, a plurality of first island area connection lines and first signal lines connected therewith may be of an interconnected integral structure. For example, in the first direction X, the first scan lines 31a of adjacent display island areas may be of an interconnected integrated structure, the first scan lines 31b of adjacent display island areas may be of an interconnected integral structure, the second scan lines 32a of adjacent display island areas may be of an interconnected integral structure, the second scan lines 32b of adjacent display island areas may be of an interconnected integral structure, the second light emission control segments 292a and 292b of adjacent display island areas may be of an interconnected integral structure, the third scan lines 33a of adjacent display island areas may be of an interconnected integral structure, the third scan lines 33b of adjacent display island areas may be of an interconnected integral structure, the fourth scan lines 34a of adjacent display island areas may be of an interconnected integral structure, the fourth scan lines 34b of adjacent display island areas may be of an interconnected integral structure, the first scan auxiliary lines 35a of adjacent display island areas may be of an interconnected integral structure, the first scan auxiliary lines 35b of adjacent display island areas may be of an interconnected integral structure, the second scan auxiliary lines 36a of adjacent display island areas may be of an interconnected integral structure, and the second scan auxiliary lines 36b of adjacent display island areas may be of an interconnected integral structure. However, the present embodiment is not limited thereto. **In** some other examples, the first signal lines (e.g., lateral wires transmitting a same signal) of adjacent display island areas in the first direction X may be connected through a first island area connection line located in the fourth conductive layer or the fifth conductive layer.

In some examples, a plurality of second island area connection lines and second signal lines connected therewith may be of an interconnected integral structure. For example, the data lines of adjacent display island areas in the second direction Y may be of an interconnected integral structure, the first power supply lines of adjacent display island areas may be of an interconnected integral structure, the first initial signal lines of adjacent display island areas may be of an interconnected integral structure, and the second initial signal lines of adjacent display island areas may be of an interconnected integral structure. However, the present embodiment is not limited thereto. **In** some other examples, the second signal lines (e.g., longitudinal wires transmitting a same signal) of adjacent display island areas in the second direction Y may be connected through a second island area connection line located on different conductive layers. For example, a second signal line located on the fourth conductive layer (including, for example, a first power supply line, a first initial signal line, and a second initial signal line) may be connected with a second island area connection line located on the fifth conductive layer.

So far, the preparation of a circuit structure layer of the display substrate is completed. The circuit structure layer of the display island area may include a plurality of first pixel circuits, and the circuit structure layer of the second sub-area may include a first insulating layer, a second insulating layer, a third insulating layer, a fourth insulating layer, a fifth insulating layer, a sixth insulating layer, and a seventh insulating layer which are stacked on the base substrate. The circuit structure layer of the second display area may include a plurality of second pixel circuits and a plurality of third pixel drive circuits.

Subsequently, a conductive connection layer, a light emitting structure layer and a encapsulation structure layer may be prepared in sequence. The conductive connection layer may include a plurality of conductive connection lines. The conductive connection layer may be made of a transparent conductive material. The light emitting structure layer may include a plurality of first light emitting elements located in the display island area, a plurality of second light emitting elements located in the second sub-area, and a plurality of third light emitting elements located in the second display area. For example, the light emitting structure layer may include an anode layer, a pixel defining layer, an organic light emitting layer, and a cathode layer.

In some examples, the first conductive layer, the second conductive layer, the third conductive layer, the fourth conductive layer, and the fifth conductive layer may be made of a metal material, such as, any one or more of silver (Ag), copper (Cu), aluminum (Al), and molybdenum (Mo), or an alloy material of the above metals, such as, an aluminum-neodymium alloy (AlNd), or a molybdenum-niobium alloy (MoNb), which may be in a single layer structure, or a multi-layer composite structure, such as, Mo/Cu/Mo, etc. The first insulating layer, the second insulating layer, the third insulating layer, the fourth insulating layer, and the fifth insulating layer may be made of any one or more of Silicon Oxide ($SiO_x$, x>0), Silicon Nitride ($SiN_y$, y>0), and Silicon OxyNitride (SiON), and may be a single layer, a multi-layer, or a composite layer. The sixth insulating layer and the seventh insulating layer may be made of an organic material, such as polyimide, acrylic, or polyethylene terephthalate. The pixel defining layer may be made of an organic material, such as polyimide, acrylic, or polyethylene terephthalate. However, the present embodiment is not limited thereto.

A structure and a preparation process of the display substrate of the embodiment are merely illustrative. In some examples, a corresponding structure may be changed and a patterning process may be added or reduced according to actual needs. The manufacturing process of the exemplary embodiment may be implemented using an existing mature manufacturing device, and may be compatible well with an existing manufacturing process, simple in process implementation, easy to implement, high in a production efficiency, low in a production cost, and high in yield.

In some examples, structures of the second pixel circuit and the third pixel circuit may be substantially the same as a structure of the first pixel circuit in the second display area. The light emitting areas of the third light emitting element and the second light emitting element emitting light of a same color may be substantially the same. Light emitting areas of the second light emitting elements emitting light of a same color as light color emitted from the first light emitting elements may be larger than light emitting areas of the first light emitting elements. An arrangement mode of the second light emitting elements in the second sub-area may be substantially the same as an arrangement mode of the third light emitting elements in the second display area. The arrangement of the present example may improve the display uniformity at the junction position of the first display area and the second display area.

The display substrate provided by the present example divides the first display area into a first sub-area and a second sub-area, the first sub-area adopts a first pixel circuit built-in design, and the second sub-area adopts a second pixel circuit built-out design, which may achieve an optimal combination of light transmittance and size of the first display area, thereby improving the performance and user experience of the display substrate. For example, the design of the present example may meet the requirement for light transmittance of the first display area, which is a strip-shaped area along the first direction.

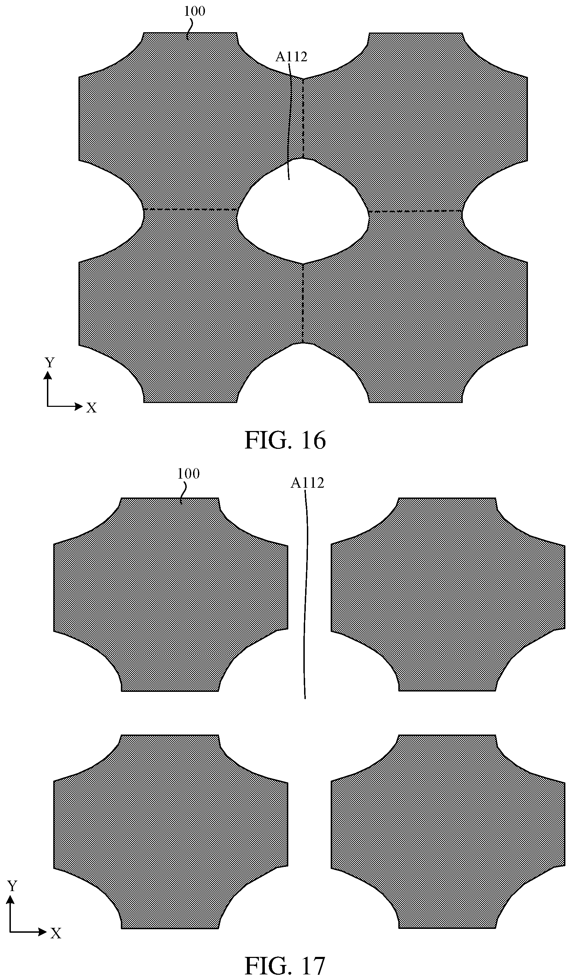

FIG. 16 is a partial schematic diagram of a light shielding layer of a first sub-area according to at least one embodiment of the present disclosure. In some examples, as shown in FIG. 16, the display substrate may include a light shielding layer (such as Bottom Shielding Metal (BSM)) provided on the base substrate. The light shielding layer may be located on a side of the circuit structure layer close to the base substrate. For example, the light shielding layer may be located on a side of the first semiconductor layer close to the base substrate, and an inorganic insulating layer may be provided between the first semiconductor layer and the light shielding layer. The light shielding layer may include a plurality of first light shielding blocks 100 located in the first sub-area. The plurality of first light shielding blocks 100 of the first sub-area may be of an interconnected integral structure. The light shielding layer in the first sub-area may form a continuous pattern.

In some examples, the first island area connection line and the second island area connection line with which the first pixel circuit of the display island area is connected may be made of a metal material. An orthographic projection of a single first light shielding block 100 of the first sub-area on the base substrate may cover the four first pixel circuits within a display island area and metal wires with which the four first pixel circuits are connected. An outline of the first light shielding block 100 may be substantially the same as an edge shape of the display island area. Four adjacent first light shielding blocks 100 may surround a first light transmitting area A112.

In some examples, an edge of the first light shielding block 100 close to the first light transmitting area A112 may be an arc-shaped edge such that the first light transmitting area A112 has an arc-shaped edge. For example, the arc-shaped edge of the first light shielding block 100 may be recessed toward the display island area to increase an area of the first light transmitting area A112. A plurality of first light transmitting areas A112 of the first sub-area may be independently provided, and adjacent first light transmitting areas A112 may be separated by the first light-shielding block 100.

In some examples, the edge of the first light transmitting area A112 may be formed by connecting a plurality of consecutive arc-shaped line segments. For example, the first light transmitting area A112 may be substantially circular or oval. The first light transmitting area A112 does not have a right-angled edge, so that the light diffraction effect may be reduced. In some examples, at least a portion of the edge of the first light transmitting area A112 may have a wave-like, bend line, or zigzag shape. The present embodiment is not limited to the shape of the edge of the first light transmitting area A112. For example, an edge shape of the first light transmitting area may be determined according to a peripheral edge of the metal wires in the display island area, or determined according to a peripheral edge of the light shielding layer in the display island area.

In the present example, by providing the light shielding layer, and making the outline of the first light shielding block of the light shielding layer substantially the same as the edge shape of the wires, it may help increase the area of the first light transmitting area and prevent diffraction.

FIG. 17 is another partial schematic diagram of a light shielding layer of a first sub-area according to at least one embodiment of the present disclosure. In some examples, as shown in FIG. 17, the light shielding layer of the display substrate may include a plurality of first light shielding blocks 100 provided independently in the first sub-area. The light shielding layer in the first sub-area may form a discontinuous pattern.

In some examples, the first signal line and the second signal line connected with the first pixel circuit of the display island area may be made of a metal material, and the first island area connection line and the second island area connection line may be made of a transparent conductive material. An orthographic projection of a single first light shielding block 100 on the base substrate may cover the four first pixel circuits within a display island area and metal wires with which the four first pixel circuits are connected. An orthographic projection of the light shielding layer on the base substrate may be partially overlapped with orthographic projections of the plurality of first island area connection lines and the plurality of second island area connection lines on the base substrate.

The first light transmitting areas between the display island areas of the first sub-areas of the present example may be interconnected, thereby facilitating the increase of the light transmittance of the first sub-areas. Rest of description of the light shielding layer of the present example may be referred to description of the aforementioned embodiments, which will not be described here in detail.

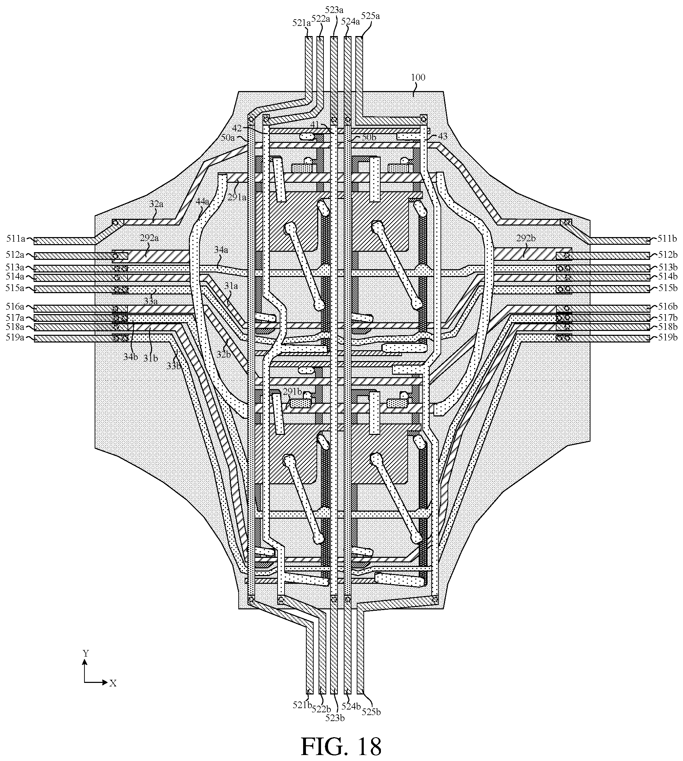

FIG. 18 is a partial top view of a first sub-area according to at least one embodiment of the present disclosure. FIG. 18 illustrates a first light shielding block 100 of the first sub-area and a display island area covered by the first light shielding block 100. The plurality of first island area connection lines and the plurality of second island area connection lines may be made of a transparent conductive material and are located on a same conductive layer.

In some examples, as shown in FIG. 18, the conductive connection layer of the display substrate may include a plurality of first island area connection lines (including, for example, first connection lines 511a and 511b, second connection lines 512a and 512b, third connection lines 513a and 513b, fourth connection lines 514a and 514b, fifth connection lines 515a and 515b, sixth connection lines 516a and 516b, seventh connection lines 517a and 517b, eighth connection lines 518a and 518b, and ninth connection lines 519a and 519b) and a plurality of second island area connection lines (including, for example, eleventh connection lines 521a and 521b, twelfth connection lines 522a and 522b, thirteenth connection lines 523a and 523b, fourteenth connection lines 524a and 524b, and fifteenth connection lines 525a and 525b).

In some examples, the seventh insulating layer may be provided with a plurality of vias that expose a portion of surfaces of the first conductive layer, the second conductive layer, the third conductive layer, the fourth conductive layer, and the fifth conductive layer. The first connection lines 511a and 511b to the ninth connection lines 519a and 519b may extend substantially along the first direction X and be arranged sequentially along the second direction Y. The eleventh connection lines 521a and 521b to the fifteenth connection lines 525a and 525b may extend substantially along the second direction Y and be arranged sequentially along the first direction X.

In some examples, one end of the second scan line 32a located on the first conductive layer may be connected with the first connection line 511a and the other end may be connected with the first connection line 511b. The second light emitting control segment 292a located on the first conductive layer may be connected with the second connection line 512a, and the second light emitting control segment 292b may be connected with the second connection line 512b. One end of the second scan auxiliary line 36a located on the second conductive layer and one end of the fourth scan line 34a located on the third conductive layer may be connected with the third connection line 513a, and the other end of the second scan auxiliary line 36a and the other end of the fourth scan line 34a may be connected with the third connection line 513b. One end of the first scan line 31a located on the first conductive layer may be connected with the fourth connection line 514a, and the other end may be connected with the fourth connection line 514b. One end of the first scan auxiliary line 35a located on the second conductive layer and one end of the third scan line 33a located on the third conductive layer may be connected with the fifth connection line 515a, and the other end of the first scan auxiliary line 35a and the other end of the third scan line 33a may be connected with the fifth connection line 515b. One end of the second scan line 32b located on the first conductive layer may be connected with the sixth connection line 516a, and the other end may be connected with the sixth connection line 516b. One end of the second scan auxiliary line 36b located on the second conductive layer and one end of the fourth scan line 34b located on the third conductive layer may be connected with the seventh connection line 517a, and the other end of the second scan auxiliary line 36b and the other end of the fourth scan line 34b may be connected with the seventh connection line 517b. One end of the first scan line 31b located on the first conductive layer may be connected with the eighth connection line 518a, and the other end may be connected with the eighth connection line 518b. One end of the first scan auxiliary line 35b located on the second conductive layer and one end of the third scan line 33b located on the third conductive layer may be connected with the ninth connection line 519a, and the other end of the first scan auxiliary line 35b and the other end of the third scan line 33b may be connected with the ninth connection line 519b. In the present example, signal transmission in the first direction X of the first pixel circuits in display island areas adjacent in the first direction X may be achieved by using the nine first island area connection lines.

In some examples, one end of the data line 50a located on the fifth conductive layer may be connected with the eleventh connection line 521a, and the other end may be connected with the eleventh connection line 521b. One end of the first initial signal line 42 located on the fourth conductive layer may be connected with the twelfth connection line 522a, and the other end may be connected with the twelfth connection line 522b. One end of the first power supply line 41 located on the fourth conductive layer may be connected with the thirteenth connection line 523a, and the other end may be connected with the thirteenth connection line 523b. One end of the data line 50b located on the fifth conductive layer may be connected with the fourteenth connection line 524a, and the other end may be connected with the fourteenth connection line 524b. One end of the second initial signal line 43 located on the fourth conductive layer may be connected with the fifteenth connection line 525a, and the other end may be connected with the fifteenth connection line 525b. In the present example, signal transmission in the second direction Y of the first pixel circuits in display island areas adjacent in the second direction Y may be achieved by using the five second island area connection lines.

In some examples, an edge shape of the first light shielding block 100 may be substantially the same as an edge shape of outer metal wires within the display island area. For example, the edge shape of the first light shielding block 100 may surround edges of the second scan line 32a and the third scan line 33b. The first light shielding block 100 may cover connection positions of the first island area connection lines and the metal wires of the display island area, and connection positions of the second island area connection lines and the metal wires of the display island area. The first island area connection lines and the second island area connection lines between adjacent display island areas are not overlapped with an orthographic projection of the first light shielding block 100 on the base substrate.

In the present example, by providing the light shielding layer, the first pixel circuit and the metal wires may be shielded, thereby preventing diffraction. Rest of film layer structures of the display island area in the present example may be referred to the description of the aforementioned embodiments, which will not be described here in detail.

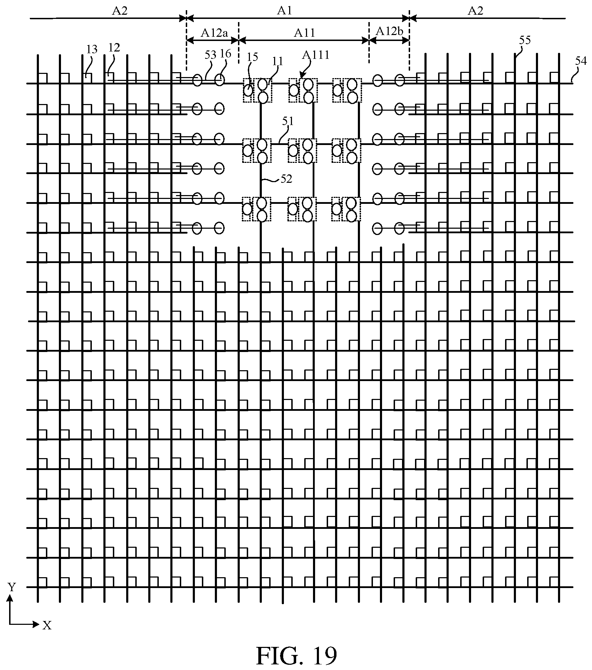

FIG. 19 is another partial schematic diagram of a display region according to at least one embodiment of the present disclosure. In some examples, as shown in FIG. 19, one display island area A111 of the first sub-area A11 in the first display area A1 may be provided with one first pixel unit, and the one first pixel unit may include three first sub-pixels, each of which may include a first pixel circuit 11 and a first light emitting element 15. In other words, the display island area A111 may include three first pixel circuits 11 and three first light emitting elements 15. The three first pixel circuits 11 and the three first light emitting elements 15 may be electrically connected in one-to-one correspondence. The three first pixel circuits may be sequentially arranged along the first direction X. Two first light emitting elements among the three first light emitting elements 15 may be arranged in a row along the second direction Y, and the other first light emitting element may be arranged on a side of the two first light emitting elements along the first direction X. For example, a first light emitting element emitting green light and a first light emitting element emitting red light may be arranged in a row along the second direction Y, and a first light emitting element emitting blue light may be arranged on a side of the first light emitting element emitting green light and the first light emitting element emitting red light in the opposite direction of the first direction X. The present embodiment is not limited thereto.

In some examples, the first island area connection line 51 and the second island area connection line 52 connected by the first pixel circuits of adjacent display island areas may be metal wires. The second light emitting element 16 of the second sub-area A12a may be connected with the second pixel circuit 12 of the second display area A2 through the conductive connection line 53. For example, the conductive connection line 53 may be made of a transparent conductive material. However, the present embodiment is not limited thereto.

In the present example, three first sub-pixels may be arranged in each display island area, which may improve the aperture ratio and the density of the light emitting elements in the first sub-area compared with arranging four first sub-pixels in the display island area.

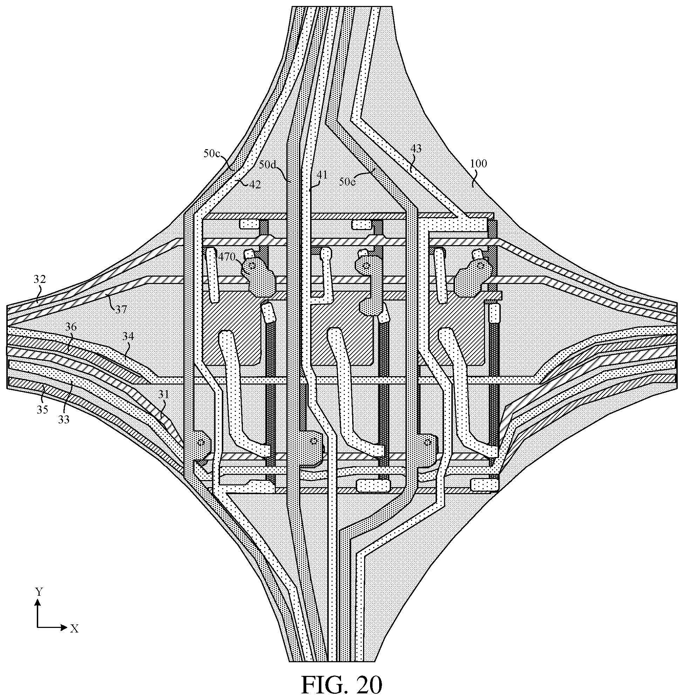

FIG. 20 is a schematic top view of a display island area according to at least one embodiment of the present disclosure. FIG. 20 illustrates a circuit structure layer in a display island area. In some examples, as shown in FIG. 20, the circuit structure layer of the display island area may be covered by an orthographic projection of the first light shielding block 100 located on the light shielding layer on the base substrate.

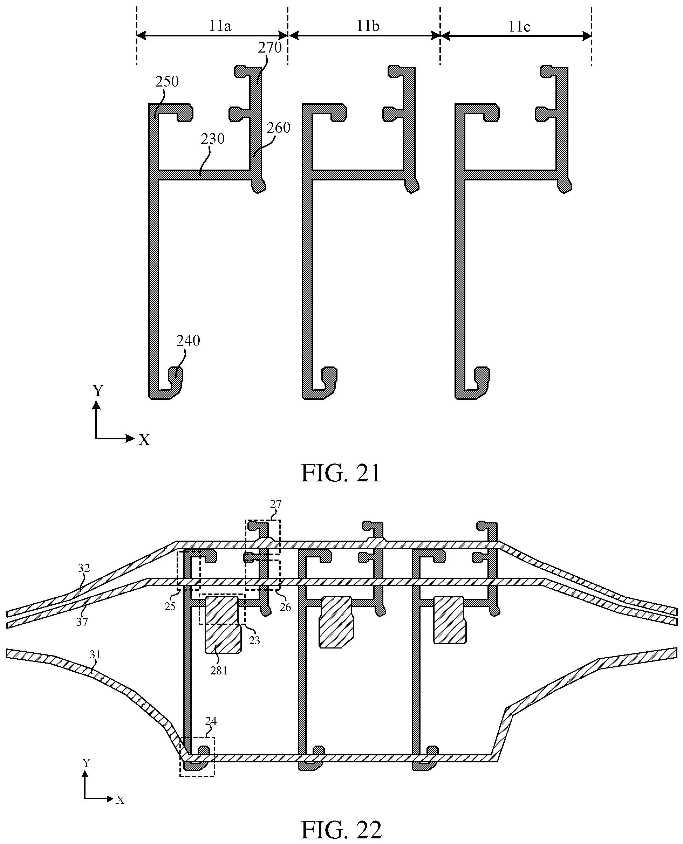

FIG. 21 is a schematic diagram of a first semiconductor layer in FIG. 20. In some examples, as shown in FIG. 21, the first semiconductor layer of the display island area may include active layers of a plurality of first type transistors of three first pixel circuits (including, for example, first pixel circuits 11a, 11b and 11c) (including, for example, an active layer 230 of a third transistor, an active layer 240 of a fourth transistor, an active layer 250 of a fifth transistor, an active layer 260 of a sixth transistor, and an active layer 270 of a seventh transistor of the first pixel circuit 11a). Patterns of the first semiconductor layers of the three first pixel circuits may be sequentially provided along the first direction X.

FIG. 22 is a schematic diagram of the first semiconductor layer and the first conductive layer in FIG. 20. In some examples, as shown in FIG. 22, the first conductive layer of the display island area may include first electrodes (e.g., a first electrode 281) of the storage capacitors of the three first pixel circuits, a first scan line 31, a second scan line 32, and a light emitting control line 37.

In some examples, the first scan line 31, the second scan line 32, and the light emitting control line 37 may have a bend line shape extending along the first direction X. The second scan line 32 and the light emitting control line 37 may be located on a side of the first electrodes of the storage capacitors of the three first pixel circuits along the second direction Y; the second scan line 32 may be located on a side of the light emitting control line 37 along the second direction Y; and the first scan line 31 may be located on a side of the first electrodes of the storage capacitors of the three first pixel circuits in the opposite direction of the second direction Y.

In some examples, an overlapping region of the first scan line 31 with the active layer 240 of the fourth transistor 24 of the first pixel circuit 11a may serve as a gate of the fourth transistor 24 of the first pixel circuit 11a, an overlapping region of the first scan line 31 with the active layer of the fourth transistor of the first pixel circuit 11b may serve as a gate of the fourth transistor of the first pixel circuit 11b, and an overlapping region of the first scan line 31 with the active layer of the fourth transistor of the first pixel circuit 11c may serve as a gate of the fourth transistor of the first pixel circuit 11c.

In some examples, an overlapping region of the light emitting control line 37 with the active layer of the fifth transistor 25 of the first pixel circuit 11a may serve as a gate of the fifth transistor 25 of the first pixel circuit 11a, and an overlapping region of the light emitting control line 37 with the active layer of the sixth transistor 26 of the first pixel circuit 11a may serve as a gate of the sixth transistor 26 of the first pixel circuit 11a. An overlapping region of the light emitting control line 37 with the active layer of the fifth transistor of the first pixel circuit 11b may serve as a gate of the fifth transistor of the first pixel circuit 11b, and an overlapping region of the light emitting control line 37 with the active layer of the sixth transistor of the first pixel circuit 11b may serve as a gate of the sixth transistor of the first pixel circuit 11b. An overlapping region of the light emitting control line 37 with the active layer of the fifth transistor of the first pixel circuit 11c may serve as a gate of the fifth transistor of the first pixel circuit 11c, and an overlapping region of the light emitting control line 37 with the active layer of the sixth transistor of the first pixel circuit 11c may serve as a gate of the sixth transistor of the first pixel circuit 11c.

In some examples, an overlapping region of the second scan line 32 with the active layer of the seventh transistor 27 of the first pixel circuit 11a may serve as a gate of the seventh transistor 27 of the first pixel circuit 11a, an overlapping region of the second scan line 32 with the active layer of the seventh transistor of the first pixel circuit 11b may serve as a gate of the seventh transistor of the first pixel circuit 11b, and an overlapping region of the second scan line 32 with the active layer of the seventh transistor of the first pixel circuit 11c may serve as a gate of the seventh transistor of the first pixel circuit 11c.

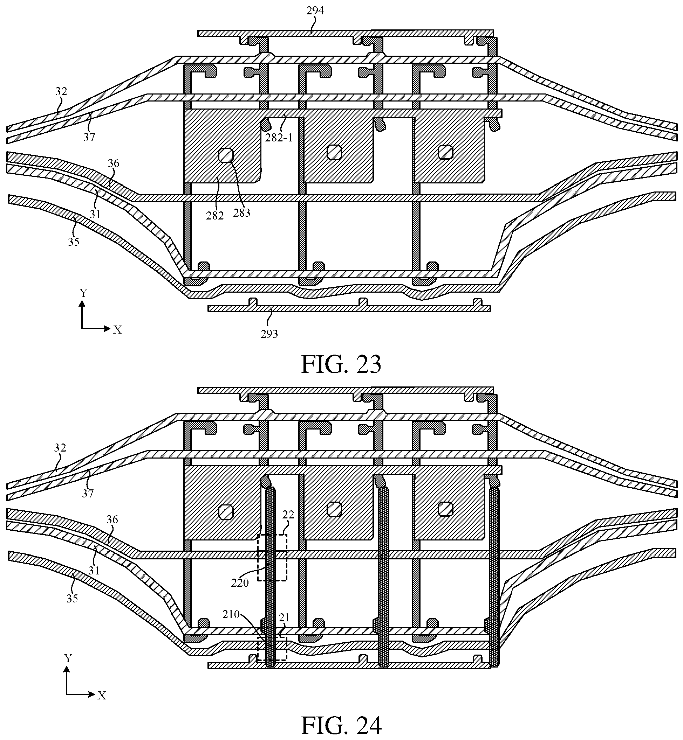

FIG. 23 is a schematic diagram of the first semiconductor layer, the first conductive layer, and the second conductive layer in FIG. 20. In some examples, as shown in FIG. 23, the second conductive layer of the display island area may at least include a first scan guide line 35, a second scan guide line 36, second electrodes of the storage capacitors of the three first pixel circuits (e.g., a second electrode 282), a first initial connection segment 293, and a second initial connection segment 294. In some examples, the second electrodes 282 of the storage capacitors of adjacent two first pixel circuits among the three first pixel circuits may be connected through an electrode plate connection block 282-1. The second electrodes 282 of the storage capacitors of the three first pixel circuits and the electrode plate connection blocks 282-1 may be of an interconnected integral structure.

FIG. 24 is a schematic diagram of the first semiconductor layer, the first conductive layer, the second conductive layer, and the second semiconductor layer in FIG. 20. In some examples, as shown in FIG. 24, the second semiconductor layer of the display island area may at least include active layers of a plurality of second type transistors of the three first pixel circuits (including, for example, an active layer 210 of the first transistor 21 and an active layer 220 of the second transistor 22 of the first pixel circuit 11a).

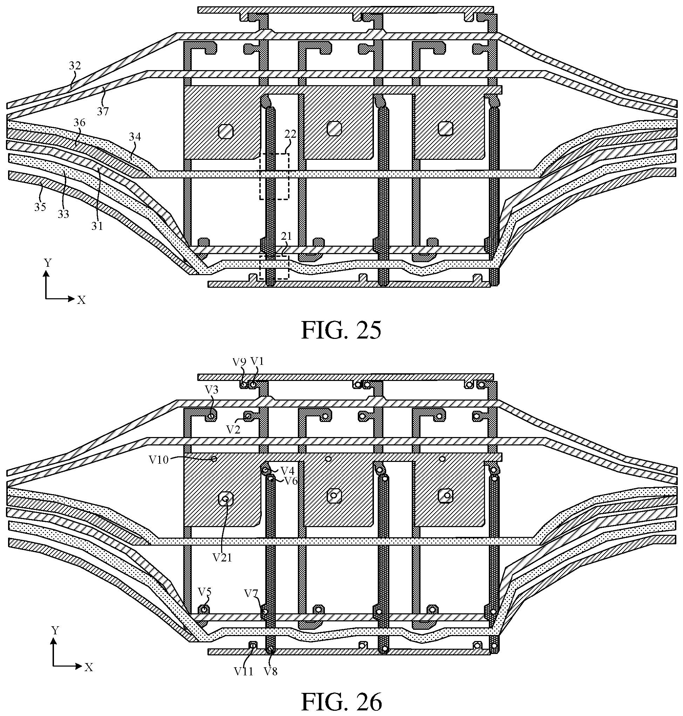

FIG. 25 is a schematic diagram of the first semiconductor layer, the first conductive layer, the second conductive layer, the second semiconductor layer, and the third conductive layer in FIG. 20. In some examples, as shown in FIG. 25, the third conductive layer of the display island area may at least include a third scan line 33 and a fourth scan line 34. In some examples, an orthographic projection of the third scan line 33 on the base substrate may be partially overlapped with an orthographic projection of the first scan auxiliary line 35 on the base substrate. An orthographic projection of the fourth scan line 34 on the base substrate may be partially overlapped with an orthographic projection of the second scan auxiliary line 36 on the base substrate.

FIG. 26 is a schematic diagram of via holes provided in a first semiconductor layer, a first conductive layer, a second conductive layer, a second semiconductor layer, a third conductive layer, and a fifth insulating layer in FIG. 20. In some examples, as shown in FIG. 26, the fifth insulating layer of the display island area may be provided with a plurality of vias, which may include, for example, a first via V1 to a fifth via V5, a sixth via V6 to an eighth via V8, a ninth via V9 to an eleventh via V11, and a twenty-first via V21.

In some examples, the fifth insulating layer, the fourth insulating layer, the third insulating layer, the second insulating layer, and the first insulating layer within the first via V1 to the fifth via V5 may be removed, exposing a portion of a surface of the first semiconductor layer. The fifth insulating layer and the fourth insulating layer within the sixth via V6 to the eighth via V8 may be removed, exposing a portion of a surface of the second semiconductor layer. The fifth insulating layer, the fourth insulating layers and the third insulating layers within the ninth via V9 to the eleventh via V11 may be removed, exposing a portion of a surface of the second conductive layer. The fifth insulating layer, the fourth insulating layer, the third insulating layer and the second insulating layer within the twenty-first via V21 may be removed, exposing a portion of a surface of the first conductive layer.

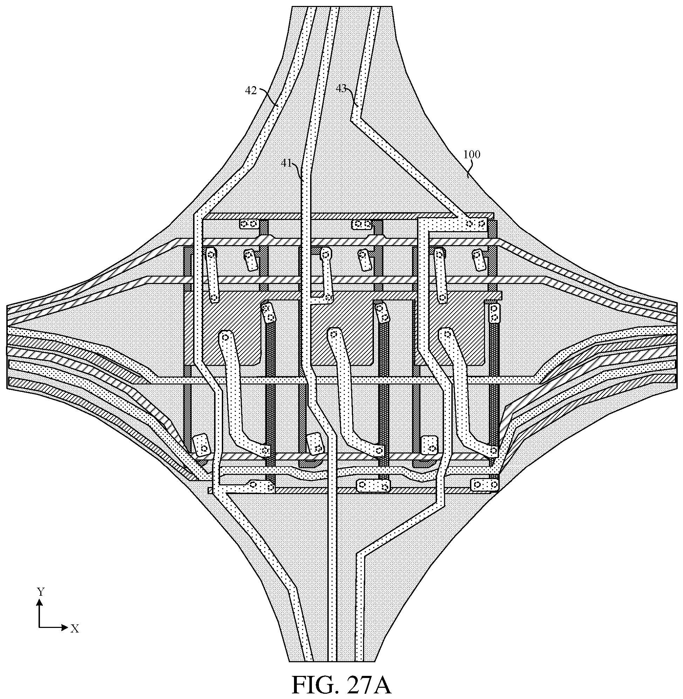

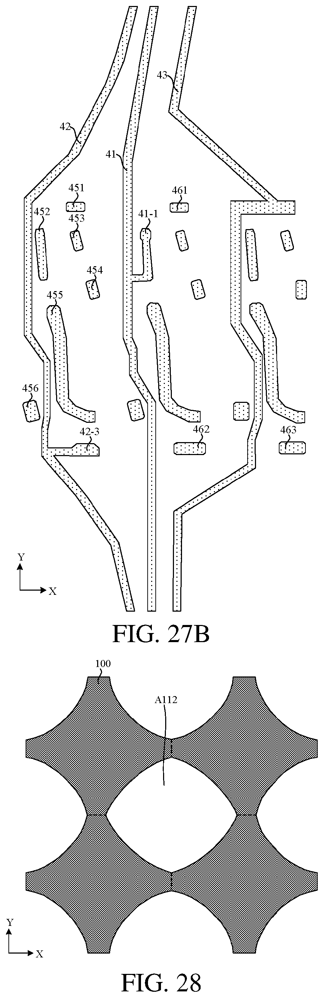

FIG. 27A is a schematic diagram of a display island area after a fourth conductive layer is formed in FIG. 20. FIG. 27B is a schematic diagram of the fourth conductive layer in FIG. 27A. In some examples, as shown in FIGS. 27A and 27B, the fourth conductive layer of the display island area may include a first power supply line 41, a first initial signal line 42, a second initial signal line 43, and a plurality of connection electrodes (including, for example, a first connection electrode 451 to a sixth connection electrode 456, and an eleventh connection electrode 461 to a thirteenth connection electrode 463). The first power supply line 41, the first initial signal line 42, and the second initial signal line 43 may have a bend line shape extending substantially along the second direction Y. The first power supply line 41 may be located between the first initial signal line 42 and the second initial signal line 43.

In some examples, a power supply connection block 41-1 is provided on a side of the first power supply line 41 close to the second initial signal line 43. The power supply connection block 41-1 may have a substantially L shape. The first power supply line 41 and the power supply connection block 41-1 may be of an interconnected integral structure. The power supply connection line 41-1 may be connected with the first region of the active layer of the fifth transistor and the second electrode of the storage capacitor of the first pixel circuit 11b, thereby achieving electrical connection with the first power supply line 41. The first power supply line 41 may achieve transmission of a first voltage signal along the second direction Y, and an integral structure of the second electrodes of the storage capacitors of the three first pixel circuits may achieve transmission of the first voltage signal along the first direction X, thereby forming a mesh structure for transmitting the first voltage signal within the display island area, which is conducive to the uniformity of the transmission of the first voltage signal.

In some examples, a fifth initial bump 42-3 may be provided on a side of the first initial signal line 42 close to the first power supply line 41. The fifth initial bumps 42-3 may have a strip shape extending substantially along the first direction X. The fifth initial bump 42-3 and the first initial signal line 42 may be of an interconnected integral structure. The fifth initial bump 42-3 may be connected with the first initial connection block through the eleventh via V11 to achieve electrical connection with the first initial connection segment 293, and the fifth initial bump 42-3 may be connected with the first region of the active layer of the first transistor of the first pixel circuit 11a through the eighth via V8. The twelfth connection electrode 462 may be electrically connected with the first region of the active layer of the first transistor of the first pixel circuit 11b and the first initial connection segment 293. The thirteenth connection electrode 463 may be electrically connected the first region of the active layer of the first transistor of the first pixel circuit 11c and the first initial connection segment 293. In the present example, the three first pixel circuits of the display island area may be connected with a same first initial signal line 42, which may reduce wire arrangement. The first initial signal line 42 may achieve transmission of a first initial signal line along the second direction Y, and the first initial connection segment 293 may achieve transmission of the first initial signal along the first direction X, thereby forming a mesh structure for transmitting the first initial signal within the display island area, which is conducive to the uniformity of the transmission of the first initial signal.

In some examples, the second initial signal line 43 may be connected with the first region of the active layer of the seventh transistor of the first pixel circuit 11c and the second initial connection segment 294. The first connection electrode 451 may be connected with a second initial connection block through the ninth via V9 to achieve electrical connection with the second initial connection segment 294, and the first connection electrode 451 may be connected with the first region of the active layer of the seventh transistor of the first pixel circuit 11a through the first via V1. The eleventh connection electrode 461 may be electrically connected with the first region of the active layer of the seventh transistor of the first pixel circuit 11b and the second initial connection segment 294. In the present example, the three first pixel circuits of the display island area may be connected with a same second initial signal line 43, which may reduce wire arrangement. The second initial signal line 43 may achieve transmission of a second initial signal line along the second direction Y, and the second initial connection segment 294 may achieve transmission of the second initial signal along the first direction X, thereby forming a mesh structure for transmitting the second initial signal within the display island area, which is conducive to the uniformity of the transmission of the second initial signal.

The description of the second connection electrode 452 to the sixth connection electrode 456 may be referred to the description of the aforementioned embodiments, which will not be described here in detail.

FIG. 20 is a schematic diagram of a display island area after a fifth conductive layer is formed according to at least one embodiment of the present disclosure. In some examples, as shown in FIG. 20, the fifth conductive layer of the display island area may at least include three data lines 50c, 50d, and 50e, and three anode connection electrodes (e.g., an anode connection electrode 470).

In some examples, the anode connection electrode 470 may be connected with the third connection electrode through a via opened on the sixth insulating layer, thereby achieving connection with the sixth transistor of the first pixel circuit 11a.

In some examples, the three data lines 50c, 50d, and 50e may have a bend line shape extending substantially along the second direction Y. The three data lines 50c, 50d, and 50e may be arranged along the first direction X. An orthographic projection of the data line 50c on the base substrate may be located on a side of the first initial signal line 42 in the opposite direction of the first direction X, an orthographic projection of the data line 50d on the base substrate may be located on a side of the first power supply line 41 in the opposite direction of the first direction X, and an orthographic projection of the data line 50e on the base substrate may be located on a side of the second initial signal line 43 in the opposite direction of the first direction X.

In some examples, the data line 50c may be connected with the fourth transistor of the first pixel circuit 11a through a via opened on the sixth insulating layer, the data line 50d may be connected with the fourth transistor of the first pixel circuit 11b, and the data line 11e may be connected with the fourth transistor of the first pixel circuit 11c.

In the present example, the first signal lines (including, for example, a first scan line 31, a second scan line 32, a third scan line 33, a fourth scan line 34, a first scan auxiliary line 35, a second scan auxiliary line 36, and a light emitting control line 37) and the second signal lines (including, for example, data lines 50c, 50d, and 50e, a first power supply line 51, a first initial signal line 42, and a second initial signal line 43) in the display island area are in a cross design, which may be conducive to increasing the area of the first light transmitting area.

FIG. 28 is still another partial schematic diagram of a light shielding layer of a first sub-area according to at least one embodiment of the present disclosure. In some examples, as shown in FIG. 28, the light shielding layer may include a plurality of first light shielding blocks 100 located in the first sub-area. The plurality of first light shielding blocks 100 may be of an interconnected integral structure. The light shielding layer in the first sub-area may form a continuous pattern.

In some examples, the first island area connection line and the second island area connection line with which the first pixel circuit of the display island area is connected may be made of a metal material. An orthographic projection of a single first light shielding block 100 of the first sub-area on the base substrate may cover the four first pixel circuits within a display island area and metal wires with which the four first pixel circuits are connected. An edge of the first light shielding block 100 close to the first light transmitting area A112 may be an arc-shaped edge such that the first light transmitting area A112 has an arc-shaped edge. An edge profile of the first light shielding block 100 close to the first light transmitting area A112 may be substantially the same as an edge shape of metal wires with which the first pixel circuits are connected.

In the present example, the display island area is provided with three first pixel circuits, and the first pixel circuits of adjacent display island areas are connected through seven metal wires extending along the first direction X. Compared with the case where the display island area is provided with four first pixel circuits, the present example may reduce a size (for example, a length along the second direction Y) of a position of the first light shielding block 100 shielding the first island area connection line may be reduced in the present example by reducing lateral connection wires, thereby facilitating the increase of the area of the first light transmitting area.

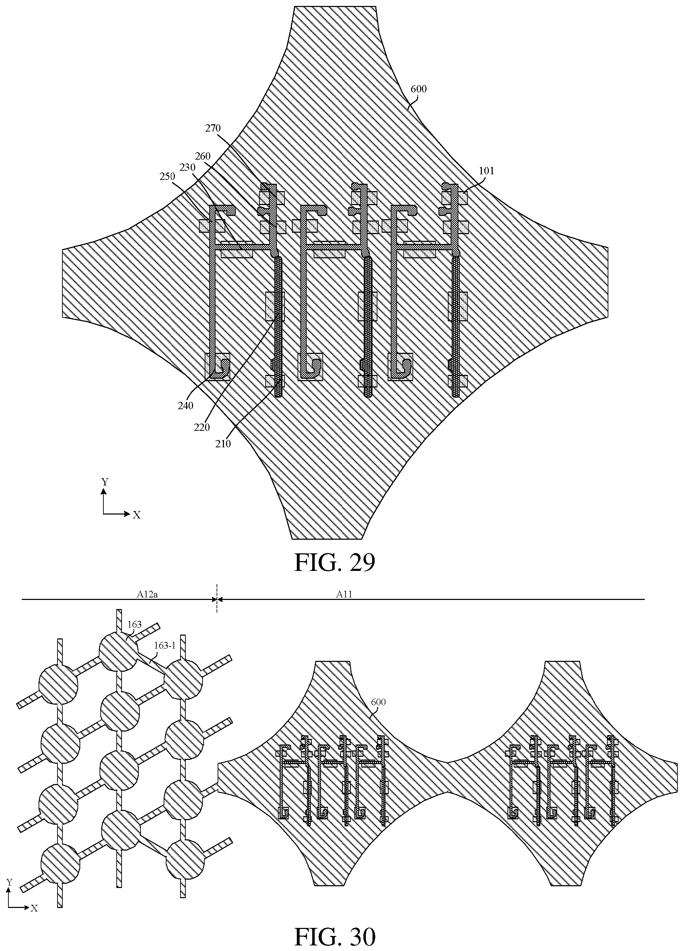

FIG. 29 is a partial schematic diagram of a display island area according to at least one embodiment of the present disclosure. In some examples, as shown in FIG. 29, the light shielding layer of the display substrate may include a plurality of light shielding strips 101 located in the display island area. The light shielding strips 101 may have a substantially rectangular shape. An orthographic projection of each light shielding strip 101 on the base substrate may cover an orthographic projection of a channel region of an active layer of at least one transistor of a first pixel circuit in the display island area on the base substrate. For example, the orthographic projection of each light shielding strip 101 on the base substrate may cover the orthographic projection of a channel region of an active layer of one transistor of the first pixel circuit on the base substrate. In some examples, the plurality of light shielding strips 101 may be independently provided. However, the present embodiment is not limited thereto. In some other examples, the plurality of light shielding strips may be connected with each other as a mesh structure.

In some examples, as shown in FIG. 29, cathodes of the plurality of first light emitting elements (e.g., three first light emitting elements) in the display island area may be of an interconnected integral structure. For example, the plurality of first light emitting elements in the display island area are connected with each other to form an island area cathode structure 600. The island area cathode structure 600 may cover the three first pixel circuits of the display island area, the metal wires with which the three first pixel circuits are connected, and orthographic projections of the plurality of light shielding strips 101 of the display island area on the base substrate. An edge of the island area cathode structure 600 close to the first light transmitting area may be an arc-shaped edge. An edge profile of the island area cathode structure 600 may be substantially the same as an edge shape of metal wires with which the first pixel circuits are connected. In some examples, the island area cathode structure 600 may be made of a metallic material. By providing a patterned cathode layer to shield the first pixel circuits and the metal wires of the display island area, it is possible to facilitate the increase of the area of the first light transmitting area and prevent diffraction.

In some examples, a light shielding pixel defining layer (the first pixel defining layer as described above) may be provided on a side of the island area cathode structure 600 close to the base substrate. An orthographic projection of the light shading pixel defining layer on the base substrate may cover the first island area connection lines and the second island connection lines that are made of a metal material. An orthographic projection of the island area cathode structure 600 on the base substrate may cover the orthographic projection of the light shading pixel defining layer on the base substrate. By providing the light shading pixel defining layer and the patterned cathode layer to shield the metal wires between adjacent display island areas, it is possible to facilitate the increase of the area of the first light transmitting area and prevent diffraction. Rest of description of the display substrate of the present example may be referred to description of the aforementioned embodiments, which will not be described here in detail.

FIG. 30 is a schematic diagram of a cathode layer of a first display area according to at least one embodiment of the present disclosure. In some examples, as shown in FIG. 30, cathodes 163 of the plurality of second light emitting elements may be connected with each other within the second sub-area A12a. For example, cathodes 163 of adjacent second light emitting elements may be connected through a cathode connection strip 163-1. The cathode 163 of the second light emitting element and the cathode connection strip 163-1 may be of an interconnected integral structure.

In some examples, the cathodes 163 of the second light emitting elements in the second sub-area A12a and the island area cathode structures 600 in the first sub-area A11 may be of an interconnected integral structure. The cathodes of the first light emitting elements and the cathodes of the second light emitting elements in the first display area may be connected to form a mesh shape, and the cathode layer with the mesh shape may have a plurality of cathode meshes. An area of a cathode mesh in the second sub-area A12a may be smaller than an area of a cathode mesh in the first sub-area A11. For example, the area of the cathode mesh in the first sub-area A11 may be substantially an area of the first light transmitting area, and the area of the cathode mesh in the second sub-area A12 may be substantially an area of the second light transmitting area.

By providing the patterned cathode layer, the present example may facilitate the increase of the area of the light transmitting area of the first display area and prevent diffraction. Rest of description of the display substrate of the example may be referred to description of the aforementioned embodiments, which will not be described here in detail.

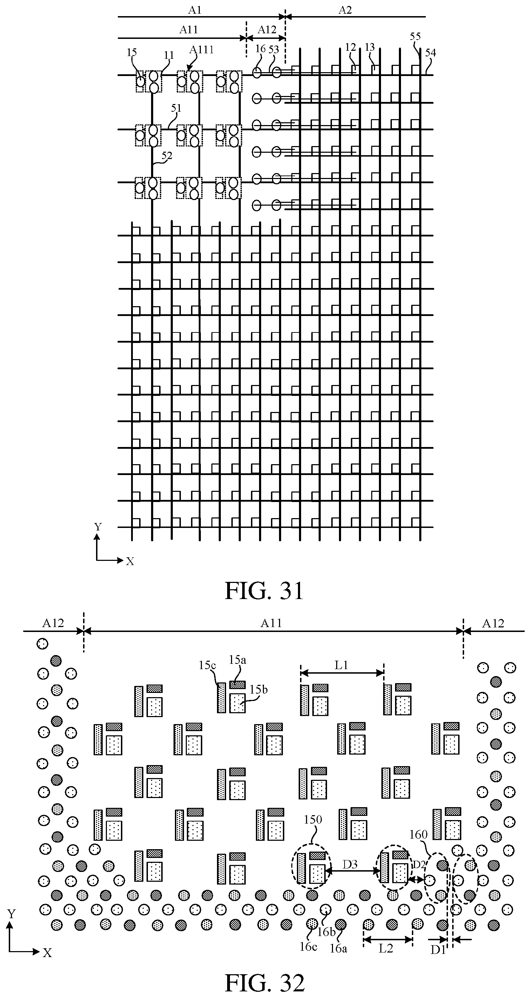

FIG. 31 is another partial schematic diagram of a display region according to at least one embodiment of the present disclosure. In some examples, the display region may include a first display area A1 and a second display area A2. The first display area A1 may, for example, be located at an edge corner position (e.g., an upper left corner position) of the display region. The first display area A1 may include a first sub-area A11 and a second sub-area A12. The second sub-area A12 is located between the first sub-area A11 and the second display area A2 in the first direction X. For example, an area of the first sub-area A11 may account for two-thirds of a total area of the first display area A1, and an area of the second sub-area A12 may account for one-third of the total area of the first display area A1. However, the present embodiment is not limited thereto.

In some examples, the second light emitting element 16 in the second sub-area A12 may be connected with the second pixel circuit 12 in an adjacent second display area A2 through the conductive connection line 53. The first pixel circuit 11 in the first sub-area A11 is connected with the first light emitting element 15 and arranged centrally in an island shape.

In the present example, a second sub-area A12 is provided on one side of the first sub-area A11 of the first display area A1, the first sub-area A11 adopts a pixel circuit built-in mode, and the second sub-area A12 adopts a pixel circuit built-out mode. This provides a circuit driving design when the first display area A1 is located on the edge of the display area, which can ensure the light transmittance of the first display area A1, and supports increasing the size of the first display area A1. Rest of description of the display substrate of the example may be referred to description of the aforementioned embodiments, which will not be described here in detail.

FIG. 32 is a partial schematic diagram of a first display area according to at least one embodiment of the present disclosure. In some examples, as shown in FIG. 32, the first display area may include a first sub-area A11 and a second sub-area A12 adjacent to the first sub-area A11. The second sub-area A12 may be located on opposite sides of the first sub-area A11 in the first direction X and adjacent to one side of the first sub-area A11 in the second direction Y. The second display area may be located on a periphery of the second sub-area A12. The first sub-area A11 includes a plurality of display island areas and a first light transmitting area located between adjacent display island areas.

In some examples, as shown in FIG. 32, a display island area of the first sub-area A11 may include a plurality of first pixel circuits and a plurality of first light emitting elements (e.g., three first pixel circuits and three first light emitting elements 15a, 15b, and 15c) provided on a base substrate. The display island area may include first light emitting units 150, which may include a plurality of adjacent first light emitting elements. For example, one display island area may include one first light emitting unit 150, and a single first light emitting unit 150 may include first light emitting elements 15a, 15b, and 15c that are adjacent and emit light of different colors. The first light emitting element 15a may be configured to emit light of a first color, the first light emitting element 15b may be configured to emit light of a second color, and the first light emitting element 15c may be configured to emit light of a third color. For example, the light of the first color may be red light, the light of the second color may be green light, and the light of the third color may be blue light.

In some examples, as shown in FIG. 32, the second sub-area A12 may include a plurality of second light emitting units 160. Each second light emitting unit 160 may include a plurality of adjacent second light emitting elements. For example, the second light emitting unit 160 may include three second light emitting elements 16a, 16b, and 16c. The second light emitting element 16a may be configured to emit light of a first color, the second light emitting element 16b may be configured to emit light of a second color, and the second light emitting element 16c may be configured to emit light of a third color.

In some examples, a quantity of the first light emitting elements in the first light emitting unit 150 and a quantity of the second light emitting elements in the second light emitting unit 160 may be the same, for example, each may be three. The three first light emitting elements in the first light emitting unit 150 may be configured to emit light of different colors, and the three first light emitting elements in the second light emitting unit 160 may be configured to emit light of different colors. However, the present embodiment is not limited thereto. In some other examples, a quantity of the first light emitting elements in the first light emitting unit and a quantity of the second light emitting elements in the second light emitting unit may both be four. The first light emitting unit may include, for example, a first light emitting element emitting light of a first color, a first light emitting element emitting light of a third color, and two first light emitting elements emitting light of a second color. The second light emitting unit may include, for example, a second light emitting element emitting light of a first color, a second light emitting element emitting light of a third color, and two second light emitting elements emitting light of a second color. Examples in which the first light emitting unit includes four first light emitting elements and the second light emitting unit includes four second light emitting elements may be referred to the embodiment corresponding to FIG. 3, which will not be described here in detail.

In some examples, as shown in FIG. 32, for the first light emitting element and the second light emitting element emitting light of a same color in the first display area, along a first direction X, a distance between adjacent first light emitting elements emitting light of the same color in the first sub-area A11 may be greater than a distance between adjacent second light emitting elements emitting light of the same color in the second sub-area A12. For example, along the first direction X, the distance between adjacent first light emitting elements emitting light of the same color in the first sub-area A11 is 1.5 times to 2 times the distance between adjacent first light emitting elements emitting light of the same color in the second sub-area A12.

Taking the first light emitting element 15c and the second light emitting element 16c that emit light of the third color as an example, along the first direction X, the distance between the adjacent first light emitting elements 15c emitting light of the third color in the first sub-area A11 is L1, and the distance between the adjacent second light emitting elements 16c emitting light of the third color in the second sub-area A12 is L2, where L1 is greater than L2. For example, L1 may be 1.5 to 2 times of L2, for example, it may be about 1.5 times, or about 1.8 times, or about 2 times. However, the present example is not limited thereto.

In some other examples, along a second direction, a distance between adjacent first light emitting elements emitting light of a same color in the first sub-area may be greater than a distance between adjacent second light emitting elements emitting light of a same color in the second sub-area. For example, along the second direction, the distance between adjacent first light emitting elements emitting light of the same color in the first sub-area may be 1.5 times to 2 times the distance between adjacent second light emitting elements emitting light of the same color in the second sub-area.

In the present example, by providing that a spacing between the first light emitting elements emitting light of the same color in the first sub-area is larger than a spacing between the second light emitting elements emitting light of the same color in the second sub-area, it is conducive to increasing the area of the first light transmitting area in the first sub-area, thereby improving the light transmittance of the first display area.

In some examples, as shown in FIG. 32, in an adjacent region of the first sub-area A11 and the second sub-area A12, along the first direction X, a minimum distance (e.g., distance D2) between the first light emitting unit 150 and the second light emitting unit 160 may be smaller than a distance (e.g., distance D3) between adjacent first light emitting units 150 and greater than a distance (e.g., distance D1) between adjacent second light emitting units 160. In other words, D1 is less than D2 and D2 is less than D3. In the present example, the distance between light emitting units refers to the distance between adjacent light emitting elements within adjacent light emitting units. In the present example, the distance between adjacent light emitting units is adjusted according to an order of the first sub-area, the adjacent area of the first sub-area and the second sub-area, and the second sub-area, so that the distance between the adjacent light emitting units varies along a direction from the first sub-area to the second sub-area, which is conducive to improving the uniformity of display of the first display area.

Rest of a structure of the display substrate according to this example may be referred to the description of the aforementioned embodiments, which will not be described here in detail.

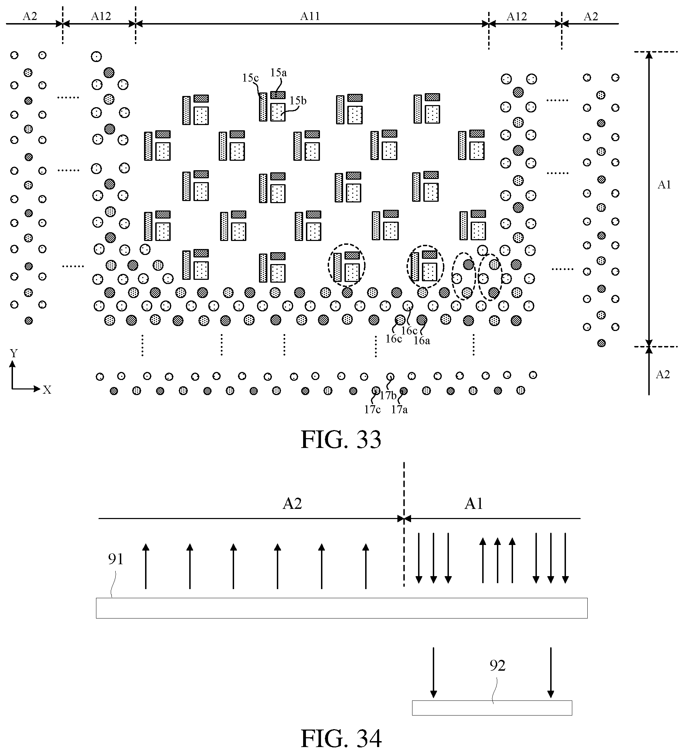

FIG. 33 is a partial schematic diagram of a display region according to at least one embodiment of the present disclosure. In some examples, as shown in FIG. 33, the second display area A2 may be located around the second sub-area A12 away from the first sub-area A11. The second display area A2 may at least include a plurality of third light emitting elements (e.g., third light emitting elements 17a, 17b, and 17c). For example, the third light emitting element 17a may be configured to emit light of a first color light, the third light emitting element 17b may be configured to emit light of a second color, and the third light emitting element 17c may be configured to emit light of a third color.

In some examples, as shown in FIG. 33, arrangement of the plurality of third light emitting elements in the second display area A2 may be the same as arrangement of the plurality of second light emitting elements in the second sub-area A12. A light emitting area of the third light emitting element emitting light of the same color as light color emitted by the second light emitting element may be smaller than a light emitting area of the second light emitting element. A light emitting area of the second light emitting element emitting light of the same color as light color emitted by the first light emitting element may be smaller than a light emitting area of the first light emitting element. In the present example, by providing changes in the light emitting areas of the first light emitting element, the second light emitting element, and the third light emitting element, it is conducive to improving the uniformity of display of the entire display area. However, the present embodiment is not limited thereto. In some other examples, light emitting areas of the third light emitting element and the second light emitting element emitting light of a same color may be substantially the same, and a distance between adjacent third light emitting elements emitting light of a same color may be greater than a distance between adjacent second light emitting elements emitting light of a same color. In the present example, by adjusting the distance between adjacent light emitting elements emitting light of the same color, the uniformity of display of the entire display area is improved.

Rest of a structure of the display substrate according to this example may be referred to the description of the aforementioned embodiments, which will not be described here in detail. FIG. 34 is a schematic diagram of a display apparatus according to at least one embodiment of the present disclosure. As shown in FIG. 34, an embodiment provides a display apparatus, which includes a display substrate 91 and a sensor 92 located away from a light exit side of a light emitting structure layer of the display substrate 91. The sensor 92 may be located on a side of a non-display surface of the display substrate 91. An orthographic projection of the sensor 92 on the display substrate 91 may be overlapped with a first display area A1.

In some examples, the display substrate 91 may be a flexible OLED display substrate, a OLED display substrate, a Micro-LED display substrate, or a Mini-LED display substrate. The display apparatus may be a product having an image (including a still image or a moving image, wherein the moving image may be a video) display function. For example, the display apparatus may be any one of: displays, televisions, billboards, digital photo frames, laser printers with display function, telephones, mobile phones, picture screens, personal digital assistants (PDA), digital cameras, portable camcorders, viewfinders, navigators, vehicles, large-area walls, information inquiry equipment (such as business inquiry equipment in e-government, banks, hospitals, power departments, etc.), monitors, etc. As another example, the display apparatus may be any one of a micro-display, a VR device including a micro-display, or an AR device.

The drawings of the present disclosure only involve structures involved in the present disclosure, and other structures may refer to conventional designs. The embodiments of the present disclosure, i.e., features in the embodiments, may be combined with each other to obtain new embodiments if there is no conflict. It should be noted that the above examples or embodiments are exemplary only and not restrictive. Therefore, the present disclosure is not limited to what is specifically shown and described herein. Various modifications, substitutions or omissions may be made in forms and details of implementation modes without departing from the scope of the present disclosure.

**Claims**

1. A display substrate, comprising a first display area and a second display area located on at least one side of the first display area, wherein:

   the first display area comprises a first sub-area and a second sub-area located on at least one side of the first sub-area close to the second display area; and the first sub-area comprises a plurality of display island areas and a first light transmitting area located between adjacent display island areas;
   a display island area comprises a plurality of first pixel circuits and a plurality of first light emitting elements provided on a base substrate; the plurality of first pixel circuits and the plurality of first light emitting elements are electrically connected; and an orthographic projection of a first light emitting element on the base substrate is at least partially overlapped with an orthographic projection of a first pixel circuit connected to the first light emitting element on the base substrate;
   the second sub-area comprises a plurality of second light emitting elements provided on the base substrate; and the second display area at least comprises a plurality of second pixel circuits provided on the base substrate; at least one second pixel circuit among the plurality of second pixel circuits is electrically connected with at least one second light emitting element among the plurality of second light emitting elements through a conductive connection line; and a distance between an orthographic projection of the second light emitting element on the base substrate and an orthographic projection of the second pixel circuit connected with the second light emitting element on the base substrate is greater than 0.

2. The display substrate according to claim 1, wherein the plurality of first pixel circuits of the display island area are connected with a plurality of first signal lines extending along a first direction and a plurality of second signal lines extending along a second direction; and
in the first sub-area, the plurality of first signal lines of adjacent display island areas in the first direction are connected through a plurality of first island area connection lines, and the plurality of second signal lines of adjacent display island areas in the second direction are connected through a plurality of second island area connection lines; and the first direction is intersected with the second direction.

3. The display substrate according to claim 2, wherein the conductive connection line comprises at least one wire layer; and the plurality of first island area connection lines, the plurality of second island area connection lines and the at least one wire layer of the conductive connection line are in a same layer, and are made of a transparent conductive material.

4. The display substrate according to claim 2, wherein the plurality of first island area connection lines, the plurality of second island area connection lines, and the conductive connection line are all made of a metal material.

5. The display substrate according to claim 2, wherein the plurality of first island area connection lines and the plurality of second island area connection lines are made of a metal material, and the conductive connection line is made of a transparent conductive material.

6. The display substrate according to any one of claims 1 to 5, wherein the plurality of first pixel circuits in the display island area are connected with a same first power supply line.

7. The display substrate according to claim 6, wherein the plurality of first pixel circuits of the display island area are connected with a same first initial signal line and a same second initial signal line; and
in the display island area, the first initial signal line, the second initial signal line and the first power supply line extend along a same direction, and the first power supply line is located between the first initial signal line and the second initial signal line.

8. The display substrate according to claim 6 or 7, wherein the plurality of first pixel circuits of the display island area are connected with a same light emitting control line, and an extending direction of the light emitting control line is intersected with an extending direction of the first power supply line.

9. The display substrate according to any one of claims 6 to 8, wherein the display island area comprises four first pixel circuits which are arranged in a 2×2 array, and active layers of the four first pixel circuits are symmetrically provided about a first center line of the four first pixel circuits in the first direction.

10. The display substrate according to any one of claims 6 to 8, wherein the display island area comprises three first pixel circuits arranged sequentially along the first direction.

11. The display substrate according to any one of claims 1 to 10, further comprising a light shielding layer located on a side of the first pixel circuits and the second pixel circuits close to the base substrate, wherein the light shielding layer is not overlapped with an orthographic projection of the first light transmitting area on the base substrate; and
the light shielding layer at least comprises a first light shielding block located in the display island area; and an orthographic projection of the first light shielding block on the base substrate covers an orthographic projection of the plurality of first pixel circuits of the display island area and signal lines connected with the plurality of first pixel circuits on the base substrate.

12. The display substrate according to claim 11, wherein first light shielding blocks of adjacent display island areas are of an interconnected integral structure.

13. The display substrate according to claim 11, wherein first light shielding blocks of adjacent display island areas are independently provided.

14. The display substrate according to any one of claims 11 to 13, wherein an edge of the first light shielding block close to the first light transmitting area is an arc-shaped edge.

15. The display substrate according to any one of claims 1 to 10, further comprising a light emitting structure layer located on a side of the plurality of first pixel circuits and the plurality of second pixel circuits away from the base substrate, wherein:

the light emitting structure layer comprises a cathode layer; and an orthographic projection of the cathode layer on the base substrate is not overlapped with an orthographic projection of the first light transmitting area on the base substrate;

the cathode layer at least comprises cathodes of the plurality of first light emitting elements; and

the cathodes of the plurality of first light emitting elements of the display island area are of an interconnected integral structure, and an orthographic projection of the integral structure of the cathodes of the plurality of first light emitting elements of the display island area on the base substrate covers an orthographic projection of the plurality of first pixel circuits of the display island area and signal lines connected with the plurality of first pixel circuits on the base substrate.

16. The display substrate according to claim 15, wherein the cathode layer further comprises cathodes of the plurality of second light emitting elements; and the cathodes of the plurality of first light emitting elements of the first sub-area and the cathodes of the plurality of second light emitting elements of the second sub-area are connected to form a mesh shape.

17. The display substrate according to claim 15 or 16, further comprising a light shielding pixel defining layer located on a side of the cathode layer close to the base substrate, wherein the light shielding pixel defining layer is at least located in the first sub-area, and an orthographic projection of the cathode layer on the base substrate covers an orthographic projection of the light shielding pixel defining layer on the base substrate.

18. The display substrate according to any one of claims 15 to 17, further comprising a light shielding layer located on a side of the first pixel circuits and the second pixel circuits close to the base substrate; wherein:

the light shielding layer is not overlapped with an orthographic projection of the first light transmitting area on the base substrate;

the light shielding layer at least comprises a plurality of light shielding strips located in the display island area; and an orthographic projection of each light shielding strip on the base substrate covers an orthographic projection of a channel region of an active layer of at least one transistor of the first pixel circuit on the base substrate; and

the orthographic projection of the integral structure of the cathodes of the plurality of first light emitting elements of the display island area on the base substrate covers an orthographic projection of the plurality of light shielding strips of the display island area on the base substrate.

19. The display substrate according to any one of claims 1 to 18, wherein a light transmittance of the first display area is greater than a light transmittance of the second display area, and a density of light emitting elements in the second display area is the same as a density of light emitting elements in the first display area.

20. The display substrate according to any one of claims 1 to 19, wherein the first display area has a strip shape extending along a first direction, and the second sub-area is located between the first sub-area and the second display area in the first direction.

21. The display substrate according to any one of claims 1 to 20, wherein:

the display island area comprises at least one first light emitting unit, and the first light emitting unit comprises a plurality of adjacent first light emitting elements;

the second sub-area comprises a plurality of second light emitting units, and a second light emitting unit comprises a plurality of adjacent second light emitting elements; a quantity of the first light emitting elements in the first light emitting unit is the same as a quantity of the second light emitting elements in the second light emitting unit; and at least three first light emitting elements in the first light emitting unit are configured to emit light of different colors, and at least three second light emitting elements in the second light emitting unit are configured to emit light of different colors; and

in an adjacent region of the first sub-area and the second sub-area, along a first direction, a minimum distance between the first light emitting unit and the second light emitting unit is less than a distance between adjacent first light emitting units and greater than a distance between adjacent second light emitting units.

22. A display apparatus, comprising a display substrate according to any one of claims 1 to 21, and a sensor located on a non-display side of the display substrate, and an orthographic projection of the sensor on the display substrate is at least partially overlapped with a first display area of the display substrate.

23. A display substrate, comprising a first display area and a second display area located on at least one side of the first display area, wherein:

the first display area comprises a first sub-area and a second sub-area located on at least one side of the first sub-area close to the second display area;
the first sub-area comprises a plurality of first pixel circuits and a plurality of first light emitting elements provided on a base substrate, the plurality of first pixel circuits and the plurality of first light emitting elements are electrically connected; and an orthographic projection of a first light emitting element on the base substrate is at least partially overlapped with an orthographic projection of a first pixel circuit connected with the first light emitting element on the base substrate;
the second sub-area comprises a plurality of second light emitting elements provided on the base substrate;
the second display area at least comprises a plurality of second pixel circuits provided on the base substrate; at least one second pixel circuit among the plurality of second pixel circuits is electrically connected with at least one second light emitting element among the plurality of second light emitting elements through a conductive connection line; and a distance between an orthographic projection of the second light emitting element on the base substrate and an orthographic projection of the second pixel circuit connected with the second light emitting element on the base substrate is greater than 0; and
for the first light emitting elements and the second light emitting elements emitting light of a same color in the first display area, along a first direction, a distance between adjacent first light emitting elements emitting light of a same color in the first sub-area is greater than a distance between adjacent second light emitting elements emitting light of a same color in the second sub-area.

24. The display substrate according to claim 23, wherein along the first direction, the distance between adjacent first light emitting elements emitting light of the same color in the first sub-area is 1.5 times to 2 times the distance between adjacent first light emitting elements emitting light of the same color in the second sub-area.

25. The display substrate according to claim 23, wherein:

the first sub-area comprises a plurality of display island areas and a first light transmitting area located between adjacent display island areas;
a display island area at least comprises a first light emitting unit, and the first light emitting unit comprises a plurality of adjacent first light emitting elements;
the second sub-area at least comprises a plurality of second light emitting units, and a second light emitting unit comprises a plurality of adjacent second light emitting elements; a quantity of the first light emitting elements in the first light emitting unit is the same as a quantity of the second light emitting elements in the second light emitting unit; and at least three first light emitting elements in the first light emitting unit are configured to emit light of different colors, and at least three second light emitting elements in the second light emitting unit are configured to emit light of different colors; and
in an adjacent region of the first sub-area and the second sub-area, along the first direction, a minimum distance between the first light emitting unit and the second light emitting unit is less than a distance between adjacent first light emitting units and greater than a distance between adjacent second light emitting units.

FIG. 1A

FIG. 1B

FIG. 1C

FIG. 2

FIG. 3

FIG. 4

FIG. 5

41

FIG. 6A

FIG. 6B

FIG. 6C

FIG. 6D

FIG. 7

FIG. 8A

FIG. 8B

FIG. 9A

FIG. 9B

FIG. 10A

FIG. 10B

FIG. 11A

FIG. 11B

FIG. 12

FIG. 13A

FIG. 13B

FIG. 14

FIG. 15A

FIG. 15B

FIG. 16

FIG. 17

FIG. 18

FIG. 19

FIG. 20

FIG. 21

FIG. 22

FIG. 23

FIG. 24

FIG. 25

FIG. 26

FIG. 27A

FIG. 27B

FIG. 28

FIG. 29

FIG. 30

FIG. 31

FIG. 32

FIG. 33

FIG. 34

## INTERNATIONAL SEARCH REPORT

| International application No. |
| --- |
| **PCT/CN2023/121696** |

**A. CLASSIFICATION OF SUBJECT MATTER**

H10K59/121(2023.01)i; H10K59/122(2023.01)i; H10K59/123(2023.01)i

According to International Patent Classification (IPC) or to both national classification and IPC

**B. FIELDS SEARCHED**

Minimum documentation searched (classification system followed by classification symbols)

IPC:H10K

Documentation searched other than minimum documentation to the extent that such documents are included in the fields searched

Electronic data base consulted during the international search (name of data base and, where practicable, search terms used)

CNABS; CNTXT; CNKI; WPABS; DWPI; USTXT; WOTXT; EPTXT: 显示, 岛, 单元, 透光区, 交叠, 重叠, 投影, 间距, 第一, 第二, display, island, unit, overlap, region, light-transmitting, space

**C. DOCUMENTS CONSIDERED TO BE RELEVANT**

| Category* | Citation of document, with indication, where appropriate, of the relevant passages | Relevant to claim No. |
| --- | --- | --- |
| Y | CN 115835698 A (BOE TECHNOLOGY GROUP CO., LTD.) 21 March 2023 (2023-03-21) description, paragraphs [0002]-[0298], and figures 1-33 | 1-25 |
| Y | CN 116568091 A (BOE TECHNOLOGY GROUP CO., LTD. et al.) 08 August 2023 (2023-08-08) description, paragraphs [0002]-[0098], and figures 1-28 | 1-25 |
| Y | CN 115713918 A (BOE TECHNOLOGY GROUP CO., LTD.) 24 February 2023 (2023-02-24) description, paragraphs [0002]-[0166], and figures 15 and 16 | 1-25 |
| Y | CN 114582949 A (BOE TECHNOLOGY GROUP CO., LTD. et al.) 03 June 2022 (2022-06-03) description, paragraphs [0002]-[0125], and figures 1A-6 | 1-25 |

☐ Further documents are listed in the continuation of Box C.　　☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
| --- | --- |
| **01 April 2024** | **15 April 2024** |

| Name and mailing address of the ISA/CN | Authorized officer |
| --- | --- |
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2023/121696**

| Patent document cited in search report | | | Publication date (day/month/year) | Patent family member(s) | | | Publication date (day/month/year) |
|---|---|---|---|---|---|---|---|
| CN | 115835698 | A | 21 March 2023 | CN | 115835698 | B | 31 October 2023 |
| CN | 116568091 | A | 08 August 2023 | None | | | |
| CN | 115713918 | A | 24 February 2023 | WO | 2023020441 | A1 | 23 February 2023 |
| | | | | GB | 2620086 | A | 27 December 2023 |
| CN | 114582949 | A | 03 June 2022 | CN | 113745273 | A | 03 December 2021 |
| | | | | US | 2022344432 | A1 | 27 October 2022 |

Form PCT/ISA/210 (patent family annex) (July 2022)